# EUROPEAN PATENT SPECIFICATION

(11) **EP 1 703 330 B1**
(45) Date of publication and mention of the grant of the patent: **19.11.2008**
(21) Application number: 06004383.3
(22) Date of filing: 03.03.2006
(51) Int. Cl.: G03F 7/32, G03F 7/031

(54) **Plate-making method of negative-working lithographic printing plate precursor**
Verfahren zur Herstellung negativer, lithographischer Druckplattenvorläufer
Méthode pour la fabrication d'un précurseur négatif de plaque d'impression lithographique

(30) Priority: 03.03.2005 JP 2005059529
(43) Date of publication of application: 20.09.2006
(73) Proprietor: FUJIFILM Corporation, Minato-ku Tokyo (JP)
(72) Inventor: Inno, Toshifumi, Yoshida-cho, Haibara-gun, Shizuoka (JP)
(74) Representative: HOFFMANN EITLE

(56) References cited:
- EP-A- 1 434 102
- EP-A- 1 502 941
- EP-A- 1 505 441
- EP-A- 1 571 493
- EP-A- 1 640 802
- US-A1- 2003 129 523
- US-A1- 2003 194 654
- US-A1- 2004 096 777
- US-A1- 2005 158 663

## Description

### FIELD OF THE INVENTION

The present invention relates to a plate-making method of a lithographic printing plate precursor, and more particularly, it relates to a plate-making method of a negative-working lithographic printing plate precursor capable of undergoing a so-called direct plate-making, which can be directly plate-made by scanning of laser beam based on digital signals, for example, a computer.

### BACKGROUND OF THE INVENTION

In negative-working lithographic printing plate precursors, in general, image formation is carried out by a process of coating 117a photosensitive composition on a support, for example, an aluminum plate subjected to surface roughening treatment, exposing a desired image to polymerize or crosslink the exposed area in the photosensitive layer thereby insolubilizing it in a developer, and dissolving out the unexposed area of the photosensitive layer with the developer. As the photosensitive compositions used for such a purpose, photopolymerizable compositions have hitherto been well known, a part of which is already put into practical use. Also, in recent high-sensitive photopolymers which adopt a photoinitiation system technology that is highly sensitive to visible light, the sensitivity increases to a region employable for direct plate-making by a visible laser, and a so-called CTP plate becomes widespread.

In order to respond to increase in drawing speed for pursuit of higher productivity, further increase in the sensitivity is necessary. Not only that, requirement for handling ability not in a dark room but under a yellow lamp or a white lamp (treatment in a bright room) increases in view of workability. Further, for the purpose of increase in the sensitivity, design and development of photopolymerization initiators or photopolymerization initiation systems have been made, and hexaarylbiimidazole photopolymerization initiators draw attention as highly sensitive photopolymerization initiators. Many of the hexaarylbiimidazole photopolymerization initiators do not have absorption in the visible region and a photosensitive composition containing the hexaarylbiimidazole photopolymerization initiator makes it possible to conduct the treatment in a bright room in combination with an exposure system of an ultraviolet to violet laser having a wavelength of 300 to 450 nm.

However, with respect to a hitherto known negative-working image-forming material using a photopolymerizable composition (for example, refer to JP-A-8-108621 (the term "JP-A" as used herein means an "unexamined published Japanese patent application")), a strongly alkaline aqueous solution having pH exceeding 12.5 containing potassium silicate is used for development. The developer having such a high pH has a problem in that damage to the image area is large and printing durability becomes deficient.

Therefore, an alkali developer to which an alkyl phenol type surfactant is added is described (for example, refer to JP-A-10-239858) in order to solve developing property of a photoresist containing a pigment dispersed while maintaining the printing durability. However, both sufficient developing property and sufficient printing durability can not yet be simultaneously achieved.

EP-A-1 505 441 relates to a polymerisable composition comprising an alkali-soluble binder polymer of formula (1) suitable for the photosensitive layer of a negative lithographic printing plate precursor.

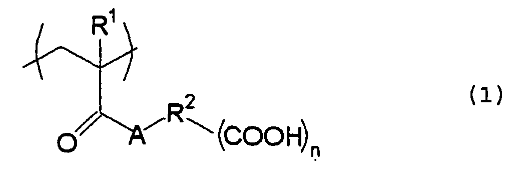

The binder polymer provides development of the plate in alkali developer, produces a minimum of development sediment and is more stable than conventional binder polymers. This document teaches, in addition, a hexaarylbiimidazole compound as a selectable radical generator in the photosensitive layer and a selectable polyoxyethylene glycol mononaphthyl ether sulphate as an optionally comprised anionic surfactant in a developer solution.

US-A-2003/0 194 654 relates to a method for treating a photosensitive lithographic printing plate, which comprises exposing the plate to laser light, developing with a developer containing an alkali metal silicate and then carrying out post-exposure treatment. The plate is prepared by forming a photopolymerisable photosensitive layer having a film thickness of 1.2-4 g/m² and further forming a protective layer having a film thickness of 2-8 g/m² on a support having a centreline average height of at least 0.35µm. The photosensitive layer may comprise a hexaarylbiimidazole as a preferred radical-generating agent. An anionic surfactant is optionally comprised in a developing solution having preferably a pH of 9-12. Such a plate has a satisfactory printing resistance and prints without staining.

EP-A-1 571 493, which constitutes prior art pursuant to Article 54(3) EPC, discloses a polymerisable composition for use in a lithographic printing plate precursor. The composition comprises a polyurethane resin, a photopolymerisation initiator and an addition-polymerisable compound. Suitable developing solutions are indicated to be an ethylene glycol mononaphthyl ether monosulfate sodium salt.

Further, the hexaarylbiimidazole photopolymerization initiator promising for an ultraviolet to violet laser as described above and a sensitizing dye are poor in solubility or dispersibility in the developer and thus, disadvantages of occurrence of scum in a developing bath and clogging of pipe may occur.

### SUMMARY OF THE INVENTION

As described above, hitherto known techniques are insufficient in view of simultaneous pursuit of high printing durability and a plate-making method using a developer having a good developing property and being free from the occurrence of development scum. An object of the present invention is to provide a plate-making method of a negative-working lithographic printing plate precursor capable of being subjected to image recording with laser exposure in which the good developing property is achieved, the high printing durability is obtained, and the occurrence of development scum is prevented.

As a result of various investigations, the inventor has found that the above-described object can be achieved by using a developer which is decreased in alkalinity and contains a specific surfactant. According to a first aspect, the present invention provides a method for making a lithographic printing plate comprising the steps of:
(a) exposing a lithographic printing plate precursor comprising a hydrophilic support, a photosensitive layer containing a sensitizing dye having absorption in a wavelength of 405 nm, a hexaarylbiimidazole compound, a polymerizable compound, a binder polymer and a chain transfer agent and a protective layer in this order with a laser beam having a wavelength of from 350 to 450 nm; and
(b) developing the exposed lithographic printing plate precursor with a developer having pH of 10.0 to 12.5 and containing an anionic surfactant in an amount of from 1.0 to 10.0% by weight represented by formula (II-A) and/or formula (II-B) : 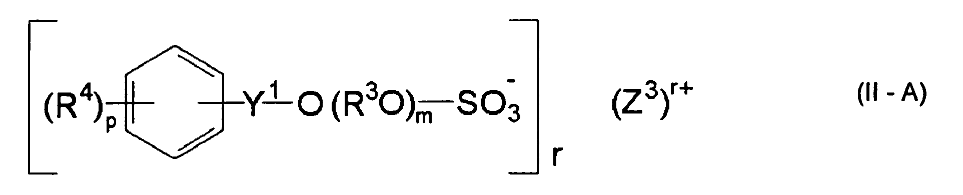 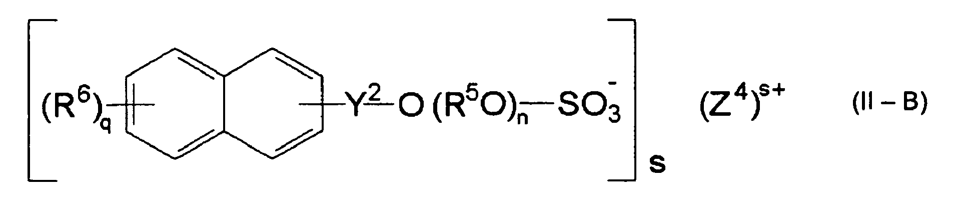
wherein R³ and R⁵ each represents a straight-chain or wherein R³ and R⁵ each represents a straight-chain or branched alkylene group having from 1 to 5 carbon atoms; m and n each represents an integer of from 1 to 100, when m is 2 or more, R³ may be selected from two or more groups, and when n is 2 or more, R⁵ may be selected from two or more groups; R⁴ and R⁶ each represents a straight-chain or branched alkyl group having from 1 to 20 carbon atoms; p and q each represents an integer of from 0 to 2; Y¹ and Y² each represents a simple bond or an alkylene group having from 1 to 10 carbon atoms; Z³ and Z⁴ each represents an alkali metal ion, an alkaline earth metal ion, an unsubstituted ammonium ion or an ammonium ion substituted with an alkyl group; and r and s each represents 1 or 2; with the proviso that if q is 0, n is 1, Y² is a simple bond and R⁵ is an ethylene group, then Z⁴ is not Na.

According to a second aspect, the present invention provides a method for making a lithographic printing plate comprising the steps of:
(a) exposing a lithographic printing plate precursor comprising a hydrophilic support, a photosensitive layer containing a sensitizing dye having absorption in a wavelength of 405 nm, a hexaarylbiimidazole compound, a polymerizable compound, a binder polymer and a thiol compound of formula (XI) as a chain transfer agent and a protective layer in this order with a laser beam having a wavelength of from 350 to 450 nm; and
(b) developing the exposed lithographic printing plate precursor with a developer having pH of 10.0 to 12.5 and containing an anionic surfactant in an amount of from 1.0 to 10.0% by weight represented by formula (II-A) and/or formula (II-B) : 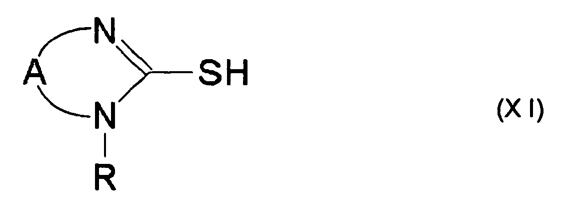
wherein R represents an alkyl group which may have a substituent or an aryl group which may have a substituent; and A represents a moiety which forms a 5-membered or 6-membered hetero ring containing a carbon atom together with the N=C-N linkage, and A may have a substituent 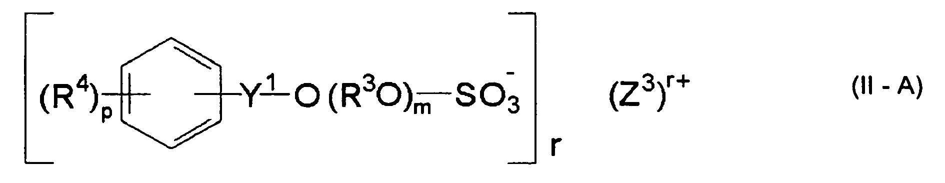 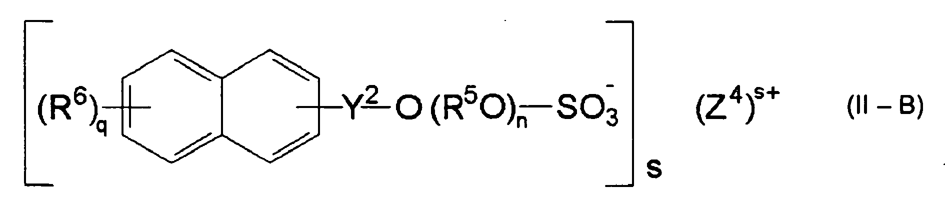 wherein R³ and R⁵ each represents a straight-chain or branched alkylene group having from 1 to 5 carbon atoms; m and n each represents an integer of from 1 to 100, when m is . 2 or more, R³ may be selected from two or more groups, and when n is 2 or more, R⁵ may be selected from two or more groups; R⁴ and R⁶ each represents a straight-chain or branched alkyl group having from 1 to 20 carbon atoms; p and q each represents an integer of from 0 to 2; Y¹ and Y² each represents a simple bond or an alkylene group having from 1 to 10 carbon atoms; Z³ and Z⁴ each represents an alkali metal ion, an alkaline earth metal ion, an unsubstituted ammonium ion or an ammonium ion substituted with an alkyl group; and r and s each represents 1 or 2.

It is preferred in the first and second aspects that the developer should contain a defoaming agent.

According to a third aspect, the present invention provides a method for making a lithographic printing plate comprising the steps of:
(a) exposing a lithographic printing plate precursor comprising a hydrophilic support, a photosensitive layer containing a sensitizing dye having absorption in a wavelength of 405 nm, a hexaarylbiimidazole compound, a polymerizable compound, a binder polymer and a chain transfer agent and a protective layer in this order with a laser beam having a wavelength of from 350 to 450 nm; and
(b) developing the exposed lithographic printing plate precursor with a developer having pH of 10.0 to 12.5 and containing a defoaming agent and an anionic surfactant in an amount of from 1.0 to 10.0% by weight represented by formula (II-A) and/or formula (II-B): 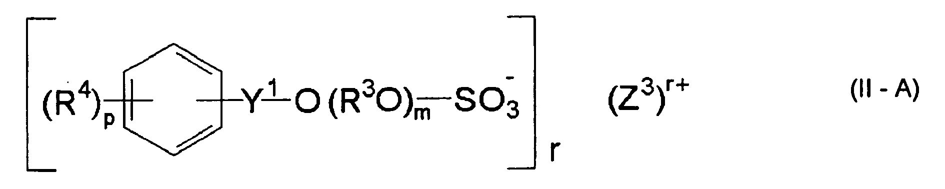 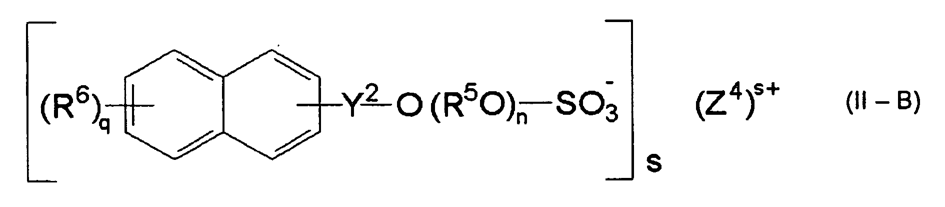
wherein R³ and R⁵ each represents a straight-chain or branched alkylene group having from 1 to 5 carbon atoms; m and n each represents an integer of from 1 to 100, when m is 2 or more, R³ may be selected from two or more groups, and when n is 2 or more, R⁵ may be selected from two or more groups; R⁴ and R⁶ each represents a straight-chain or branched alkyl group having from 1 to 20 carbon atoms; p and q each represents an integer of from 0 to 2; Y¹ and Y² each represents a simple bond or an alkylene group having from 1 to 10 carbon atoms; Z³ and Z⁴ each represents an alkali metal ion, an alkaline earth metal ion, an unsubstituted ammonium ion or an ammonium ion substituted with an alkyl group; and r and s each represents 1 or 2.

It is preferred in the first and third aspects that the chain transfer agent is a thiol compound represented by the formula (XI) : 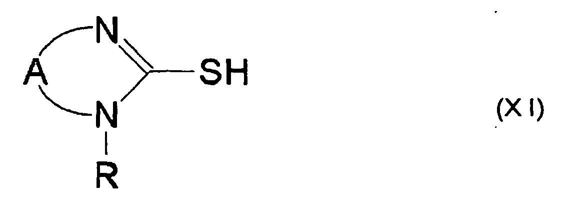 wherein R represents an alkyl group which may have a substituent or an aryl group which may have a substituent; and A represents a moiety which forms a 5-membered or 6-membered hetero ring containing a carbon atom together with the N=C-N linkage, and A may have a substituent.

It is preferred in all three of the above aspects that the developer should contain an alkali metal salt of an organic acid and/or an alkali metal salt of an inorganic acid. It is also preferred that the binder polymer is at least one of a (meth)acrylic copolymer having a crosslinkable group in a side chain or a polyurethane resin having a crosslinkable group in a side chain.

It is even further preferred that the developer contains a chelating agent.

According to the present invention, a plate-making method of a negative-working lithographic printing plate precursor capable of being subjected to image recording with laser exposure in which the good developing property is achieved, the high printing durability is obtained, and the occurrence of development scum is prevented can be provided.

### DERAILED DESCRIPTION OF THE INVENTION

### [plate-Making Method]

The plate-making method of a lithographic printing plate precursor according to the invention will be described in more detail below. The lithographic printing plate precursor described hereinafter is developed after image exposure, with an aqueous alkali solution. Now, a developer for use in the plate-making method according to the invention is described below.

### <Developer>

The developer applied to the plate-making method of a lithographic printing plate precursor according to the invention characterized by having pH in a range of 10.0 to 12.5 and containing an anionic surfactant in an amount of 1.0 to 10.0% by weight. The composition and physical property of the developer are described in order below.

### (Anionic Surfactant)

The anionic surfactant for use in the developer according to the invention is represented by formula (II-A) or (II-B) shown below;

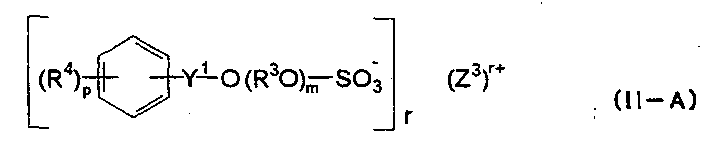

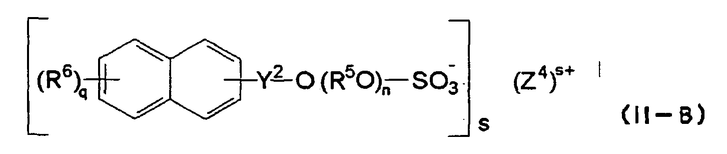

In formula (II-A) or (II-B), R³ and R⁵ each represents a straight-chain or branched alkylene group having from 1 to 5 carbon atoms. Specific examples of the alkylene group include an ethylene group, a propylene group, a butylene group and a pentylene group. Among them, an ethylene group and a propylene group are particularly preferable.
m and n each represents an integer from 1 to 100, preferably from 1 to 30, and more preferably from 2 to 20. When m is 2 or more, plural R³s present may be the same or different. Also, when n is 2 or more, plural R⁵s present may be the same or different.
R⁴ and R⁶ each represents a straight-chain or branched alkyl group having from 1 to 20 carbon atoms. Specific examples of the alkyl group include a methyl group, an ethyl group, a propyl group, a butyl group, a hexyl group and a dodecyl group. Among them a methyl group, an ethyl group, an isopropyl group, a n-propyl group, a n-butyl group, an isobutyl group and a tert-butyl group are particularly preferable.
p and q each represents an integer of 0 to 2.
Y¹ and Y² each represents a simple bond or an alkylene group having from 1 to 10 carbon atoms. Specific examples thereof include a simple bond, a methylene group and an ethylene group. Among them, a simple bond is particularly preferable.
(Z³)^{r+} and (Z⁴)^{s+} each represents an alkali metal ion, an alkaline earth metal ion, an unsubstituted ammonium ion or an ammonium ion substituted with an alkyl group. Specific examples thereof include a lithium ion, a sodium ion, a potassium ion, a magnesium ion, a calcium ion, an ammonium ion and a secondary, tertiary or quaternary ammonium ion substituted with an alkyl group having from 1 to 20 carbon atoms, an aryl group or an aralkyl group. A sodium ion is particularly preferable.
r and s each represents 1 or 2.

Specific examples of the compound represented by formula (II-A) or (II-B) are set forth below, but the invention should not be construed as being limited thereto. In the compounds shown below, x and y each represents a number of repeating units of ethyleneoxy chain or propyleneoxy chain, and specifically represents an integer of 1 to 20 (as an average value).

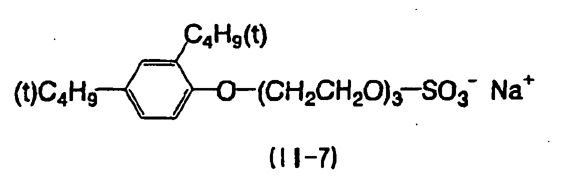

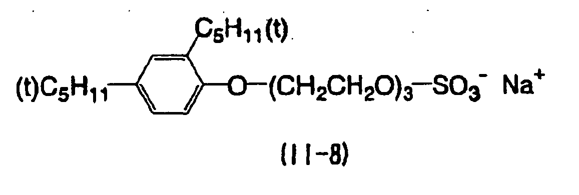

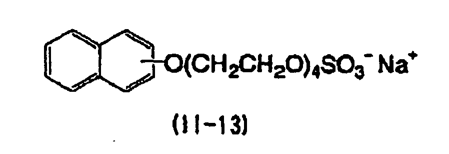

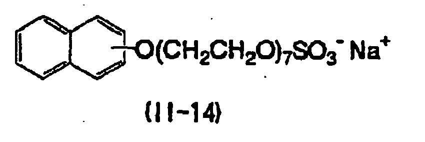

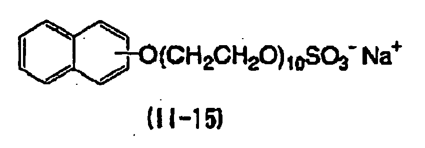

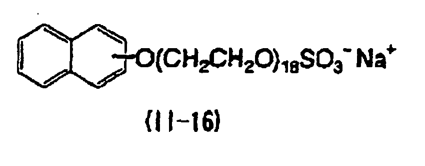

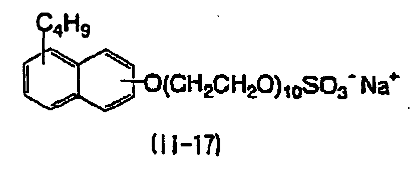

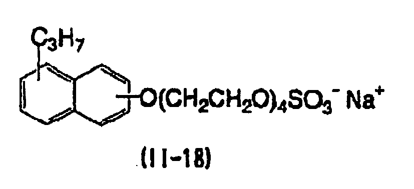

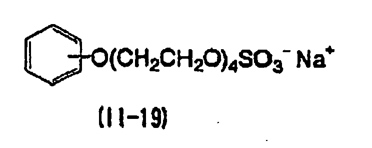

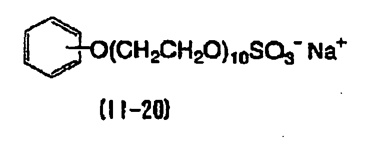

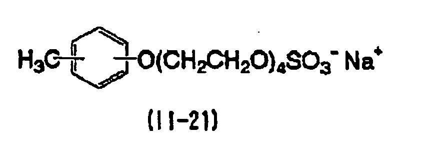

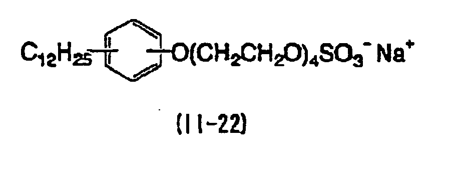

The anionic surfactants may be used individually or in an appropriate combination of two or more thereof. With respect to a content of the anionic surfactant, the concentration of the anionic surfactant in the developer should be in a range of 1.0 to 10% by weight. It is preferably in a range of 2 to 10% by weight. In the above-described range, satisfactory results are obtained in the developing property, dissolution property of the component of photosensitive layer and printing durability of a printing plate prepared.

In the developer for use in the invention, a surfactant other than the above-described anionic surfactant may be used in combination. Examples of the other surfactant include nonionic surfactants, for example, polyoxyethylene naphthyl ether, polyoxyethylene alkyl phenyl ether, polyoxyethylene alkyl ether, e.g., polyoxyethylene lauryl ether, polyoxyethylene cetyl ether or polyoxyethylene stearyl ether, polyoxyethylene alkyl ester, e.g., polyoxyethylene stearate, sorbitan alkyl ester, e.g., sorbitan monolaurate, sorbitan monostearate, sorbitan distearate, sorbitan monooleate, sorbitan sesquioleate or sorbitan trioleate, monoglyceride alkyl ester, e.g., glycerol monostearate or glycerol monooleate. In the case of using the nonionic surfactant together with the anionic surfactant, an amount of the nonionic surfactant added is preferably from 5 to 90% by weight, more preferably from 10 to 80% by weight, and still more preferably from 20 to 50% by weight, based on the total amount of the surfactants from the viewpoint of the developing effect of the anionic surfactant.

### (Defoaming agent)

To the developer for use in the invention, a defoaming agent is preferably added. The defoaming agent used in the invention includes, for example, a silicone type defoaming agent, fluorine type defoaming agent, acetylene alcohol type defoaming agent and acetylene glycol type defoaming agent. Examples of the silicone type defoaming agent and fluorine type defoaming agent include compounds described in 7 to 9 pages of JP-A-62-73270.

Examples of the acetylene alcohol type defoaming agent include an unsaturated alcohol having an acetylene bond (triple bond) in its molecule. Examples of the acetylene glycol type defoaming agent include an unsaturated glycol having an acetylene bond (triple bond) in its molecule, which is also referred to as an alkynediol. More specifically, compounds represented by formula (III) or (IV) shown below are exemplified.

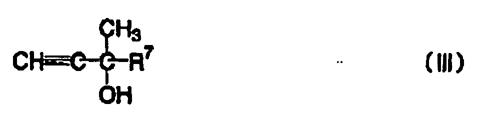

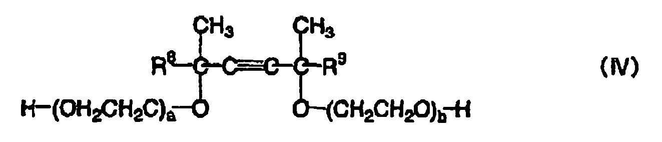

In formula (III) or (IV), R⁷ to R⁹ each represents a straight-chain or branched alkyl group having from 1 to 5 carbon atoms, a + b means a numerical value of 0 to 30. Examples of the straight-chain or branched alkyl group having from 1 to 5 carbon atoms include a methyl group, an ethyl group, an isopropyl group, an isobutyl group and a isopentyl group.

According to the invention, the defoaming agents of various kinds may be used individually or in an appropriate combination of two or more thereof. Among them, the acetylene alcohol type defoaming agent or the acetylene glycol type defoaming agent is preferably used, because a large amount of the defoaming agent can be stably introduced into the developer and as a result, the defoaming effect can be increased.

Specific examples of the acetylene alcohol type defoaming agent and the acetylene glycol type defoaming agent are set forth below, but the invention should not be construed as being limited thereto.

(1) Propagyl alcohol

**CH≡C-CH₂OH**

(2) Propagyl carbinol

**CH≡C-CH₂-CH₂OH**

(3) 3,5-Dimethyl-1-hexyne-3-ol

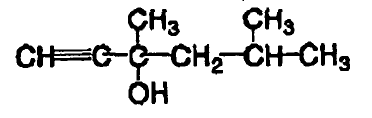

(4) 3-Methyl-1-butyne-3-ol

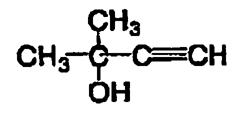

(5) 3-Methyl-1-pentyne-3-ol

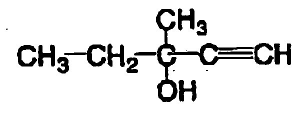

(6) 1,4-Butynediol

**HO-CH₂-C≡C-CH₂-OH**

(7) 2,5-Dimethyl-3-hexyne-2,5-diol

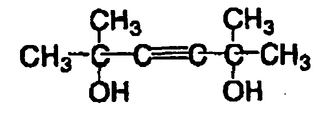

(8) 3,6-Dimethyl-4-octyne-3,6-diol

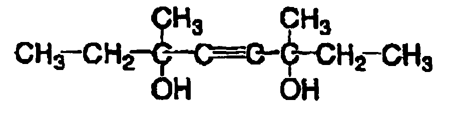

(9) 2,4,7,9-Tetramethyl-5-decyne-4,7-diol

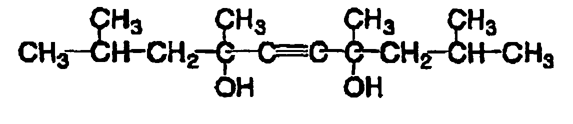

(10) Oxyethylene adduct of 2,4,7,9-tetramethyl-5-decyne-4,7-diol

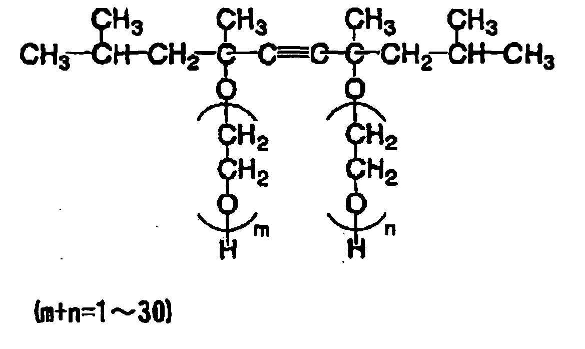

2,5,8,11-Tetramethyl-6-dodecyne-5,8-diol (11)

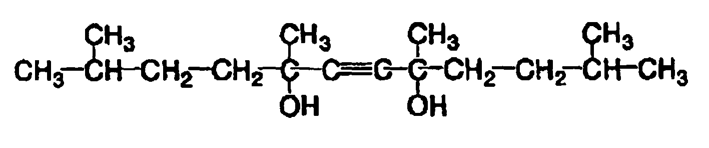

An amount of the defoaming agent added to the developer is preferably 0.0001% by weight or more, particularly preferably from 0.0005 to 0.1% by weight in view of the deforming effect and printing durability. The acetylene alcohol and acetylene glycol deforming agents can be available from the market. As the commercial product, for example, Safinol (trade name, produced by Air Products and Chemicals Inc.) is known. Specific examples of the commercial product include Safinol 61 corresponding to the above-described compound (3), Orphyne B corresponding to the above-described compound (4), Orphyne P corresponding to the above-described compound (5), Orphyne Y corresponding to the above-described compound (7), Safinol 82 corresponding to the above-described compound (8), Safinol 104 and Orphyne AK-02 corresponding to the above-described compound (9), Safinol 400 series corresponding to the above-described compound (10) and Safinol DF-110 corresponding to the above-described compound (11). (Alkali agent)

The alkali agent used in the developer include an inorganic alkali agent, for example, sodium tertiary phosphate, potassium tertiary phosphate, ammonium tertiary phosphate, sodium borate, potassium borate, ammonium borate, sodium hydroxide, potassium hydroxide, ammonium hydroxide or lithium hydroxide, and an organic alkali agent, for example, monomethylamine, dimethylamine, trimethylamine, monoethylamine, diethylamine, triethylamine, monoisopropylamine, diisopropylamine, triisopropylamine, n-butylamine, monoethanolamine, diethanol amine, triethanolamine, monoisopropanolamine, diisopropanolamine, ethyleneimine, ethylenediamine, pyridine or tetramethyl ammonium hydroxide. The alkali agents may be used individually or in combination of two or more thereof in the invention.

As the alkali agent other than those described above, an alkali silicate is preferably exemplified. The alkali silicate may be used in combination with a base. The alkali silicate used in the invention is a compound exhibiting alkaline property when it is dissolved in water, and examples thereof include sodium silicate, potassium silicate, lithium silicate and ammonium silicate. The alkali metal silicates may be used individually or in combination of two of more thereof.

The developer used in the invention can be easily controlled to an optimum range by adjusting the mixing ratio of the silicon oxide SiO₂ to the alkali oxide M₂O (wherein M represents an alkali metal or an ammonium group) as the alkali component and the concentration thereof The mixing ratio of silicon oxide SiO₂ to alkali oxide M₂O (SiO₂/M₂O in a molar ratio) used in the developer is preferably in a range from 0.75 to 4.0 and more preferably in a range from 0.75 to 3.5 in view of suppressions of formation of satin resulting from the excessive dissolution (etching) of an anodized film of aluminum substrate as a support for a lithographic printing plate precursor upon allowing to stand and occurrence of insoluble scum resulting from the formation of a complex between dissolved aluminum and the silicate.

The concentration of the alkali silicate used in the developer is preferably in a range from 0.01 to 1 mol/liter, more preferably from 0.05 to 0.8 mol/liter, as expressed in terms of the amount of SiO₂ based on the developer from the standpoint of the suppression effect on the excessive dissolution (etching) of an anodized film of aluminum substrate, the developing property, the suppression effect on the formation of precipitate and crystal and the effect of preventing gelation at the neutralization in the treatment of waste liquor. When the concentration is less than 0.01 mol/liter, the desired effects can not be obtained and development processing ability may sometimes deteriorate. When it exceeds 1 mol/liter, troubles may be encountered.

It is also preferred that the developer for use in the invention contains a chelating agent to a divalent metal for the purpose, for example, of controlling the influence due to calcium ions or the like included in hard water used. Examples of the chelating agent include a polyphosphoric acid salt, for example, Na₂P₂O₇, Na₅P₃O₃, Na₃P₃O₉, Na₂O₄P(NaO₃P)PO₃Na₂ or Calgon (sodium polymetaphosphate); an aminopolycarboxylic acid and a salt thereof, for example, ethylenediaminetetraacetic acid, potassium salt or sodium salt thereof, diethylenetriaminepentaacetic acid, potassium salt or sodium salt thereof, triethylenetetraminehexaacetic acid, potassium salt or sodium salt thereof, hydroxyethylethylenediaminetriacetic acid, potassium salt or sodium salt thereof, nitrilotriacetic acid, potassium salt or sodium salt thereof, 1,2-diaminocyclohexanetetraacetic acid, potassium salt or sodium salt thereof, or 1,3-diamino-2-propanoltetraacetic acid, potassium salt or sodium salt thereof; and an organic phosphonic acid and a salt thereof, for example, 2-phosphonobutanetricarboxylic acid-1,2,4, potassium salt or sodium salt thereof, 2-phosphonobutanonetricarboxylic acid-2,3,4, potassium salt or sodium salt thereof, 1-phosphonoethanetricarboxylic acid-1,2,2, potassium salt or sodium salt thereof, 1-hydroxyethane-1,1-diphosphonic acid, potassium salt or sodium salt thereof, or aminotri(methylenephosphonic acid), potassium salt or sodium salt thereof. Among them, ethylenediaminetetraacetic acid, potassium salt, sodium salt or an amine salt thereof, ethylenediaminetetra(methylenephosphonic acid), ammonium salt or potassium salt thereof, and hexamethylenediaminetetra(methylenephosphonic acid), ammonium salt or potassium salt thereof are preferable.

Although the optimum amount of the chelating agent may be varied depending on the hardness of hard water used and the amount thereof to be used, in general, it ranges preferably from 0.01 to 5% by weight, more preferably from 0.01 to 2.0% by weight, based on the developer in use.

The developer for use in the invention may include a component described below in addition to the above-described components, if desired. Examples of the additional component include an organic carboxylic acid, for example, benzoic acid, phthalic acid, p-ethylbenzoic acid, p-n-propylbenzoic acid, p-isopropylbenzoic acid, p-n-butylbenzoic acid, p-tert-butylbenzoic acid, p-2-hydroxyethylbenzoic acid, decanoic acid, salicylic acid or 3-hydroxy-2-naphthoic acid; an organic solvent, for example, isopropyl alcohol, benzyl alcohol, ethyl cellosolve, butyl cellosolve, phenyl cellosolve, propylene glycol or diacetone alcohol; and a reducing agent, a dye, a pigment, a water softener and a preservative.

The pH of the developer for use in the invention is essentially in a range of 10 to 12.5 (at 25°C), and preferably in a range of 11 to 12.5. The adjustment of the pH of the developer to a relatively low value is preferable since the damage in the exposed area at the development is reduced and the handling property of the developer is excellent.

Also, the conductivity x of the developer preferably satisfies 2 < x < 30 mS/cm, and is more preferably in a range of 5 to 25 mS/cm.

It is preferred to add the developer at least one of an alkali metal salt of organic acid and an alkali metal salt of inorganic acid as a conductivity-controlling agent in order to control the conductivity of developer. Specific examples thereof include potassium salt of an organic carboxylic acid, sodium salt of an organic carboxylic acid, potassium carbonate and sodium carbonate. Among them, potassium carbonate and sodium carbonate are particularly preferable. The amount thereof added is preferably in a range of 0.01 to 10% by weight, and more preferably in a range of 1 to 5% by weight.

The developer described above can be used as a developer or a replenisher for the development of an exposed negative-working lithographic printing plate precursor and it is preferably used in an automatic developing machine. In the case of development using an automatic developing machine, the developer is fatigued in proportion to the amount of processing and therefore, the processing capability of the developer may be restored by the use of a replenisher or a fresh developer. The replenishing system can be preferably adopted in the plate-making method of a lithographic printing plate precursor according to the invention.

### (Exposure and Development Processing)

The lithographic printing plate precursor according to the invention is exposed imagewise with a laser beam of 350 to 450 nm and then subjected to the development processing with a developer to form an image on the surface of aluminum plate support.

It is possible to provide, between the imagewise exposure and the development processing, a process of heating the photosensitive layer at a temperature of 50 to 140°C for 1 second to 5 minutes for the purpose of increasing the curing ratio of the photosensitive layer. The heating at the temperature in the above-described range serves to increase the curing ratio and to prevent the remaining layer in the unexposed area due to dark polymerization.

As described hereinbefore, the protective layer is provided on the photosensitive layer of the lithographic printing plate precursor according to the invention. There are known a method of removing both the protective layer and the unexposed area of the photosensitive layer at the same time using a developer and a method of first removing the protective layer with water or warm water, and then removing the unexposed area of the photosensitive layer by development. Into the water or warm water may be incorporated a preservative as described in JP-A-10-10754 or an organic solvent as described in JP-A-8-278636.

The development of the lithographic printing plate precursor according to the invention with the above-described developer is conducted at a temperature from 0 to 60°C, preferably from about 15 to about 40°C in a conventional manner, for example, by immersing the exposed lithographic printing plate precursor in the developer and rubbing with a brush.

Further, in the case of conducting the development processing using an automatic developing machine, the developer is fatigued in accordance with the amount of processing and therefore, the processing capability of the developer may be restored by the use of a replenisher or a fresh developer. The lithographic printing plate precursor thus development-processed is subjected to after treatment with washing water, a rinse solution containing, for example, a surfactant, or an oil- desensitizing solution containing, for example, gum arabic or a starch derivative as described, for example, in JP-A-54-8002, JP-A-55-115045 and JP-A-59-58431. In the after-treatment of the lithographic printing plate precursor according to the invention, these processings may be used in combination.

The printing plate thus-obtained by the above-described processing may be subjected to an after-exposure treatment in the manner as described in JP-A-2000-89478 or a heating treatment, for example, baking, in order to improve the printing durability.

The lithographic printing plate thus-obtained is mounted on an offset printing machine to perform printing of a large number of sheets.

### [Lithographic Printing Plate Precursor]

The lithographic printing plate precursor for use in the invention is described below.

### [Photosensitive Layer]

The photosensitive layer according to the invention contains (A) a sensitizing dye having absorption in a wavelength of 405 nm, (B) a hexaarylbiimidazole compound, (C) a polymerizable compound, (D) a binder polymer and (E) a chain transfer agent. The photosensitive layer according to the invention may further contain other components. The constituting components of the photosensitive layer will be described in greater detail below.

### (A) Sensitizing Dye

The photosensitive layer according to the invention can contain a sensitizing dye responding to a wavelength of an exposure light source.

Sensitizing dyes having an absorption maximum in a wavelength range of 300 to 500 nm are described at the beginning. Examples of the sensitizing dye include merocyanine dyes represented by formula (V) shown below, benzopyranes represented by formula (VI) shown below, coumarins, aromatic ketones represented by formula (VII) shown below, and anthracenes represented by formula (VIII) shown below.

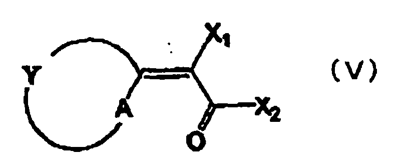

In formula (V), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye.

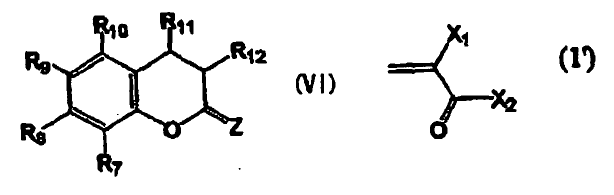

In formula (VI), =Z represents a carbonyl group, a thiocarbonyl group, an imino group or an alkylydene group represented by the partial structural formula (I') described above, X₁ and X₂ have the same meanings as defined in formula (V), and R₇ to R₁₂ each independently represents a monovalent non-metallic atomic group.

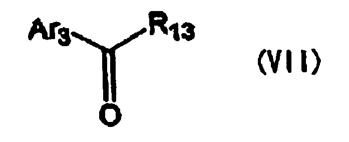

In formula (VII), Ar₃ represents an aromatic group which may have a substituent or a heteroaromatic group which may have a substituent, and R₁₃ represents a monovalent non-metallic atomic group. R₁₃ more preferably represents an aromatic group or a heteroaromatic group. Ar₃ and R₁₃ may be combined with each other to form a ring.

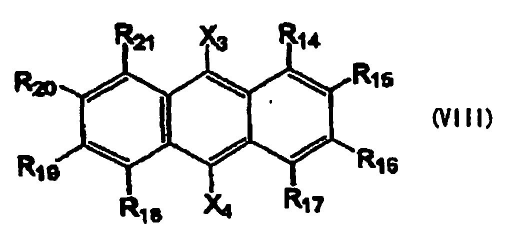

In formula (VIII), X₃, X₄ and R₁₄ to R₂₁ each independently represents a monovalent non-metallic atomic group. More preferably, X₃ and X₄ each independently represents an electron-donating group having a negative Hammett substituent constant.

In formulae (V) to (VIII), preferred examples of the monovalent non-metallic atomic group represented by X₁ to X₄ and R₆ to R₂₁ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-metbylbutyl group, an isohexyl group, a 2-ethylhexyl group, a 2-methylhexyl group, a cyclohexyl group, a cyclopentyl group, a 2-norbomyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group or a phosphonatophenyl group), a heteroaryl group (for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl goup), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diaryl-carbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxy group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group''), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, and a nitro group. Of the substituents, a hydroxy group, an alkyl group, an aryl group, a halogen atom, an alkoxy group and an acyl group are particularly preferred.

The basic nucleus of the dye formed by Y together with the adjacent A and the adjacent carbon atom in formula (V) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenylthiazole) or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7'6',4,5-thiazole); oxazoles (for example, 4-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5-methoxybenzoxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); 2-pyridines (for example, pyridine or 5-methylpyridine); and 4-pyridines (for example, pyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolidene group.

Of the sensitizing dyes having an absorption maximum in a wavelength range of 360 to 450 nm, dyes represented by formula (IX) shown below are more preferred in view of high sensitivity.

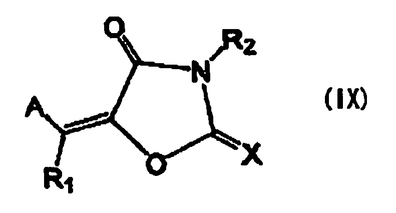

In formula (IX). A represents an aromatic ring which may have a substituent or a hetero ring which may have a substituent, X represents an oxygen atom, a sulfur atom or N-(R₃), and R₁, R₂ and R₃ each independently represents a hydrogen atom or a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a hydrogen atom or a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic group, a substituted or unsubstituted alkoxy group, a substituted or unsubstituted alkylthio group, a hydroxy group or a halogen atom.

Preferred examples of R₁, R₂ and R₃ will be specifically described below. Preferred examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferred examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N',diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base goup (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group, a nitro group, an aryl group, a heteroaryl group, an alkenyl group and an alkynyl groups.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxyphenylcarbonyl group, a phenoxycarbonylphenyl group, an N-phenylcarbamoylphenyl group, a phenyl group, a cyanophenyl group, a sulfophenyl group, a sulfonatophenyl group, a phosphonophenyl group and a phosphonatophenyl group.

Preferred examples of the aromatic heterocyclic group represented by any one of R₁, R₂ and R₃ include a monocyclic or polycyclic aromatic ring containing at least one of a nitrogen atom, an oxygen atom and a sulfur atom. Examples of especially preferred aromatic heterocyclic group include thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indoyl, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane and phenoxazine. These groups may be benzo-fused or may have a substituent.

Also, preferred examples of the alkenyl group represented by any one of R₁, R₂ and R₃ include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferred alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferred substituted alkyl group represented by any one of R₁, R₂ and R₃, which is obtained by combining the above-described substituent with an alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an NN-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferred examples of the aryl group represented by any one of R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferred substituted aryl group represented by any one of R₁, R₂ and R₃ include aryl groups having a monovalent non-metallic atomic group exclusive of a hydrogen atom as a substituent on the ring-forming carbon atom of the above-described aryl group. Preferred examples of the substituent include the above-described alkyl groups and substituted alkyl groups, and the substituents described for the above-described substituted alkyl group. Specific examples of the preferred substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl goup, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-meth-ylbenzoylaminophenyl group, a carboxyphenyl group, a methoxycarbonylphenyl group, an allyloxycarbonylphenyl group, a chlorophenoxycarbonylphenyl group, a carbamoylphenyl group,-an N-methylcarbamoylphenyl group, an N,N-dipropylcarbamoyl-phenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropyl-sulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propenylphenyl group, a 2-butynylphenyl group and a 3-butynylphenyl group.

Next, A in formula (IX) will be described below. A represents an aromatic ring which may have a substituent or hetero ring which may have a substituent. Specific examples of the aromatic ring which may have a substituent or hetero ring which may have a substituent include those described for any one of R₁, R₂ and R₃ in formula (IX).

The sensitizing dye represented by formula (IX) according to the invention is obtained by a condensation reaction of the above-described acidic nucleus or an active methyl group-containing acidic nucleus with a substituted or unsubstituted, aromatic ring or hetero ring and can be synthesized with reference to JP-B-59-28329.

Preferred specific examples (D1) to (D75) of the compound represented by formula (IX) are set forth below. Also, when isomers with respect to a double bond connecting an acidic nucleus and a basic nucleus are present, the invention should not be construed as being limited to any one of the isomers.

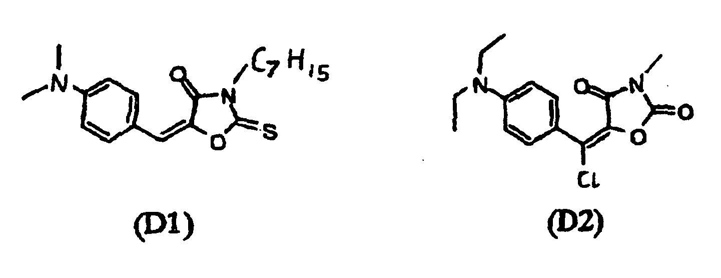

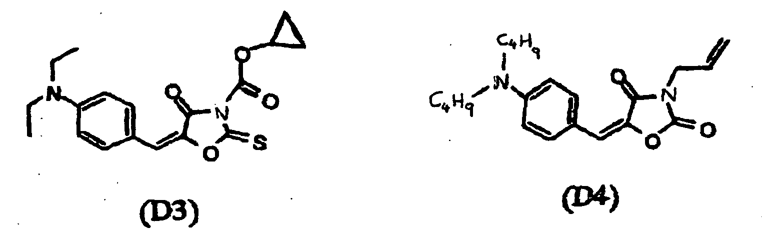

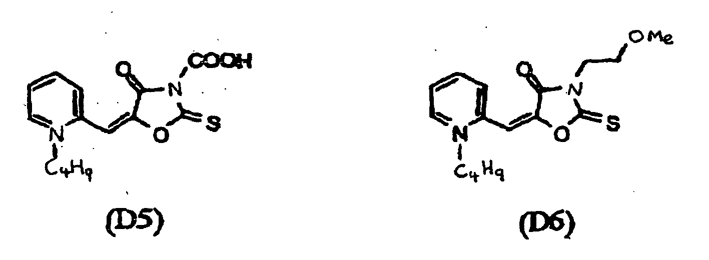

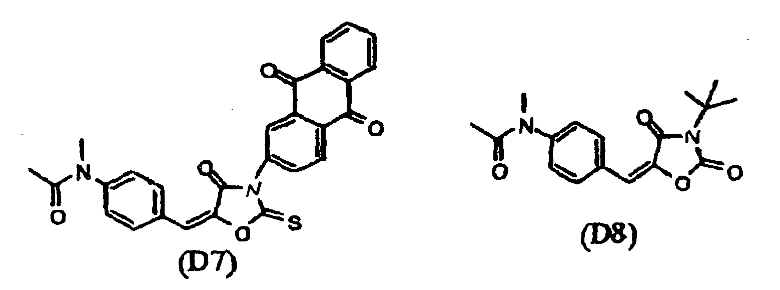

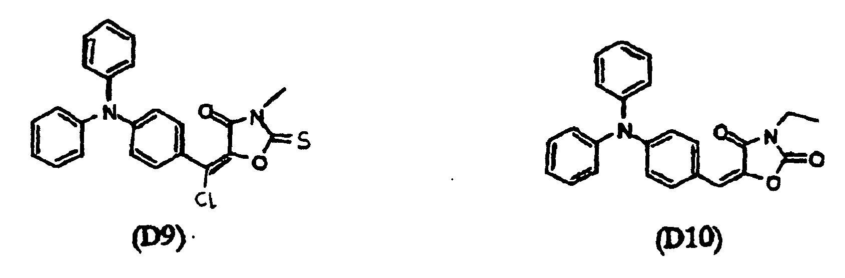

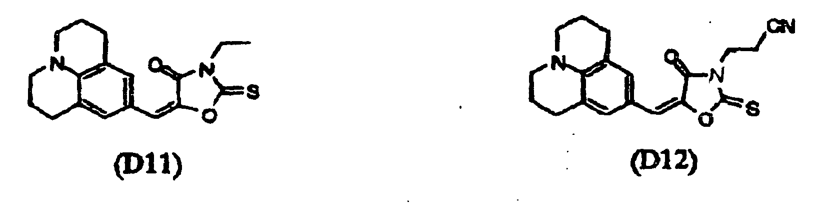

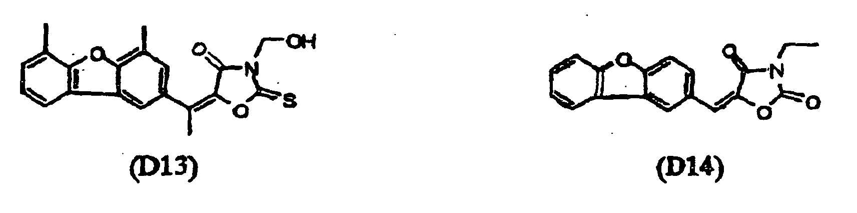

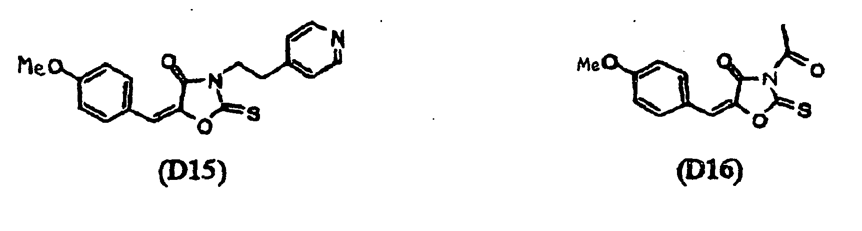

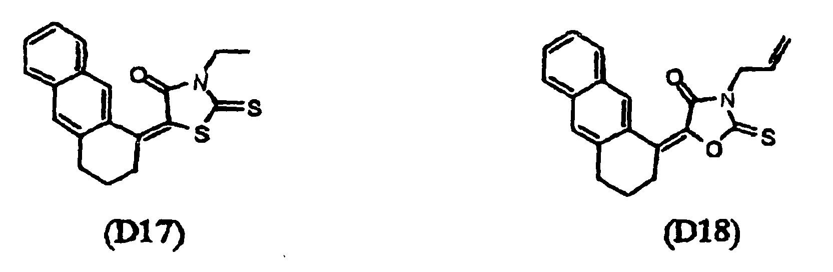

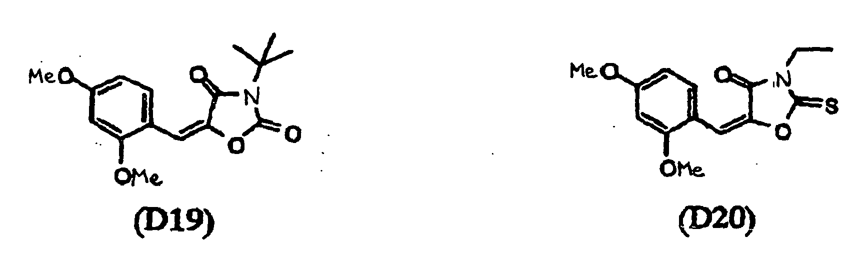

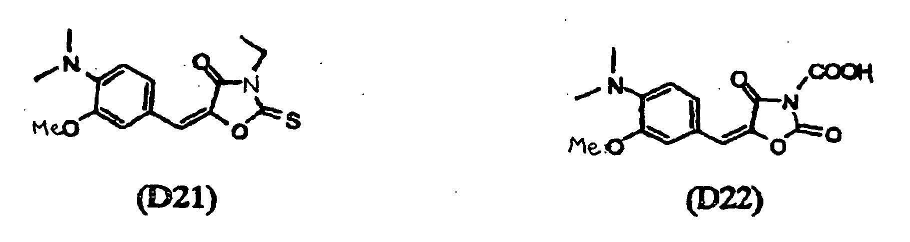

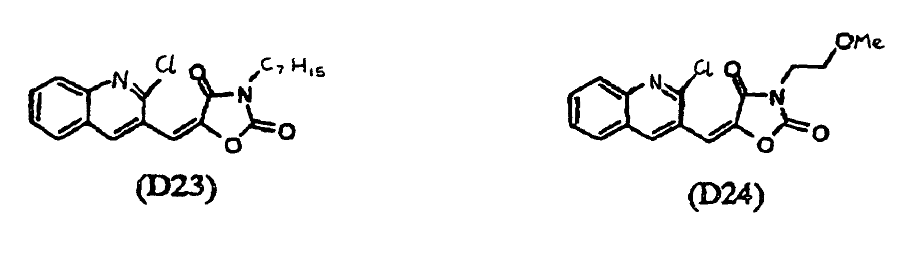

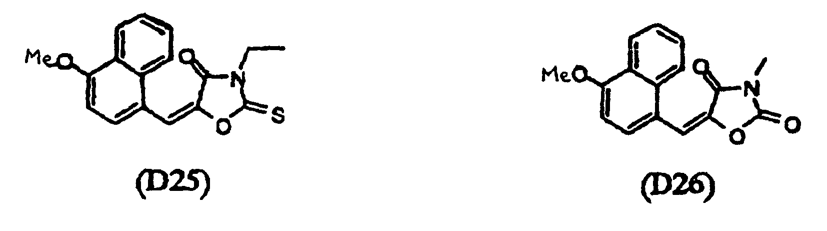

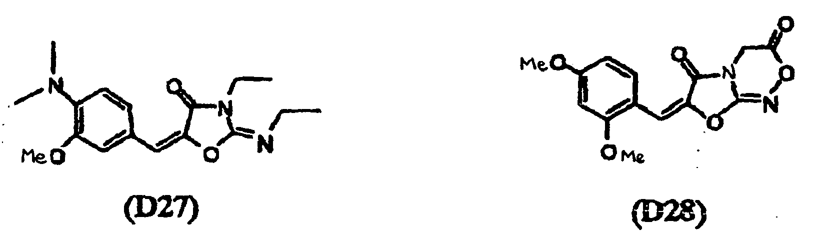

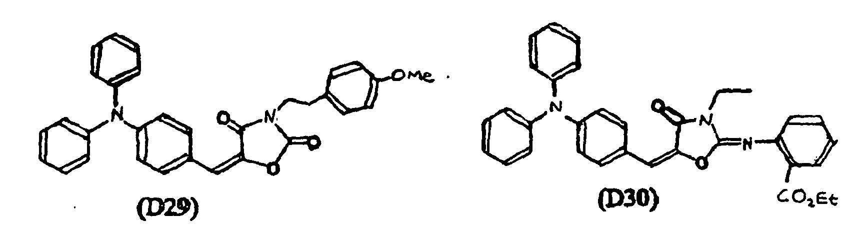

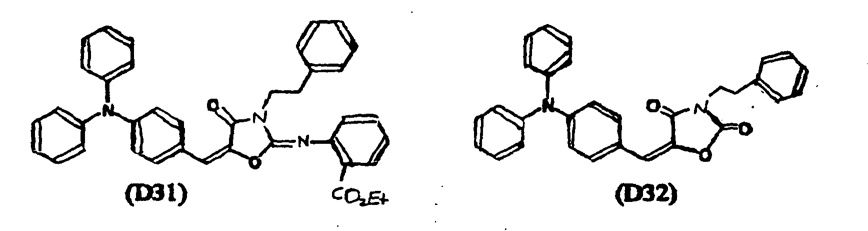

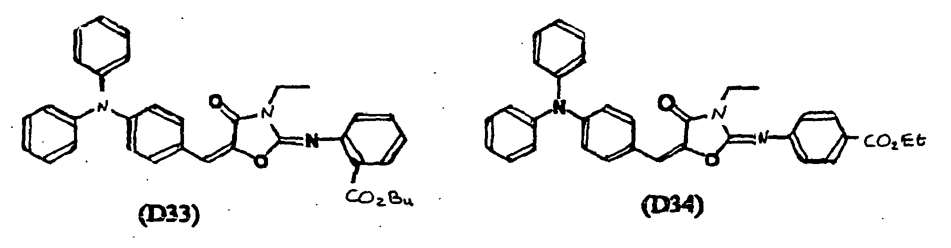

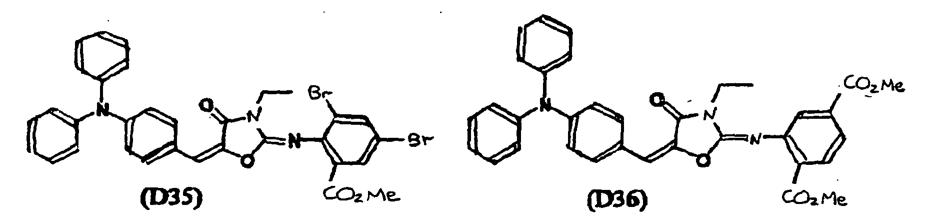

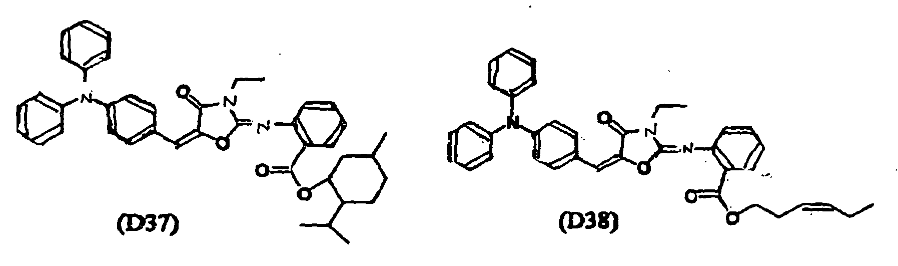

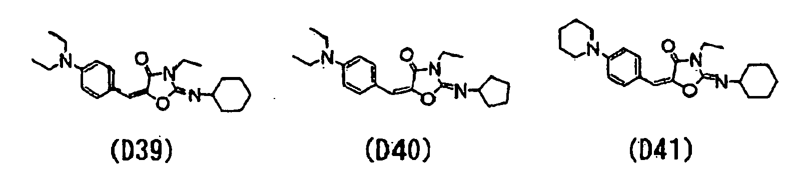

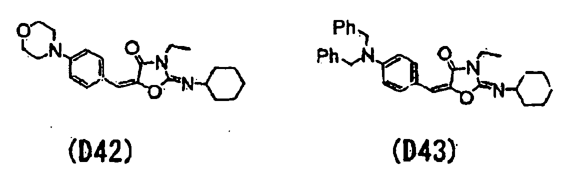

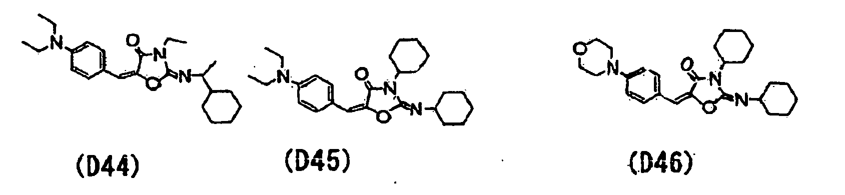

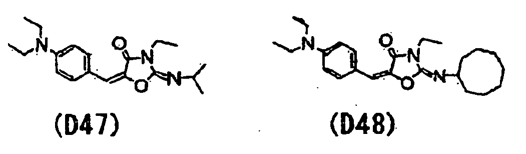

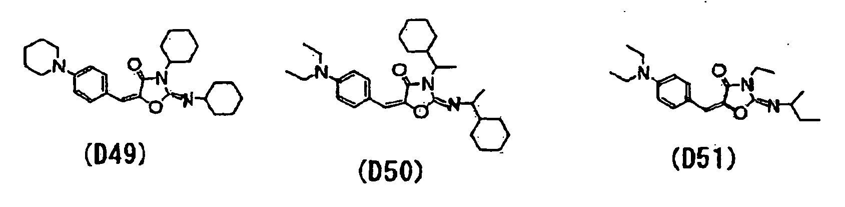

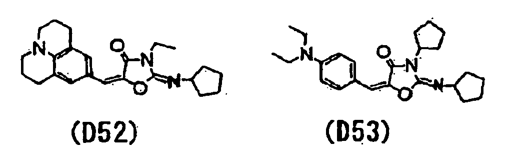

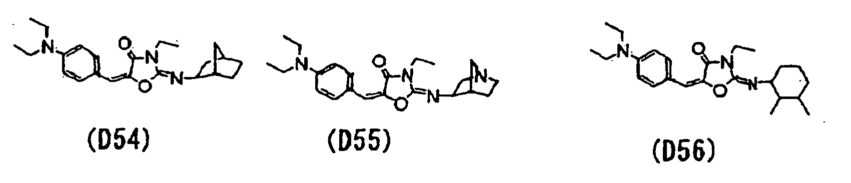

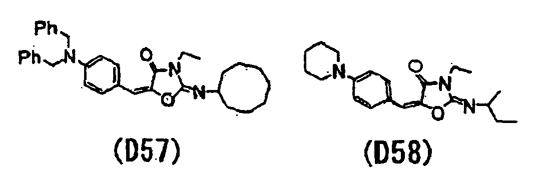

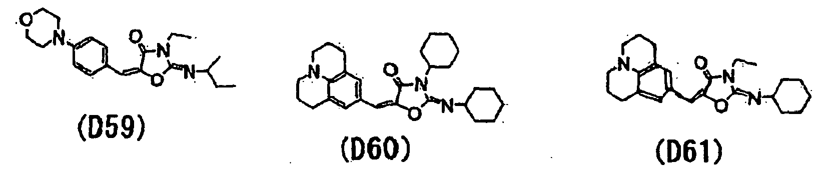

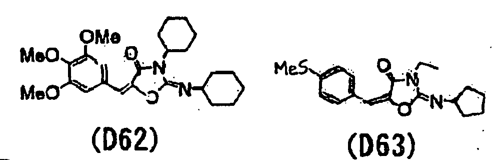

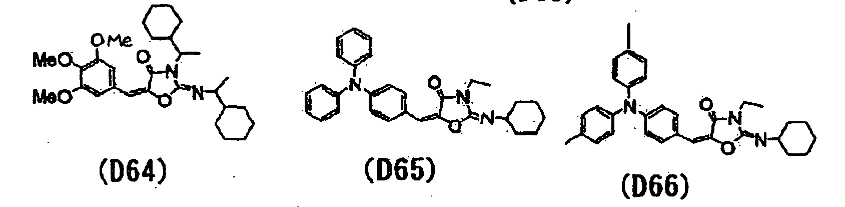

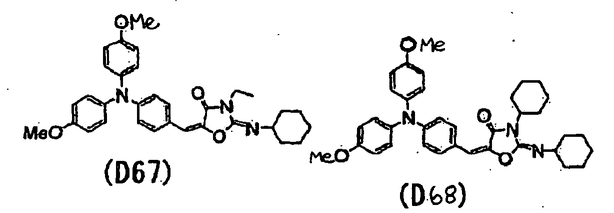

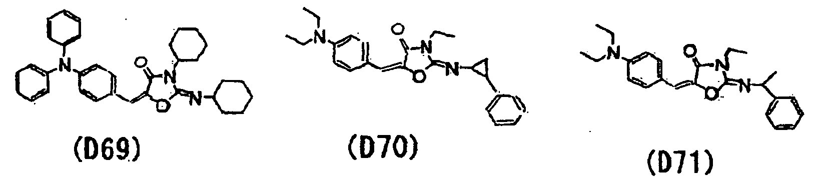

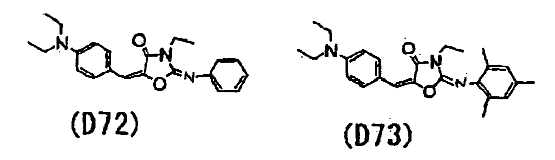

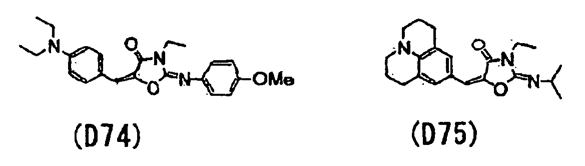

### (B) Polymerization Initiator

As the polymerization initiator, a hexaarylbiimidazole compound is used in the invention.

Examples of the hexaarylbiimidazole polymerization initiator include lophine dimers described in JP-B-45-37377 and JP-B-44-86516, and more specifically,
2,2'-bis(o-chlorophenyl)-4,4',5,5'-tetraphenylbiimidazole,
2,2'-bis(o-bromophenyl)-4,4',5,5'-tetraphenylbiimidazole,
2,2'-bis(o,p-dichlorophenyl)-4,4',5,5'-tetraphenylbiimidazole,
2,2'-bis(o-chlorophenyl)-4,4',5,5'-tetra(m-methoxyphenyl)biimidazole,
2,2'-bis(o,o'-dichlorophenyl)-4,4',5,5'-tetraphenylbiimidazole,
2,2'-bis(o-nitrophenyl)-4,4',5,5'-tetraphenylbiimidazole,
2,2'-bis(o-methylphenyl)-4,4',5,5'-tetraphenylbiimidazole and 2,2'-bis(o-trifluoromethylphenyl)-4,4',5,5'-tetraphenylbiimidazole.

In the invention, a trihalomethyl compound, an onium salt compound or a titanocene compound may be used together with the hexaarylbiimidazole compound, as the polymerization initiator.

The trihalomethyl compound preferably includes trihalomethyl-s-triazines, and specifically s-triazine derivatives having a trihalogen-substituted methyl group described in JP-A-58-29803, for example, 2,4,6-tris(trichloromethyl)-s-triazine, 2-methoxy-4,6-bis(trichloromethyl)-s-triazine, 2-amino-4,6-bis(trichloromethyl)-s-triazine and 2-(p-methoxystyryl)-4,6-bis(trichloromethyl)-s-triazine.

The onium salt includes, for example, onium salts represented by the following formula (X):

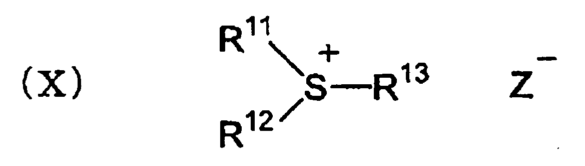

In formula (X), R¹¹, R¹² and R¹³, which may be the same or different, each represents a hydrocarbon group having 20 or less carbon atoms which may have a substituent. Preferred examples of the substituent include a halogen atom, a nitro group, an alkyl group having 12 or less carbon atoms, an alkoxy group having 12 or less carbon atoms and an aryloxy group having 12 or less carbon atoms. Z⁻ represents a counter ion selected from the group consisting of a halogen ion, a perchlorate ion, a tetrafluoroborate ion, a hexafluorophosphate ion, a carboxylate ion and a sulfonate ion, and preferably a perchlorate ion, a hexafluorophosphate ion, a carboxylate ion or an arylsulfonate ion.

The titanocene compound can be used by appropriately selecting, for example, from known compounds as described in JP-A-59-152396 and JP-A-61-151197. Specific examples thereof include dicyclopentadienyl-T1-dichloride,
dicyclopentadienyl-Ti-bisphenyl,
dicyclopentadienyl-Ti-bis-2,3,4,5,6-pentafluorophen-1-yl,
dicyclopentadienyl-Ti-bis-2,3,5,6-tetrafluorophen-1-yl,
dicyclopentadienyl-Ti-bis-2,4,6-trifluorophen-1-yl,
dicyclopentadienyl-Ti-bis-2,6-difluorophen-1-yl,
dicyclopentadienyl-Ti-bis-2,4-difluorophen-1-yl,
dimethylcyclopentadienyl-Ti-bis-2,3,4,5,6-pentafluorophen-1-yl,
dimethylcyclopentadienyl-Ti-bis-2,3,5,6-tetrafluorophen-1-yl,
dimethylcyclopentadienyl-Ti-bis-2,4-difluorophen-1-yl and
bis(cyclopentadienyl)-bis-(2,6-difluoro-3-(pyr-1-1yl)phenyl) titanium.

The polymerization initiators are preferably used individually or as a mixture of two or more thereof in the invention.

An amount of the polymerization initiator used in the invention is preferably from 0.01 to 20% by weight, more preferably from 0.1 to 15% by weight, and still more preferably from 1.0 to 10% by weight, based on the total solid content of the photosensitive layer.

### (C) Polymerizable Compound

The polymerizable compound used in the photosensitive layer according to the invention is an addition-polymerizable compound having at least one ethylenically unsaturated double bond and it is selected from compounds having at least one, preferably two or more, terminal ethylenically unsaturated double bonds. Such compounds are broadly known in the field of art and they can be used in the invention without any particular limitation. The compound has a chemical form, for example, a monomer, a prepolymer, specifically, a dimer, a trimer or an oligomer, or a copolymer thereof, or a mixture thereof. Examples of the monomer and copolymer thereof include unsaturated carboxylic acids (for example, acrylic acid, methacrylic acid, itaconic acid, crotonic acid, isocrotonic acid or maleic acid) and esters or amides thereof Preferably, esters of an unsaturated carboxylic acid with an aliphatic polyhydric alcohol compound and amides of an unsaturated carboxylic acid with an aliphatic polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy, or a dehydration condensation reaction product of the unsaturated carboxylic acid ester or amide with a monofunctional or polyfunctional carboxylic acid is also preferably used. Furthermore, an addition reaction product of an unsaturated carboxylic acid ester or amide having an electrophilic substituent, for example, an isocyanato group or an epoxy group with a monofunctional or polyfunctional alcohol, amine or thiol, or a substitution reaction product of an unsaturated carboxylic acid ester or amide having a releasable substituent, for example, a halogen group or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of an aliphatic polyhydric alcohol compound with an unsaturated carboxylic acid, include acrylic acid esters, for example, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, isocyanuric acid ethylene oxide (EO) modified triacrylate or polyester acrylate oligomer;
methacrylic acid esters, for example, tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane or bis[p-(methacryloxyethoxy)phenyl]dimethylmethane;
itaconic acid esters, for example, ethylene glycol diitaconate, propylene glycol diitaconate, 1,3-butanediol diitaconate, 1,4-butanediol diitaconate, tetramethylene glycol diitaconate, pentaerythritol diitaconate or sorbitol tetraitaconate; crotonic acid esters, for example, ethylene glycol dicrotonate, tetramethylene glycol dicrotonate, pentaerythritol dicrotonate or sorbitol tetradicrotonate; isocrotonic acid esters, for example, ethylene glycol diisocrotonate, pentaerythritol diisocrotonate or sorbitol tetraisocrotonate; and maleic acid esters, for example, ethylene glycol dimaleate, triethylene glycol dimaleate, pentaerythritol dimaleate and sorbitol tetramaleate.

Other examples of the ester, which can be preferably used, include aliphatic alcohol esters described in JP-B-51-47334 and JP-A-57-196231, esters having an aromatic skeleton described in JP-A-59-5240, JP-A-59-5241 and JP-A-2-226149, and esters containing an amino group described in JP-A-1-165613.

The above-described ester monomers can also be used as a mixture.

Specific examples of the monomer, which is an amide of an aliphatic polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide. Other preferred examples of the amide monomer include amides having a cyclohexylene structure described in JP-B-54-21726.

Urethane type addition polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used. Furthermore, a photopolymerizable composition having remarkably excellent photosensitive speed can be obtained by using an addition polymerizable compound having an amino structure or a sulfide structure in its molecule, described in JP-A-63-277653, JP-A-63-260909 and JP-A-1-105238.

Other examples include polyfunctional acrylates and methacrylates, for example, polyester acrylates and epoxy acrylates obtained by reacting an epoxy resin with (meth)acrylic acid, described in JP-A-48-64183, JP-B-49-43191 and JP-B-52-30490. Specific unsaturated compounds described in JP-B-46-43946, JP-B-1-40337 and JP-B-1-40336, and vinylphosphonic acid type compounds described in JP-A-2-25493 can also be exemplified. In some cases, structure containing a perfluoroalkyl group described in JP-A-61-22048 can be preferably used. Moreover, photocurable monomers or oligomers described in Nippon Secchaku Kyokaishi (Journal of Japan Adhesion Society), Vol. 20, No. 7, pages 300 to 308 (1984) can also be used.

Details of the method of using the polymerizable compound, for example, selection of the structure, individual or combination use, or an amount added, can be appropriately arranged depending on the characteristic design of the final lithographic printing plate precursor. For instance, the compound is selected from the following standpoints.

In view of the sensitivity, a structure having a large content of unsaturated groups per molecule is preferred and in many cases, a bifunctional or more functional compound is preferred. In order to increase the strength of image area, that is, hardened layer, a trifunctional or more functional compound is preferred. A combination use of compounds different in the functional number or in the kind of polymerizable group (for example, an acrylic acid ester, a methacrylic acid ester, a styrene compound or a vinyl ether compound) is an effective method for controlling both the sensitivity and the strength.

The selection and use method of the polymerizable compound are also important factors for the compatibility and dispersibility with other components (for example, a binder polymer, a polymerization initiator or a coloring agent) in the photosensitive layer. For instance, the compatibility may be improved in some cases by using the compound of low purity or using two or more kinds of the compounds in combination. A specific structure may be selected for the purpose of improving an adhesion property to a support or a protective layer described hereinafter.

The polymerizable compound is preferably used in an amount from 5 to 80% by weight, more preferably from 25 to 75% by weight, based on the total solid content of the photosensitive layer. The polymerizable compounds may be used individually or in combination of two or more thereof In the method of using the polymerizable compound, the structure, blend and amount added can be appropriately selected by taking account of the degree of polymerization inhibition due to oxygen, resolution, fogging property, change in refractive index, surface adhesion and the like. Further, depending on the case, a layer construction, for example, an undercoat layer or an overcoat layer, and a coating method, may also be considered.

### (D) Binder Polymer

In the invention, a binder polymer is used as the essential component in order to improve the film property and developing property of the photosensitive layer. Further, the binder polymer used in the invention is preferably characterized by having a crosslinkable property in order to improve the film strength of the image area. In order to impart the crosslinkable property to the binder polymer, a crosslinkable functional group, for example, an ethylenically unsaturated bond is introduced into a main chain or side chain of the polymer. The crosslinkable functional group may be introduced by copolymerization or a polymer reaction.

The crosslinkable group means a group capable of crosslinking the polymer binder in the process of a radical polymerization reaction which is caused in the photosensitive layer, when the photosensitive lithographic printing plate is exposed to light. The crosslinkable group is not particularly restricted as long as it has such a function and includes, for example, an ethylenically unsaturated bonding group, an amino group or an epoxy group as a functional group capable of conducting an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferable, and functional groups represented by formulae (1) to (3) shown below are particularly preferable.

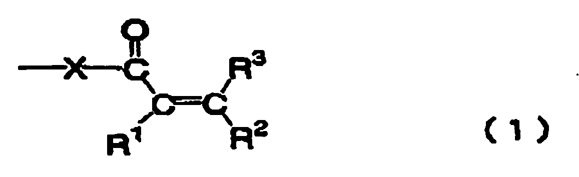

In formula (1), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity. R² and R³ each independently preferably includes, for example, a hydrogen atom, a halogen atom, an amino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The organic group represented by R¹² includes, for example, an alkyl group which may have a substituent. Among them, a hydrogen atom, a methyl group, an ethyl group or an isopropyl group is preferable because of high radical reactivity.

Examples of the substituent introduced include an alkyl group, an alkenyl group, an alkynyl group, an aryl group, an alkoxy group, an aryloxy group, a halogen atom, an amino group, an alkylamino group, an arylamino group, a carboxy group, an alkoxycarbonyl group, a sulfo group, a nitro group, a cyano group, an amido group, an alkylsulfonyl group and an arylsulfonyl group.

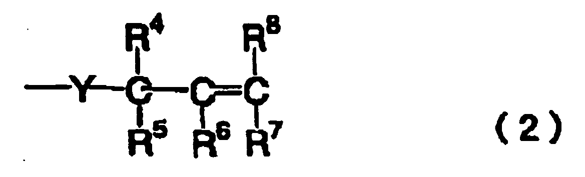

In formula (2), R⁴ to R⁸ each independently represents a hydrogen atom or a monovalent organic group. R⁴ to R⁸ each independently preferably includes, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a- substituent or an aryl group which may have a substituent is preferable.

Examples of the substituent introduced include those described in Formula (1). Y represents an oxygen atom, a sulfur atom or -N(R¹²)-, and R¹² has the same meaning as R¹² defined in Formula (1). Preferred examples for R¹² are also same as those described in Formula (1).

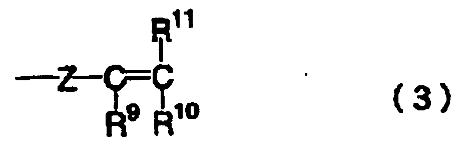

In formula (3), R⁹ preferably represents a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxy group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxy group, an alkoxycarbonyl group, an alkyl group which may have a substituent or an aryl group which may have a substituent is preferable because of high radical reactivity.

Examples of the substituent introduced include those described in Formula (1). Z represents an oxygen atom, a sulfur atom, -N(R¹³)- or a phenylene group which may have a substituent. R¹³ preferably includes an alkyl group which may have a substituent. Among them, a methyl group, an ethyl group or an isopropyl group is preferable because of high radical reactivity.

The polymer binder having a crosslinkable group in a side chain according to the invention not only functions as a film-forming agent but also is preferably an organic polymer which is soluble or swellable in alkali water since it is needed to be dissolved in a developer, preferably an alkali developer. Therefore, it is preferred that the polymer binder according to the invention has an alkali-soluble group, for example, a carboxy group, in the side chain in addition to the crosslinkable group. In the case where the polymer binder having a crosslinkable group in a side chain is a water-soluble organic polymer, it is possible to conduct water development.

Examples of the polymer binder according to the invention include (meth)acrylic acid copolymers, itaconic acid copolymers, crotonic acid copolymers, maleic acid copolymers and partially esterified maleic acid copolymers each having a crosslinkable group, for example, an allyl group or a (meth)acryloyl group in the side chain thereof as described in JP-A-59-53836 and JP-A-59-71048.

Also, polyurethanes, acid cellulose derivatives and adducts between an addition polymer having a hydroxy group and a cyclic acid anhydride, each having the crosslinkable group and carboxy group in the side chain are useful as the polymer binder according to the invention.

Of the polymers, the (meth)acrylic acid copolymers and polyurethanes are more preferable. In particular, the polyurethane resins are preferable from the standpoint that development damage in the exposed area can be prevented without accompanying with decrease in developing property in the unexposed area so that both good stain resistance and high printing durability can be achieved, even when an acid value of the photosensitive layer is low.

The polyurethane resin having a crosslinkable group in the side chain thereof is described in more detail below.

The polyurethane resin having a crosslinkable group in the side chain thereof particularly preferably used in the invention can be obtained by a polyaddition reaction of (i) a diisocyanate compound, (ii)a diol compound having a carboxy group, (iii) a diisocyanate compound having a crosslinkable group, and if desired, (iv) a diol compound containing no carboxy group.

The diisocyanate compound and diol compound which are starting materials of the polyurethane resin will be described in more detail below.

### (i) Diisocyanate compound

Examples of the diisocyanate compound include diisocyanate compounds represented by the following formula (4):

OCN-L-NCO (4)

In formula (4), L represents a single bond or a divalent aliphatic or aromatic hydrocarbon group which may have a substituent. If desired, L may contain other functional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent (preferably, for example, an alkyl group, an aralkyl group, an aryl group, an alkoxy group or a halogeno group); preferably an alkylene group having from 1 to 20 carbon atoms or an arylene group having from 6 to 15 carbon atoms; and more preferably an alkylene group having from 1 to 8 carbon atoms. Also, if desired, L may contain other functional group which does not react with the isocyanate group, for example, a carbonyl group, an ester group, a urethane group, an amido group, a ureido group or an ether group.

Specific examples of the diisocyanate compound represented by formula (4) include the following compounds. Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4'-diphenylmethane diisocyanate, 1,5-naphthalene diisocyanate or 3,3'-dimethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4(or 2,6)-diisocyanate or 1,3-(isocyanatomethyl)cyclohexane; and a diisocyanate compound obtained by a reaction of diol with diisocyanate, for example, an adduct of 1 mole of 1,3-butylene glycol with 2 moles of tolylene diisocyanate are exemplified.

The diisocyanate compounds may be used individually or in combination of two or more thereof. In view of the balance between printing durability and stain resistance, it is preferred to use two or more of the diisocyanate compounds in combination, and it is particularly preferred to use at least one of the aromatic diisocyanate compounds (L represents an aromatic group) and at least one of the aliphatic diisocyanate compounds (L represents an aliphatic group).

With respect to an amount of the diisocyanate compound used, a molar ration of the diisocyanate compound to the diol compound is preferably from 0.8 to 1.2, and more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal.

### (ii) Diol Compound Having At Least One Carboxy Group

The diol compound having at least one carboxy group includes diol compounds represented by formulae (5), (6) and (7) shown below and/or a compound obtained by ring opening of a tetracarboxylic acid dianhydride with a diol compound. The diol compound used for the purpose of ring opening of the tetracarboxylic acid dianhydride can be used.

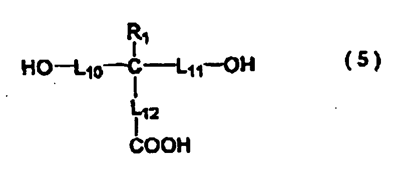

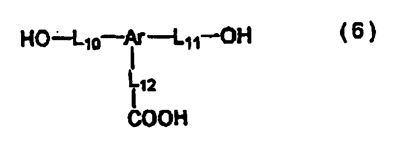

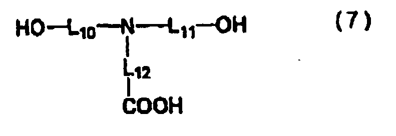

In the formulae, R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1 to 10 carbon atoms or an aralkyl group having from 7 to 15 carbon atoms)); and preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogeno group); preferably an alkylene group having from 1 to 20 carbon atoms or an arylene group having from 6 to 15 carbon atoms; and more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁₁, L₁₀, L₁₁ and L₁₂ may be taken together to form a ring. Ar represents a trivalent aromatic hydrocarbon group which may have substituent, and preferably an aromatic group having from 6 to 15 carbon atoms.

Specific examples of the diol compound having a carboxy group represented by formula (5), (6) or (7) include the following compounds.

Specifically, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionamide are exemplified.

Preferable examples of the tetracarboxylic acid dihydrate, which is used in the preparation of the diol compound having at least one carboxy group, include compounds represented by formulae (8), (9) and (10) shown below.

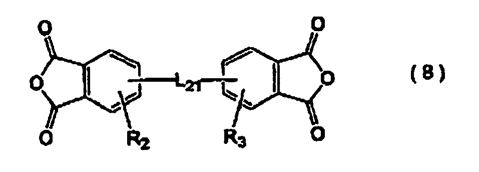

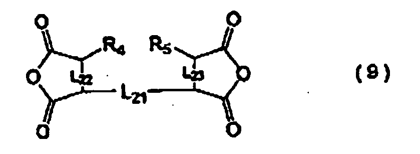

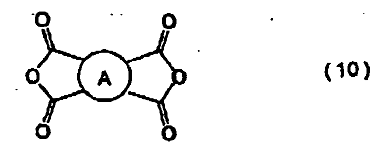

In the formulae, L₂₁ represents a single bond, a divalent aliphatic or aromatic hydrocarbon group which may have a substituent (preferably, for example, an alkyl group, an aralkyl group, an aryl group, an alkoxy group, a halogeno group, an ester group or an amido group), -CO-, -SO-, -SO₂-, -O- or -s-; and preferably a single bond, a divalent aliphatic hydrocarbon group having from 1 to 15 carbon atoms, -CO-, -SO₂-, -O- or -s-R₂ and R₃, which may be the same or different, each represents a hydrogen atom, an alkyl group, an aralkyl group, an aryl group, an alkoxy group or a halogeno group; and preferably a hydrogen atom, an alkyl group having from 1 to 8 carbon atoms, an aryl group having from 6 to 15 carbon atoms, an alkoxy group having from 1 to 8 carbon atoms or a halogeno group. Alternatively, two of L₂₁, R₂ and R₃ may be combined with each other to form a ring. R₄ and R₅, which may be the same or different, each represents a hydrogen atom, an alkyl group, an aralkyl group, an aryl group or a halogeno group; and preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group; and preferably a single bond, a double bond or a methylene group. A represents a monocyclic or polycyclic aromatic ring; and preferably an aromatic ring having from 6 to 18 carbon atoms.

Specific examples of the compound represented by formula (8), (9) or (10) include the following compounds.

Specifically, an aromatic tetracarboxylic acid dihydride, for example, pyromellitic acid dihydride, 3,3',4,4'-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetracarboxylic acid dihydride, 4,4'-sulfonyldiphthalic acid dihydride, 2,2-bis(3,4-dicarboxyphenyl)propane dihydride, bis(3,4-dicarboxyphenyl)ether dihydride, 4,4'-[3,3'(alkylphosphoryldiphenylene)-bis(iminocarbonyl)] diphthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohexene-1,2-dicarboxylic acid dihydride (Epicron B-4400, produced by Dainippon Ink and Chemicals, Inc.), 1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxy group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:
a) Method wherein an alcohol-terminated compound obtained by ring-opening of the tetracarboxylic acid dianhydride with a diol compound is reacted with the diisocyanate compound; and
b) Method wherein an alcohol-terminated urethane compound obtained by reacting the diisocyanate compound under excess of the diol compound is reacted with the tetracarboxylic acid dianhydride.

Of the diol compounds having at least one carboxylic group, the compounds represented by formula (5) are more preferable because of high solvent solubility and ease of synthesis. The diol compound having at least one carboxylic group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, and most preferably from 0.6 to 1.2 meq/g, of the carboxy group. Therefore, although the content of the structure derived from the diol compounds having at least one carboxylic group in the polyurethane resin binder can be appropriately determined after considering a number of the carboxyl group in the diol compound, other diol compound used in combination, an acid value or molecular weight of the resulting polyurethane resin binder, a composition or pH of developer and the like, it is, for example, ordinarily from 5 to 45% by mole, preferably from 10 to 40% by mole, and more preferably from 15 to 35% by mole.

### (iii) Diisocyanate Compound Having Crosslinkable Group

The diisocyanate compound having a crosslinkable group includes, for example, a reaction product obtained by an addition reaction of a triisocyanate compound with one equivalent of a monofunctional alcohol or monofunctional amine compound having a crosslinkable group.

Examples of the triisocyanate compound are set forth below, but the invention should not be construed as being limited thereto.

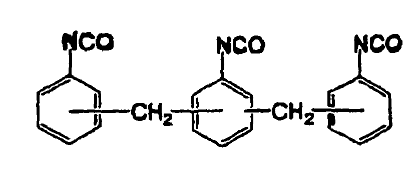

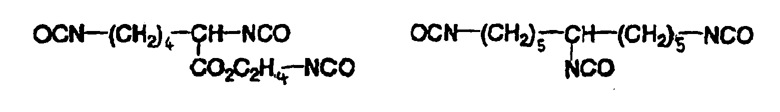

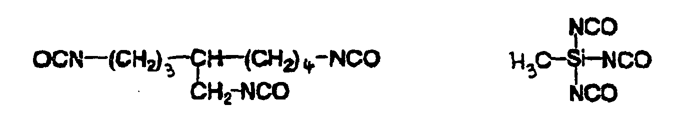

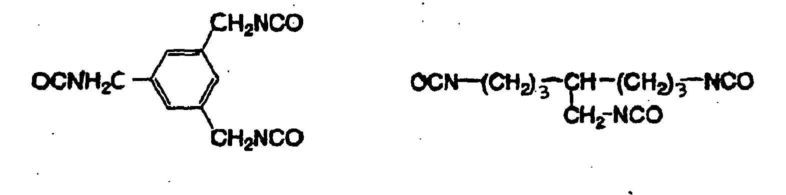

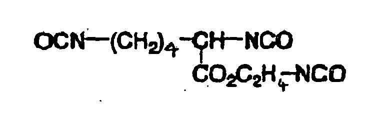

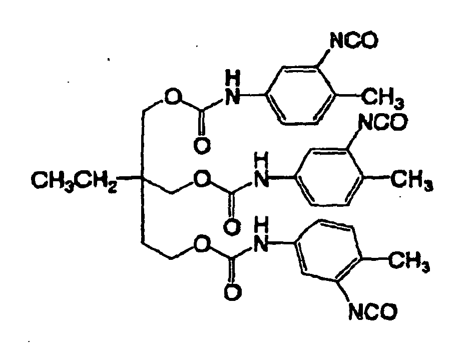

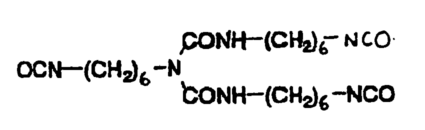

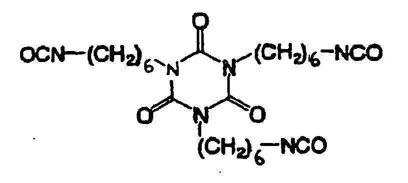

Examples of the monofunctional alcohol or monofunctional amine compound having a crosslinkable group are set forth below, but the invention should not be construed as being limited thereto.

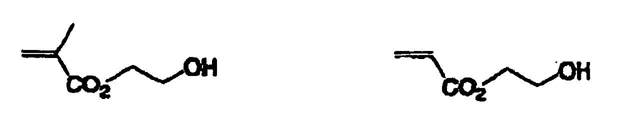

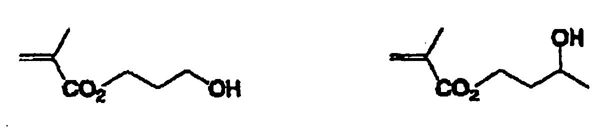

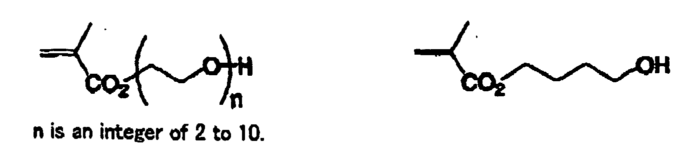

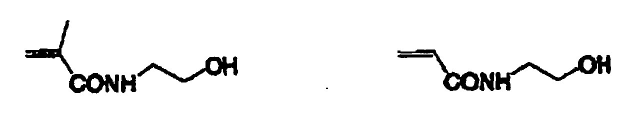

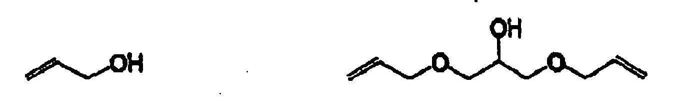

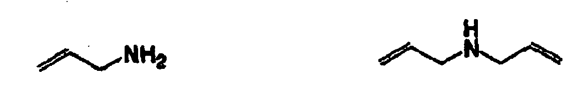

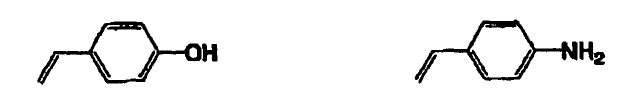

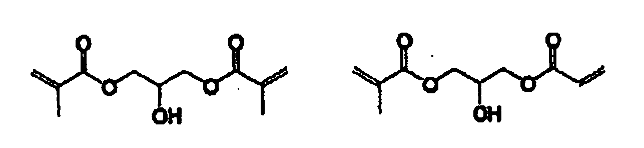

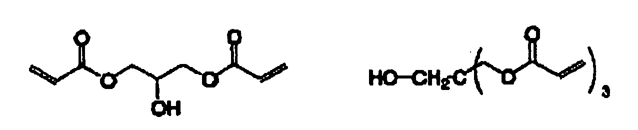

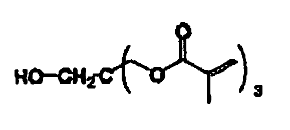

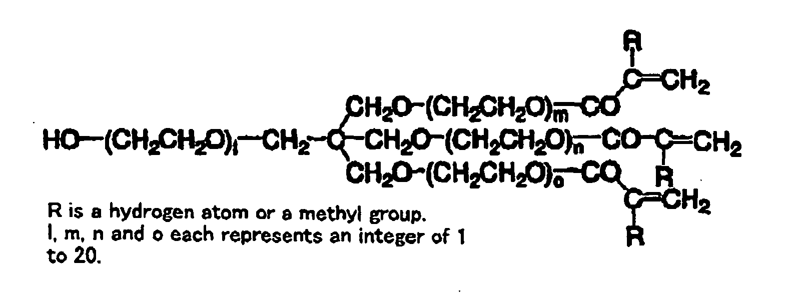

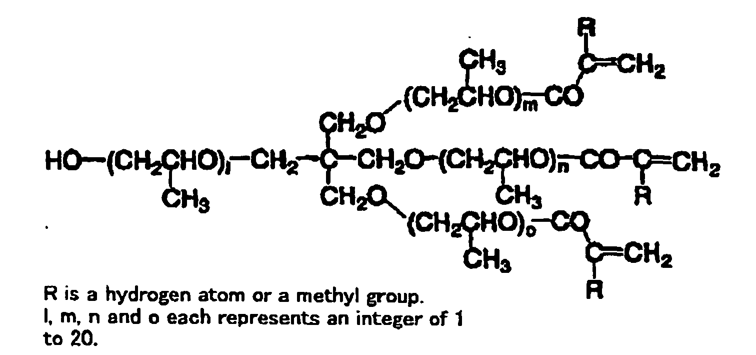

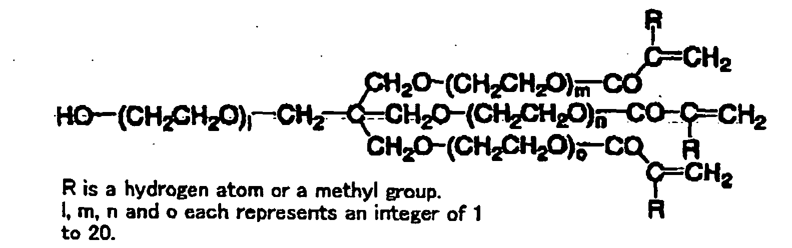

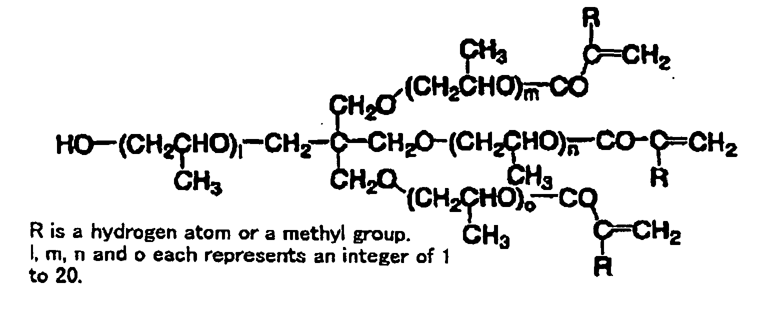

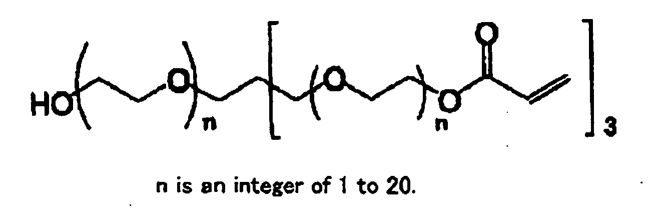

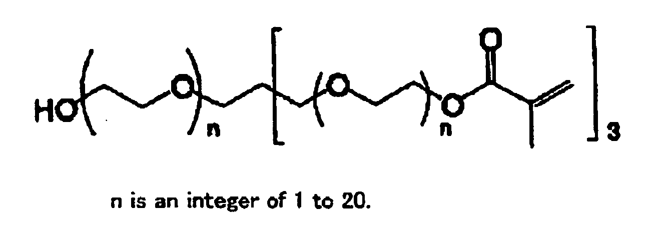

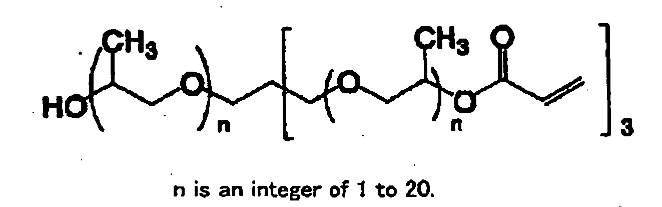

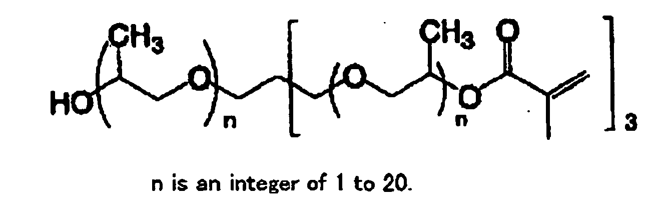

In order to introduce a crosslinkable group into the side chain of the polyurethane resin, a method of using as a raw material for the production of polyurethane resin, the diisocyanate compound having the crosslinkable group in the side chain is preferable. Specific examples of the diisocyanate compound having a crosslinkable group in the side chain obtained by an addition reaction of a triisocyanate compound with one equivalent of a monofunctional alcohol or monofunctional amine compound having the crosslinkable group are set forth below, but the invention should not be construed as being limited thereto.

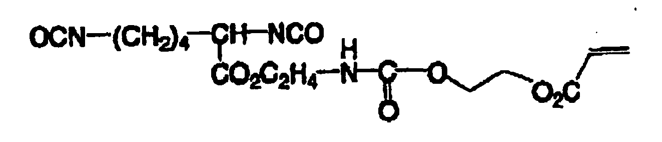

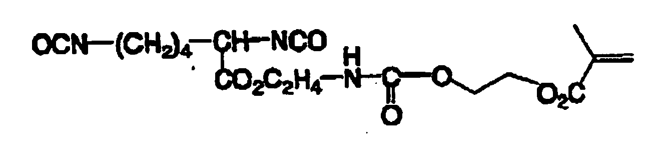

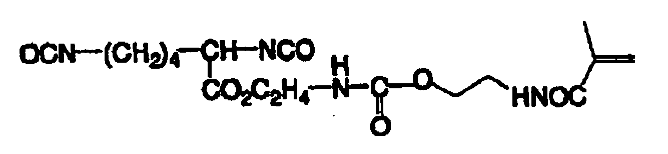

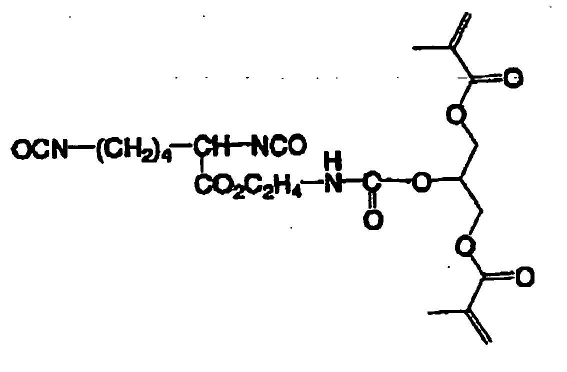

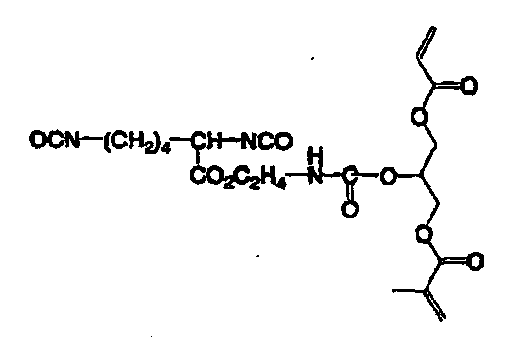

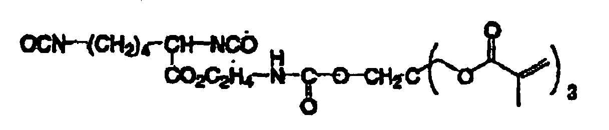

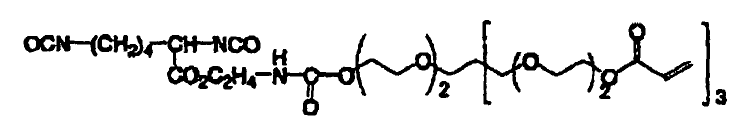

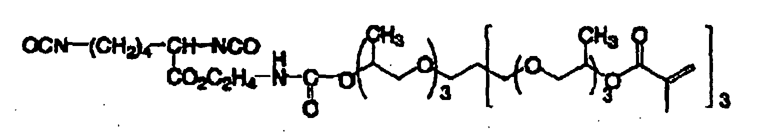

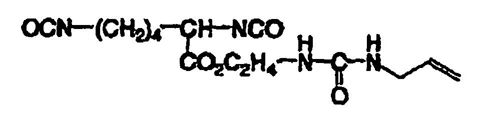

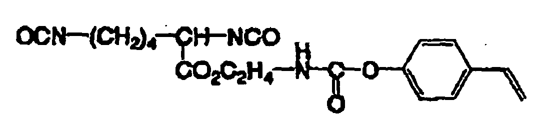

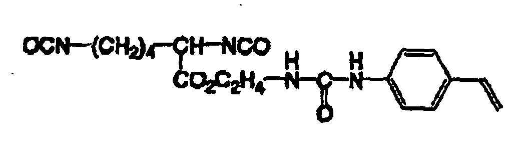

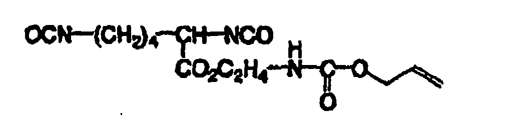

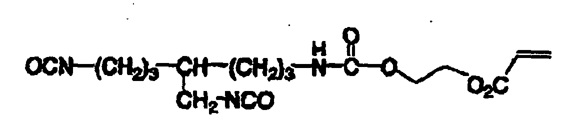

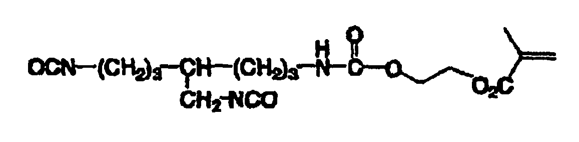

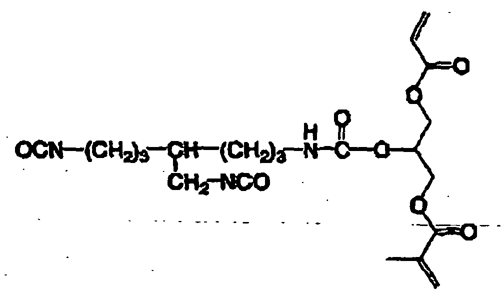

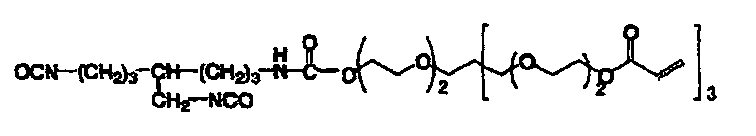

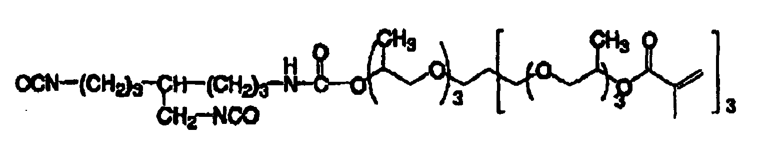

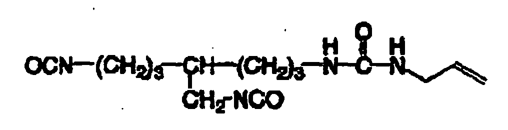

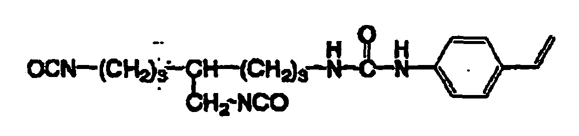

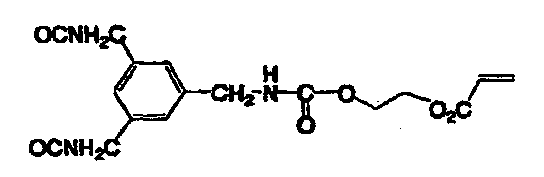

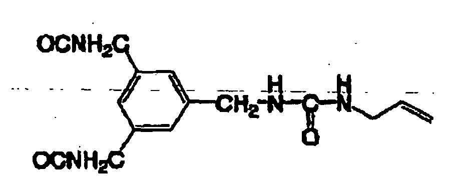

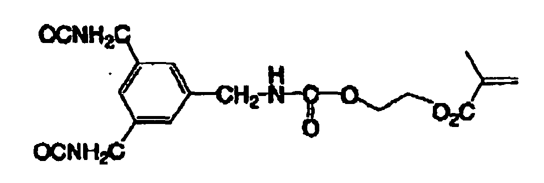

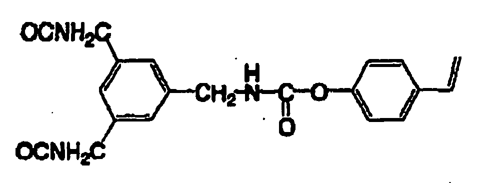

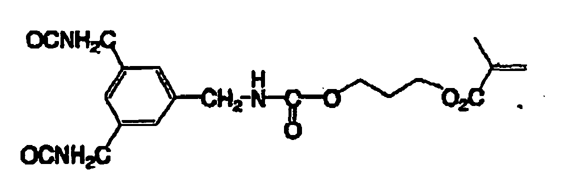

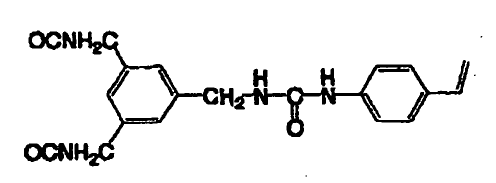

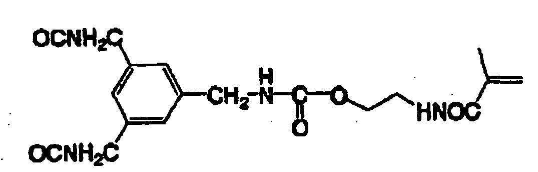

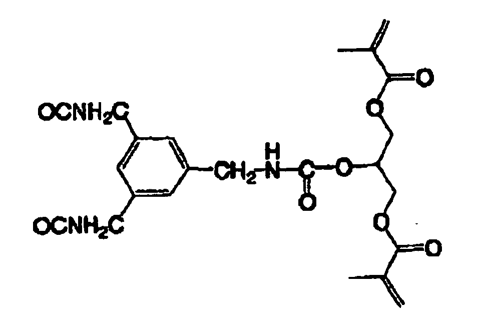

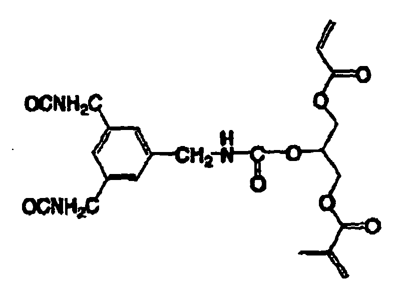

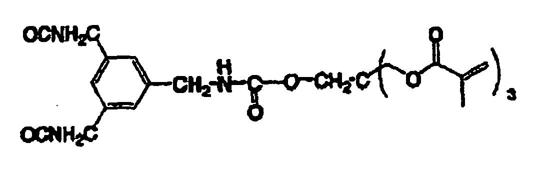

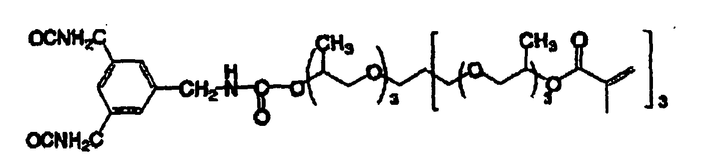

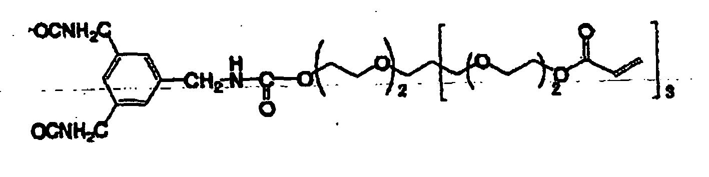

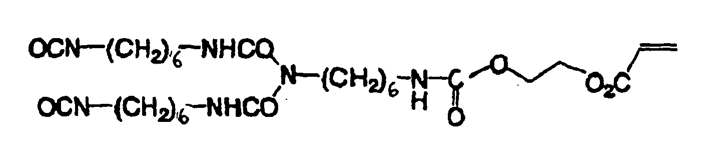

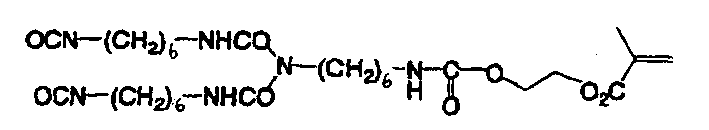

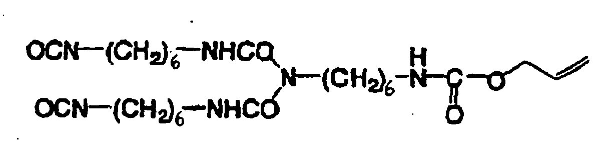

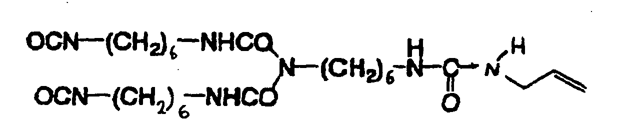

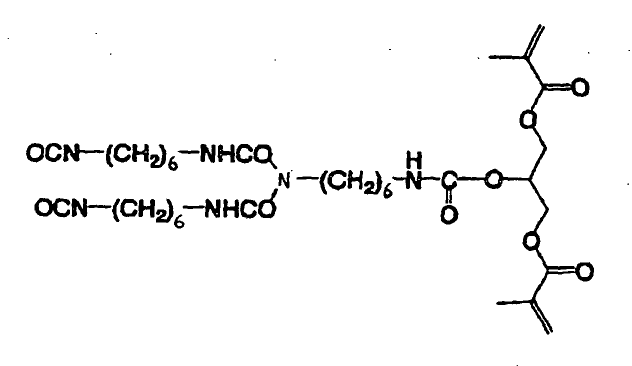

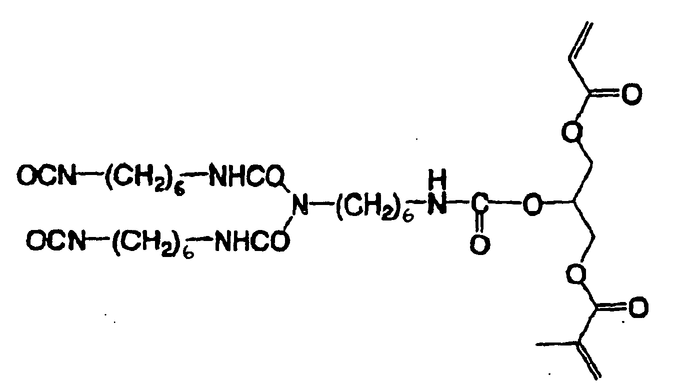

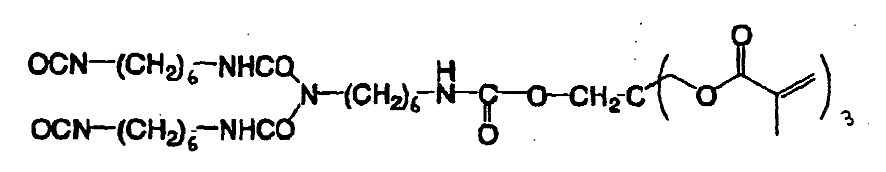

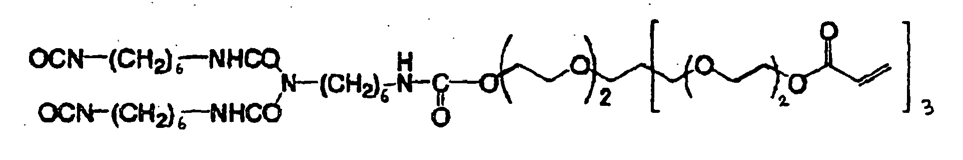

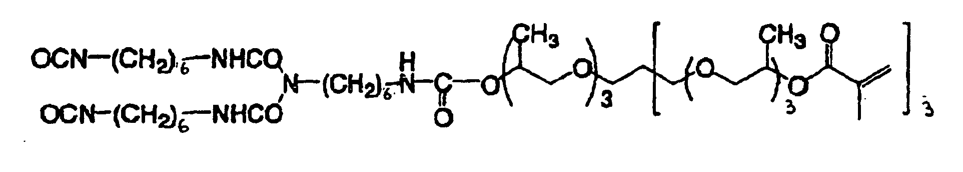

### (iv) Other Diol Compound

A method of using a diol compound having a crosslinkable group in the side chain as a raw material for the production of polyurethane resin is preferable as well as the method described above for the purpose of introducing the crosslinkable group into the side chain of the polyurethane resin. Such a diol compound may be a commercially available compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound having a crosslinkable group. Specific examples of the diol compound having a crosslinkable group are set forth below, but the invention should not be construed as being limited thereto.

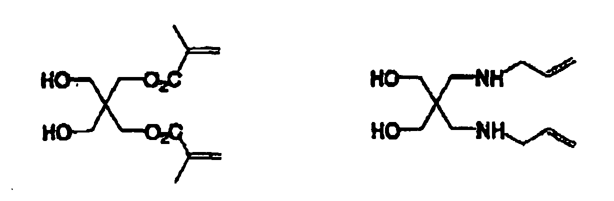

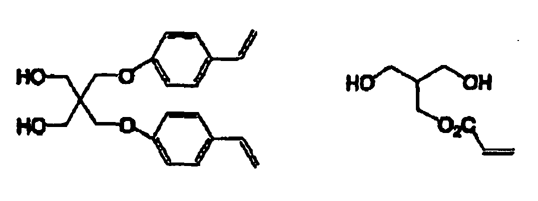

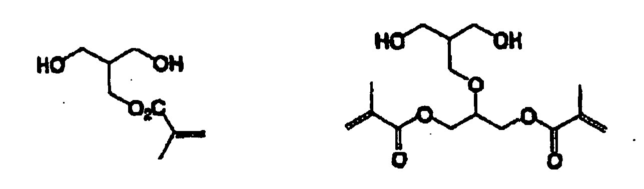

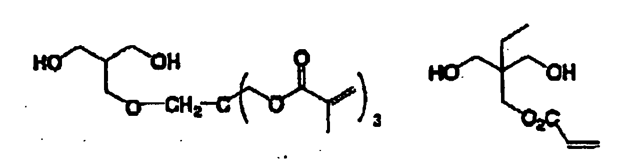

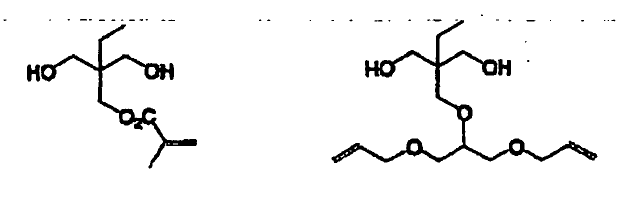

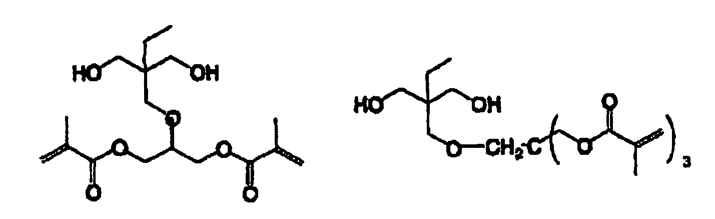

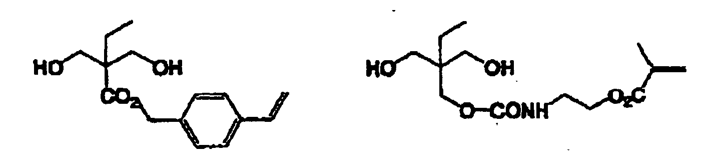

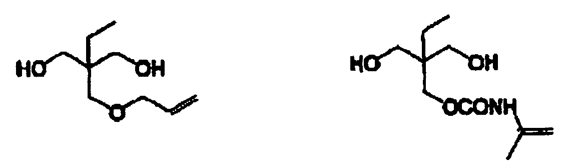

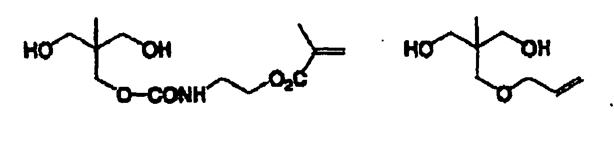

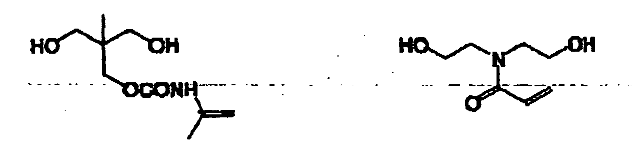

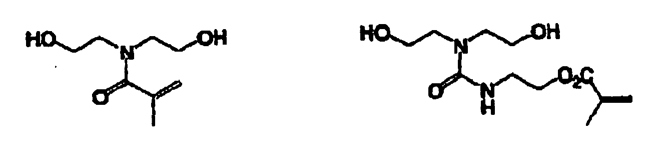

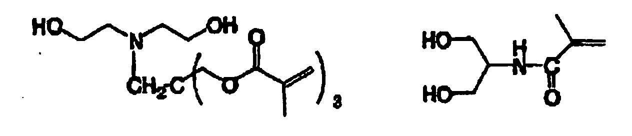

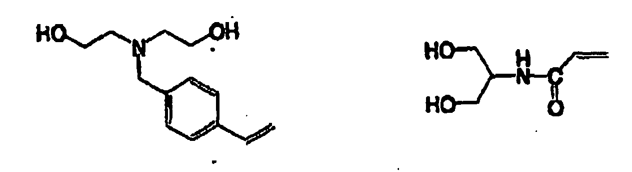

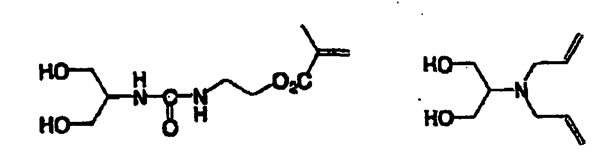

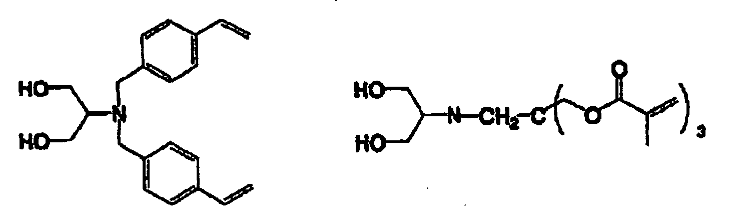

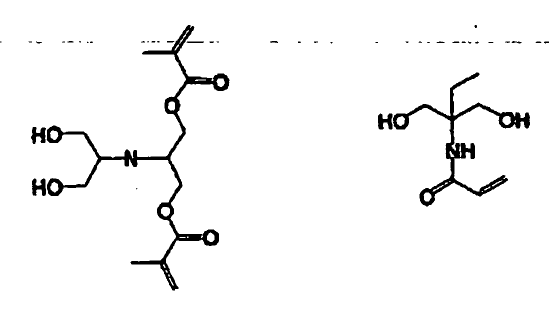

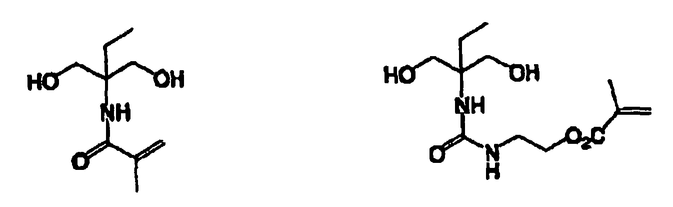

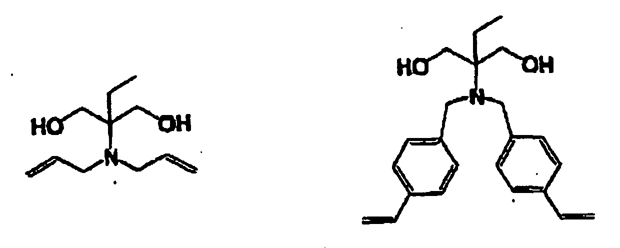

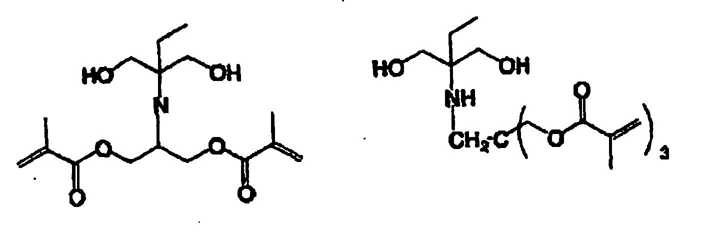

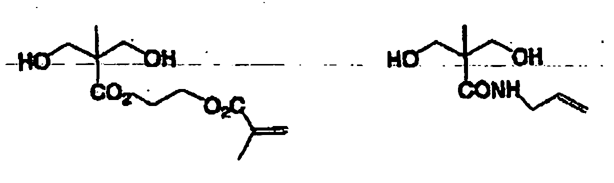

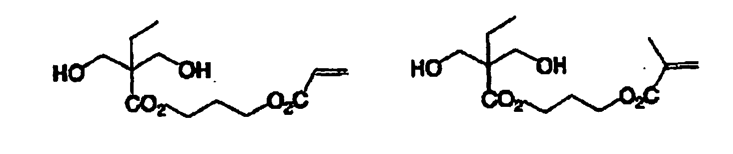

Another examples of the other diol compound include ethylene glycol compounds represented by the following formula (A'):

HO-(CH₂CH₂O)ₙ-H (A')

In the formula, n represents an integer of 1 or more.

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferable in view of the stain resistance. The ethylene glycol compounds represented by formula (A') wherein n is form 2 to 50 are more preferable, those wherein n is form 3 to 30 are still more preferable, and those wherein n is form 4 to 10 are particularly preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2,000, polypropylene glycol having an average molecular weight of 3,000, polypropylene glycol having an average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct ofbisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by the following formulae (a), (b), (c), (d) and (e) are preferably used.

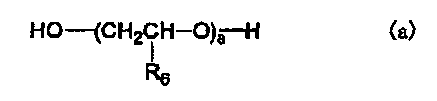

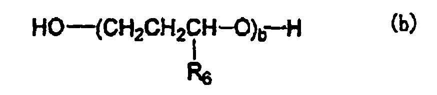

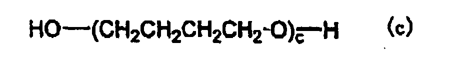

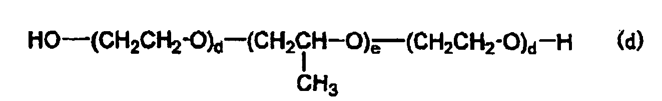

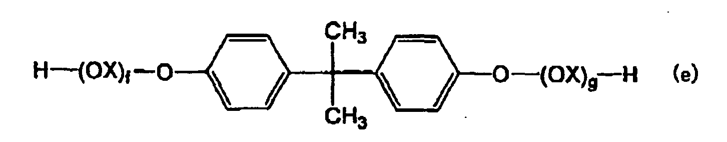

In the formulae, R₆ represents a hydrogen atom or a methyl group, provided that R₆ in formula (A) represents a methyl group. X represents a group shown below. 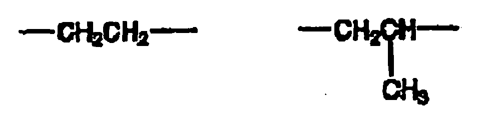 a, b, c, d, e, f and g each represents an integer of 2 or more, and preferably an integer of 2 to 100.

Polyester diol compounds represented by formulae (11) and (12) shown below are also enumerated as specific examples.

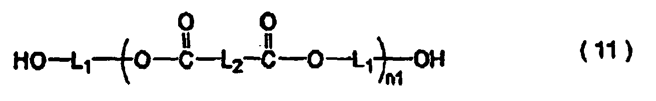

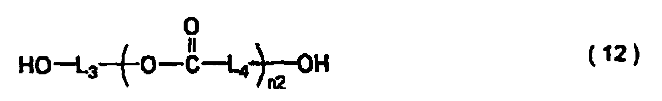

In the formulae, L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n1 and n2 each represents an integer of 2 or more, and preferably an integer of 2 to 100.

Polycarbonate diol compounds represented by formula (13) shown below are also enumerated as specific examples.

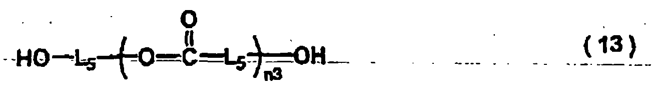

In the formula, L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 represents an integer of 2 or more, and preferably an integer of 2 to 100.

Specific examples of the diol compound represented by formula (11), (12) or (13) include those shown below. In the specific examples, n represents an integer of 2 or more.

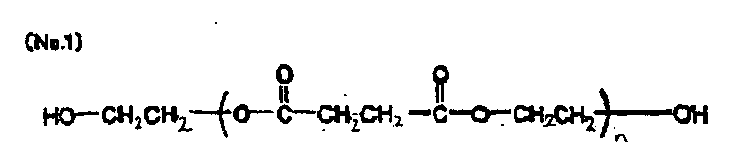

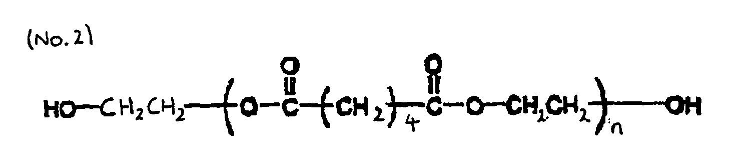

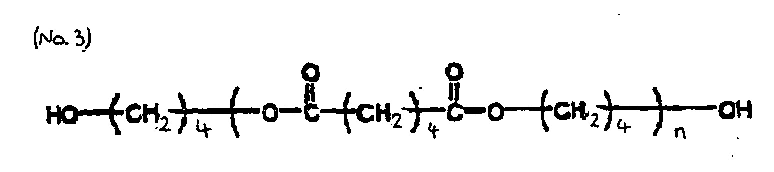

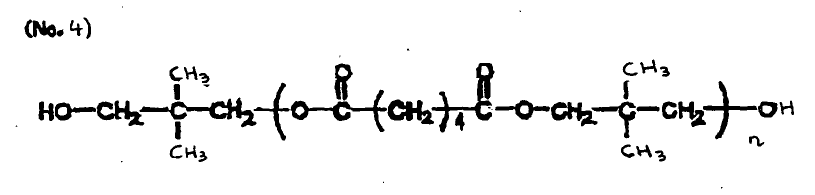

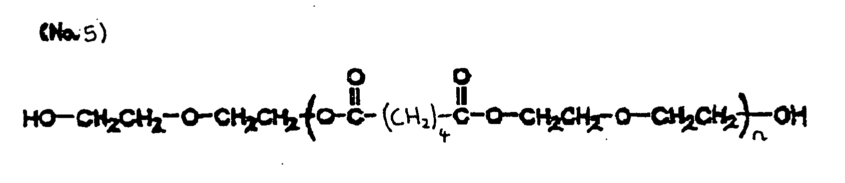

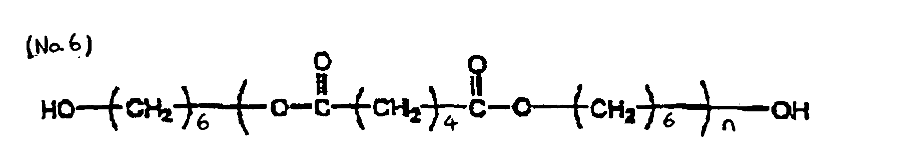

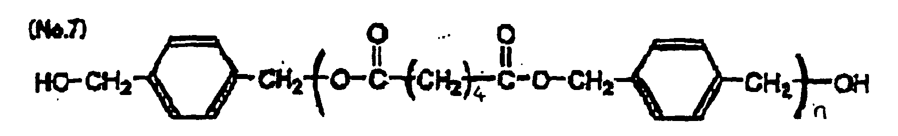

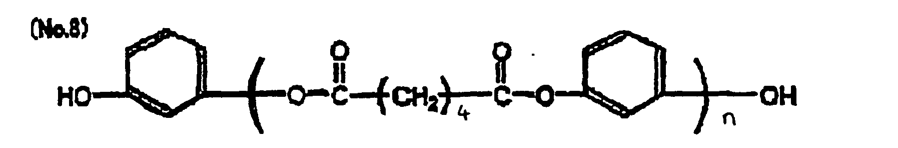

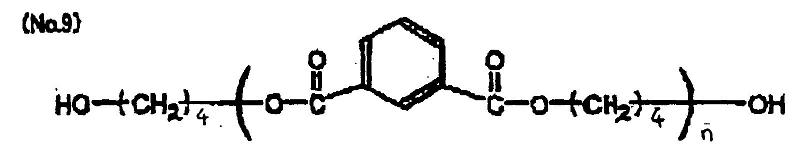

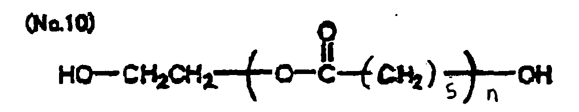

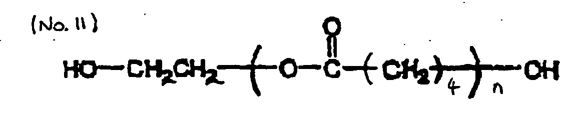

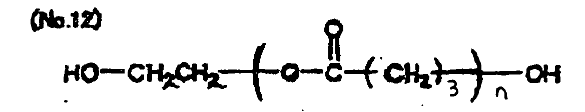

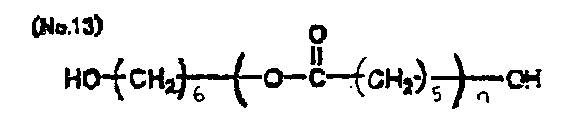

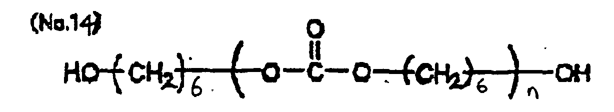

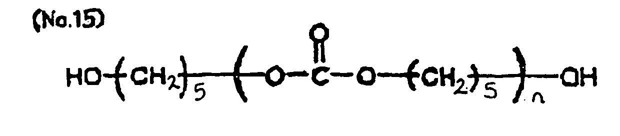

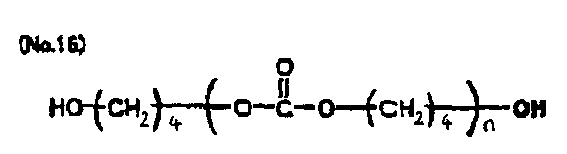

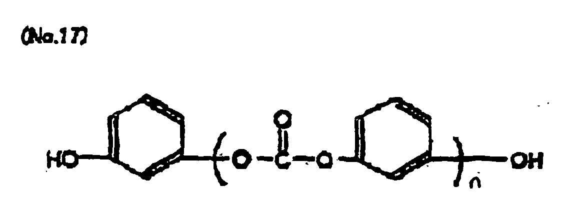

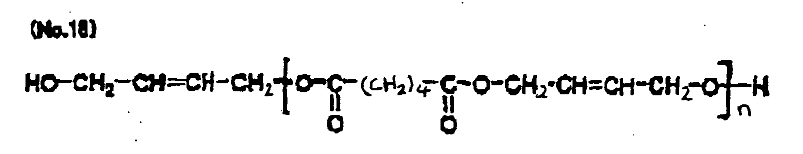

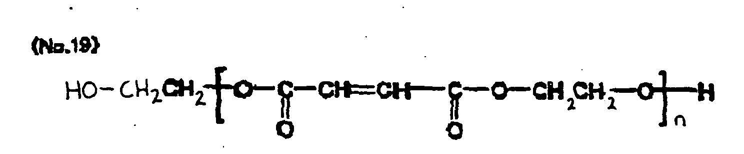

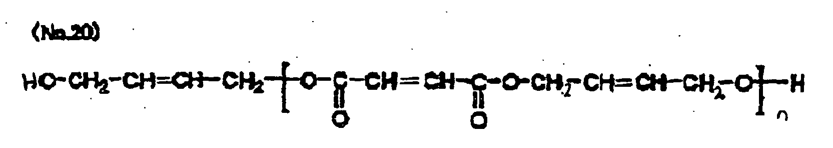

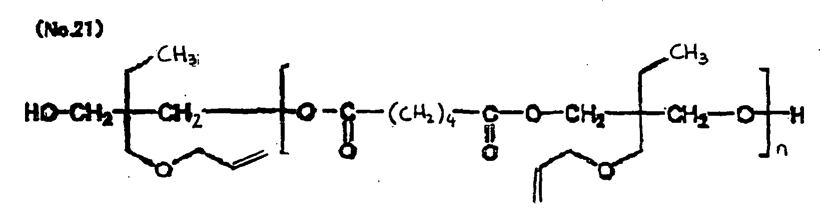

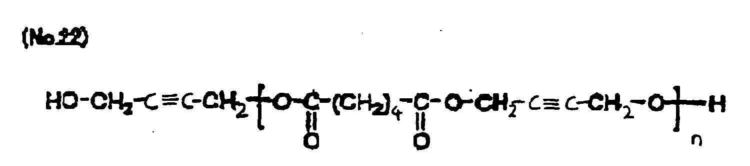

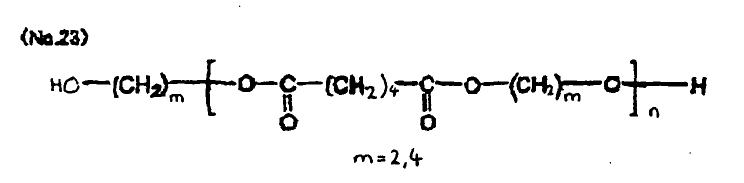

Moreover, a diol compound that does not have a carboxy group and that may have other functional group which does not react with the isocyanate group may be used.

Examples of such a diol compound include those represented by formulae (14) and (15) shown below.

HO-L₆-O-CO-L₇-CO-O-L₆-OH (14)

HO-L₇-CO-O-L₆-OH (15)

In the formulae, L₆ and L₇, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₆ and L₇ each may have other functional group which does not react with the isocyanate group, for example, a carbonyl group, an ester group, a urethane group, an amido group or a ureido group, if desired. Alternatively, L₆ and L₇ may be combined with each other to form a ring.

Specific examples of the diol compound represented by formula (14) or (15) include those shown below. 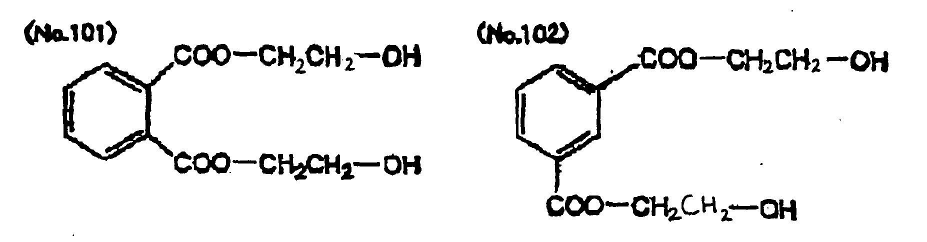 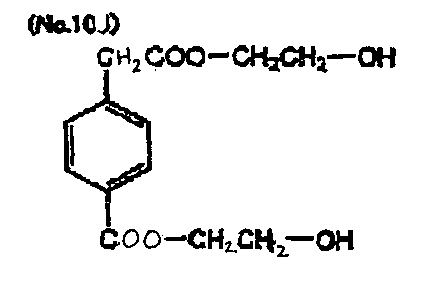 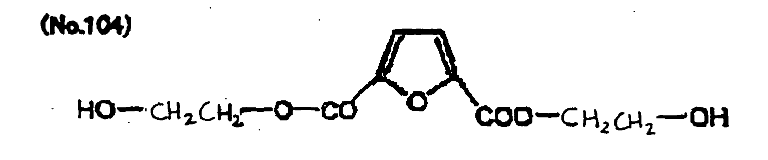
(No.105)
   HO-CH₂CH₂-O-CO-CH=CH-COO-CH₂CH₂-OH
(No.106)
   HO-CH₂ CH₂-O-COC₁₁H₂₂COO-CH₂CH₂-OH
(No.107)
   HO-CH₂CH₂-O-COC₁₂H₂₄COO-CH₂CH₂-OH
(No.108)
   HO-CH₂CH₂-O-COC₁₄H₂₈COO-CH₂CH₂-OH 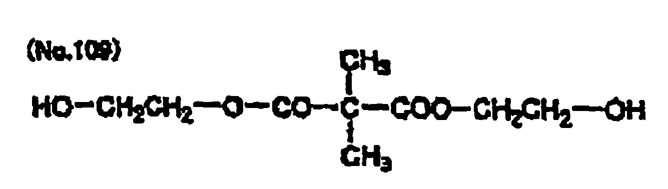
(No.110)
   HO-CH₂CH₂-O-CO-C=COO-CH₂CH₂-OH 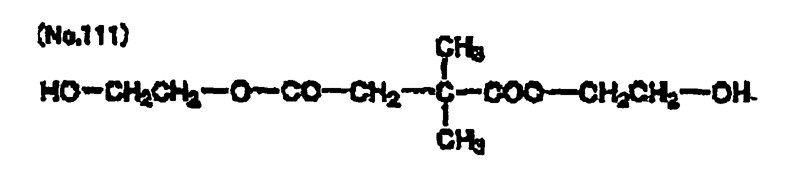 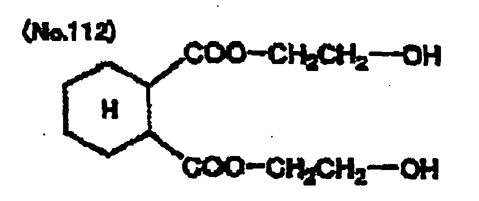
(No.113)
   HO-CH₂CH₂-O-CO-CH₂-O-CH₂-COO-CH₂CH₂-OH 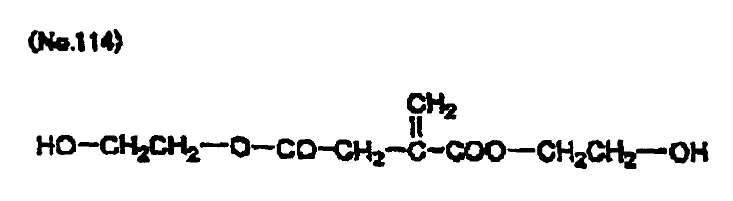 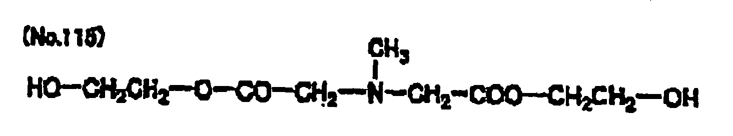 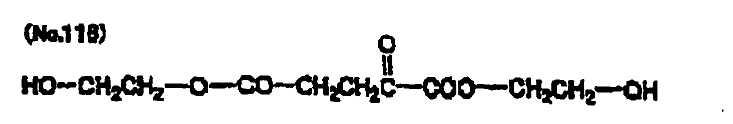 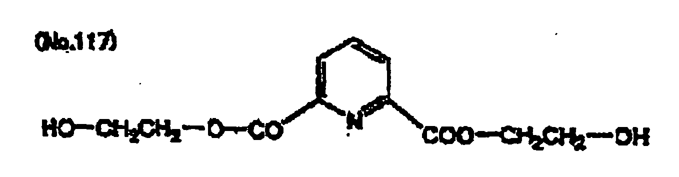 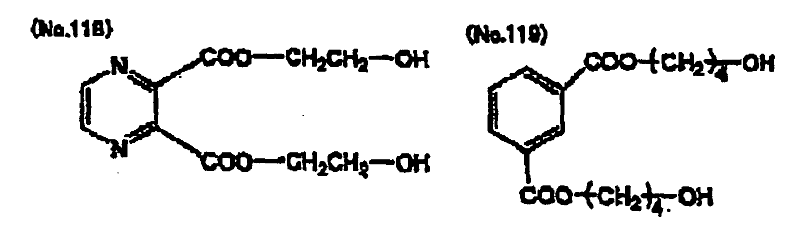 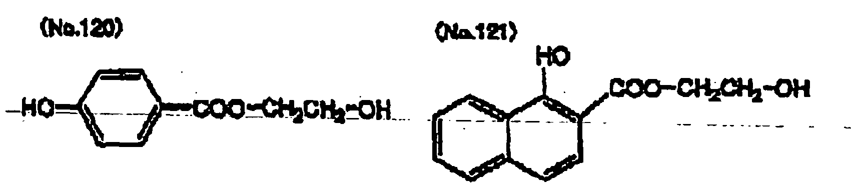 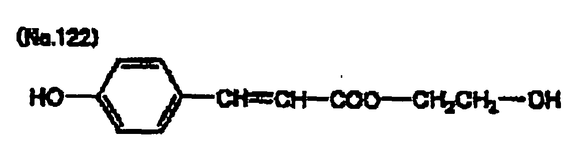
(No.123)
   HO-CH₂CH₂-COO-CH₂CH₂-OH

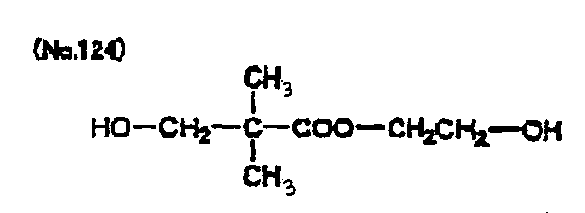

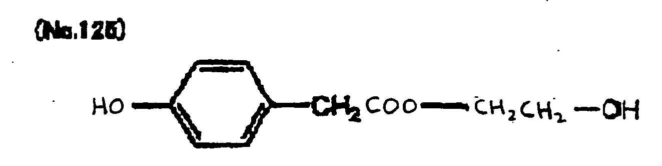

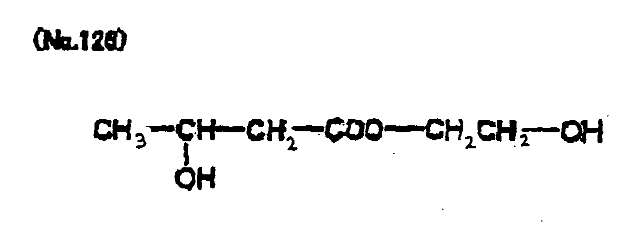

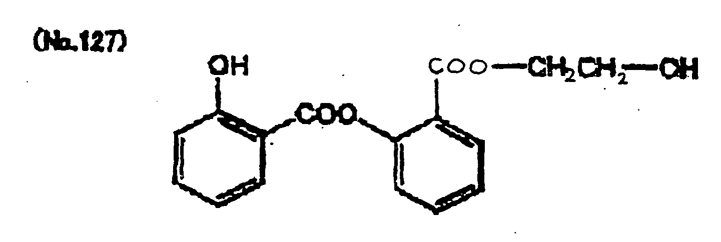

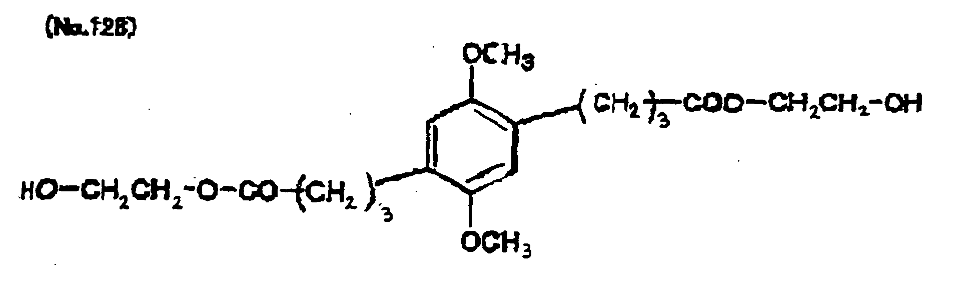

Moreover, diol compounds shown below are also preferably used.

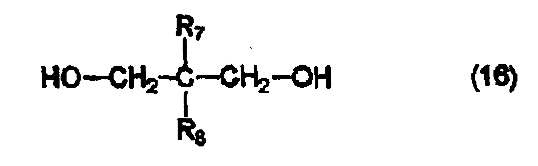

HO-CH₂-C≡C-CH₂-OH (17)

HO-CH₂-CH=CH-CH₂-OH (18)

In the formulae, R₇ and R₈, which may be the same or different, each represents an alkyl group which may have a substituent, preferably an alkyl group having from 1 to 10 carbon atoms which may have a substituent (for example, a cyano group, a nitro group, a halogen atom (e.g., -F, -Cl, -Br or -I), -CONH₂, -COOR or -OR (wherein R, which may be the same or different, each represents an alkyl group having from 1 to 10 carbon atoms, an aryl group having from 7 to 15 carbon atoms or an aralkyl group)).

Specific examples of the diol compound represented by formula (16) include those shown below.

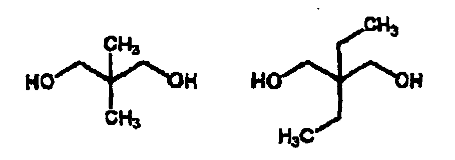

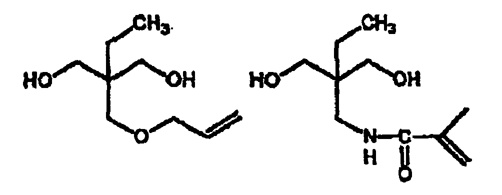

Example of the diol compound represented by formula (17) includes 2-butyne-1,4-diol. Examples of the diol compound represented by formula (18) include cis-2-butene-1,4-diol and trans-2-butene-1,4-diol.

Furthermore, diol compounds represented by formulae (19) and (20) shown below are also preferably used.

HO-L₈-NH-CO-L₉-CO-NH-L₈-OH (19)

HO-L₉-CO-NH-L₈-OH (20)

In the formulae, L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₈ and L₉ each may have other functional group which does not react with the isocyanate group, for example, a carbonyl group, an ester group, a urethane group, an amido group or a ureido group, if desired. Alternatively, L₈ and L₉ may be combined with each other to form a ring.

Specific examples of the diol compound represented by formula (19) or (20) include those shown below. 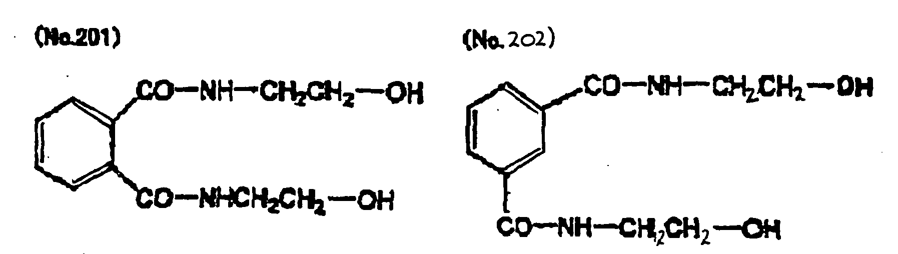
(No.203)
   HO-CH₂CH₂-NH-CO-CH=CH-CO-NH-CH₂CH₂-OH
(No.204)
   HO-CH₂CH₂-NH-CO-C≡CO-NH-CH₂CH₂-OH 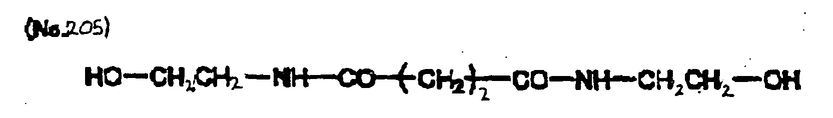 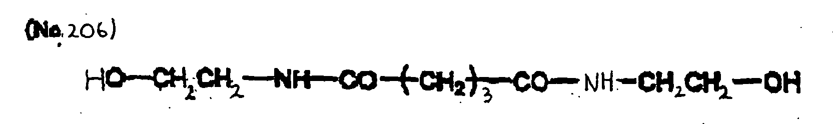 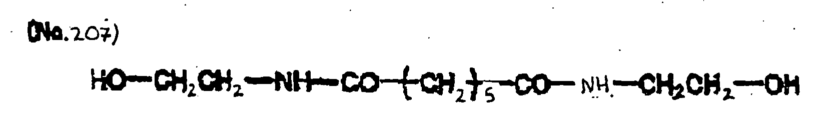 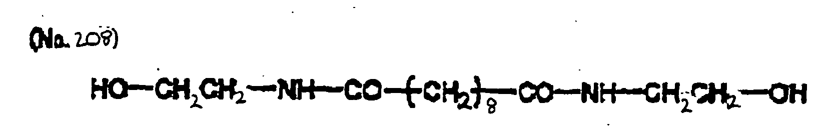 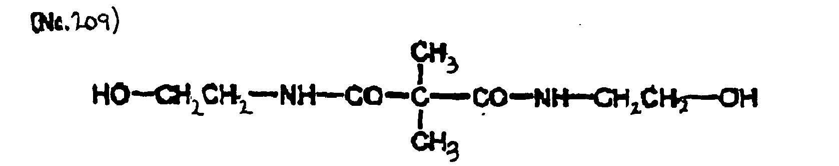 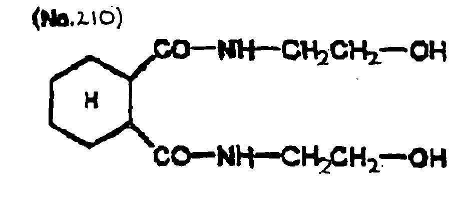 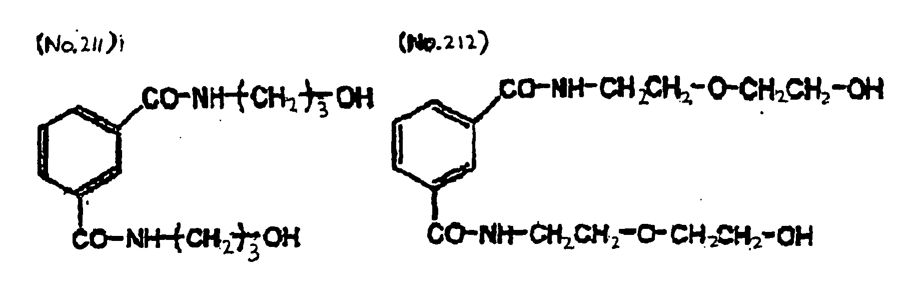 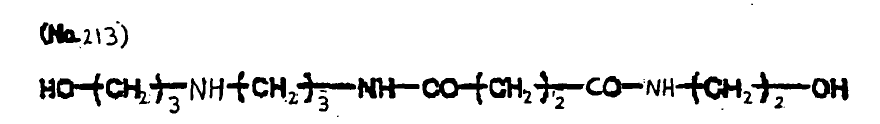 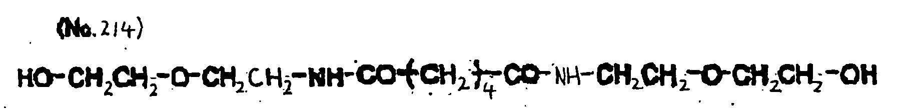
(No.215)
   HO-CH₂CH₂-NH-CO-CH₂-O-CH₂-CO-NH-CH₂CH₂-OH 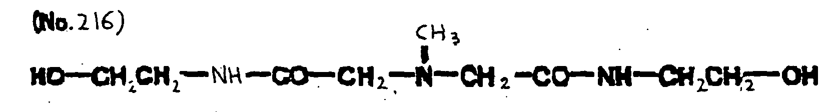 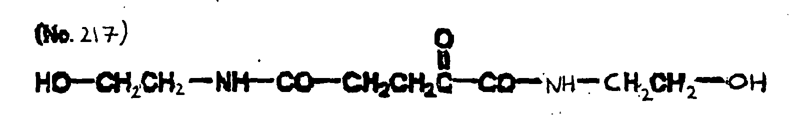
(No.218)
   HO-CH₂CH₂-NH-CO-CH₂-S-CH₂-CO-NH-CH₂CH₂-CO-NH-CH₂CH₂-OH

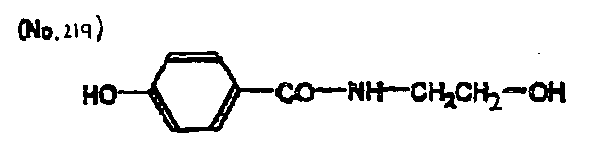

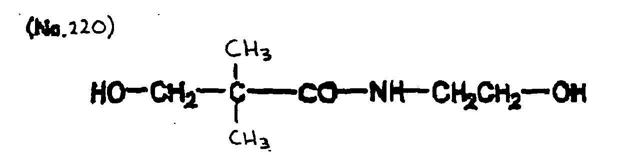

Furthermore, diol compounds represented by formulae (21) and (22) shown below are also preferably used.

HO-Ar₂-(L₁₆-Ar₃)ₙ-OH (21)

HO-Ar₂-L₁₆-OH (22)

In the formulae, L₁₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms, n represents an integer of 0 to 10.

Specific examples of the diol compound represented by formula (21) or (22) include those shown below.

Specifically, catechol, resorcine, hydroquinone, 4-methylcatechol, 4-tert-butylcatechol, 4-acetylcatechol, 3-methoxycatechol, 4-phenylcatechol, 4-methylresorcine, 4-ethylresorcine, 4-tert-butylresorcine, 4-hexylresorcine, 4-chlororesorcine, 4-benzylresorcine, 4-acetylresorcine, 4-carboxymethoxyresorcine, 2-methylresorcine,5-methylresorcine, tert-butylhydroquinone, 2,5-di-tert-butylhydroquinone, 2,5-di-tert-amylhydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydroxybezyl alcohol, 2-hydroxy-3,5-di-tert-butylbezyl alcohol, 4-hydroxy-3,5-di-tert-butylbezyl alcohol, 4-hydroxyphenethyl alcohol, 2-hydroxyethyl-4-hydroxybenzoate, 2-hydroxyethyl-4-hydroxyphenylacetate and resorcine mono-2-hydroxyethyl ether are exemplified. Diol compounds shown below are also preferably used.

### (v) Other Amino Group-Containing Compound

In the polyurethane resin binder according to the invention, an amino group-containing compound represented by formula (31) or (32) shown below may be used together to react with the diisocyanate compound, thereby forming a urea structure to incorporate into the polyurethane resin.

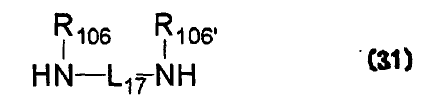

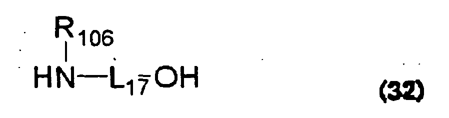

In the formulae, R₁₀₆ and R₁₀₆, which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxy group); and preferably a hydrogen atom, an alkyl group having from 1 to 8 carbon atoms or an aryl group having from 6 to 15 carbon atoms, each of which may have a carboxy group as a substituent. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group, a halogen atom (e.g., -F, -Cl, -Br or -I) or a carboxy group). L₁₇ may have other functional group which does not react with the isocyanate group, for example, a carbonyl group, an ester group, a urethane group or an amido group, if desired. Alternatively, two of R₁₀₆, L₁₇ and R₁₀₆ may be combined with each other to form a ring.

Specific examples of the compound represented by formula (31) or (32) include the following compounds.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine or isophorondiamine); aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptophan or adenine; and aminoalcohol or aminophenol compounds, for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are enumerated.

A polyurethane resin obtained by introducing a crosslinkable group into polyurethane having a carboxy group by a polymer reaction as described in JP-A-2003-270775 may also be used as the polymer binder according to the invention as well as the above-described polyurethane resin obtained by introducing a crosslinkable group into a side chain at the synthesis of polyurethane.

A molecular weight of the polymer binder used in the invention is appropriately determined in view of the image-forming property and printing durability. The molecular weight is preferably in a range from 2,000 to 1,000,000, more preferably from 5,000 to 500,000, and still more preferably from 10,000 to 200,000.

The polymer binders may be used individually or in combination of two or more thereof in the invention. Further, the polymer binder according to the invention may be used together with one or more other binder polymers having no crosslinkable group. As the binder polymer used together, conventionally known alkali-soluble or alkali-swellable binders are employed without any limitation. Specifically, for example, acryl main chain binders and urethane binders conventionally used in the field of art can be preferably employed.

The total amount of the polymer binder and binder polymer which may be used together in the photosensitive layer can be appropriately determined. It is, however, ordinarily in a range from 10 to 90% by weight, preferably from 20 to 80% by weight, and more preferably from 30 to 70% by weight, based on the total weight of the nonvolatile components in the photosensitive layer.

### (E) Chain Transfer Agent

It is preferred that the photosensitive layer according to the invention contains a chain transfer agent. The chain transfer agent contributes to improvements in the sensitivity and preservation stability. Compounds which function as the chain transfer agents include, for example, compounds containing SH, PH, SiH or GeH in their molecules. Such a compound donates hydrogen to a radical species of low activity to generate a radical, or is oxidized and then deprotonated to generate a radical.

In the photosensitive layer according to the invention, a thiol compound (for example, a 2-mercaptobenzimidazole) is particularly preferably used as the chain transfer agent.

Among them, a thiol compound represented by formula (XI) shown below is particularly preferably used. By using the thiol compound represented by formula (XI) as the chain transfer agent, a problem of the odor and decrease in sensitivity due to evaporation of the compound from the photosensitive layer or diffusion thereof into other layers are avoided and a lithographic printing plate precursor which is excellent in preservation stability and exhibits high sensitivity and good printing durability is obtained.

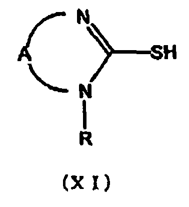

In formula (XI), R represents an alkyl group which may have a substituent or an aryl group which may have a substituent; and A represents an atomic group necessary for forming a 5-membered or 6-membered hetero ring containing a carbon atom together with the N=C-N linkage, and A may have a substituent.

Compounds represented by formulae (XII) and (XIII) shown below are more preferably used.

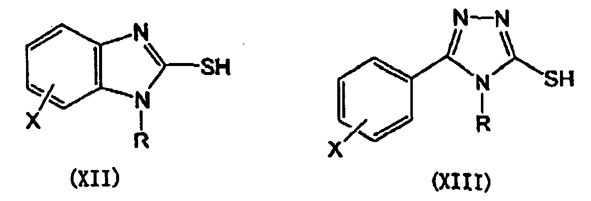

In formulae (XII) and (XIII), R represents an alkyl group which may have a substituent or an aryl group which may have a substituent; and X represents a halogen atom, an alkoxy group which may have a substituent, an alkyl group which may have a substituent or an aryl group which may have a substituent.

Specific examples of the compound represented by formula (XI) are set forth below, but the invention should not be construed as being limited thereto.

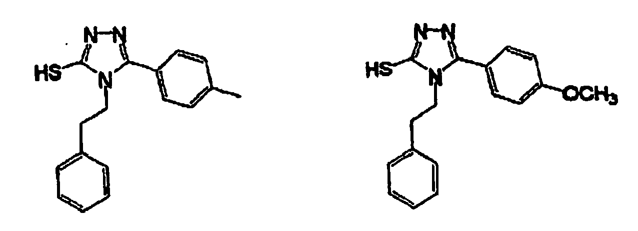

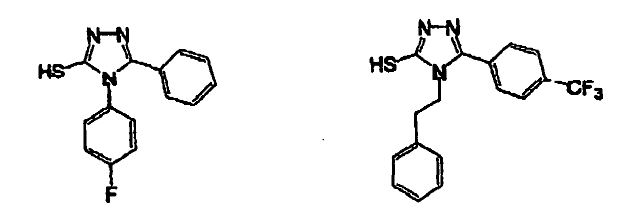

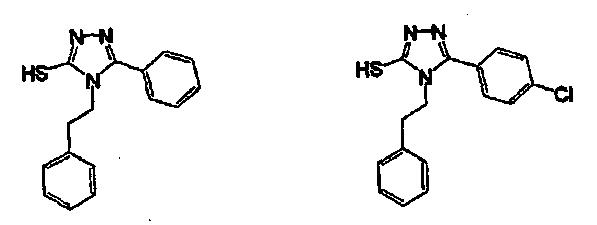

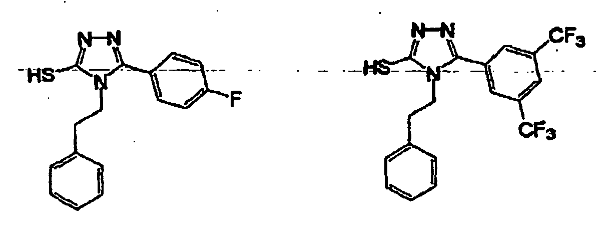

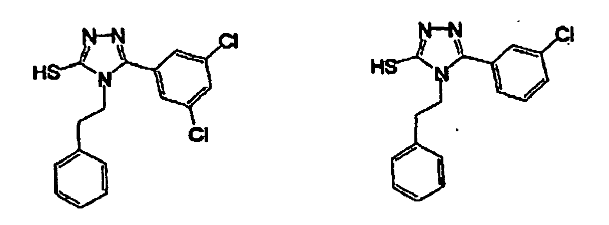

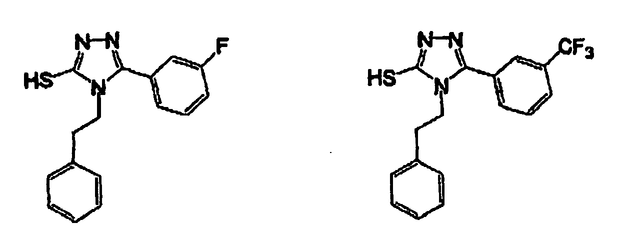

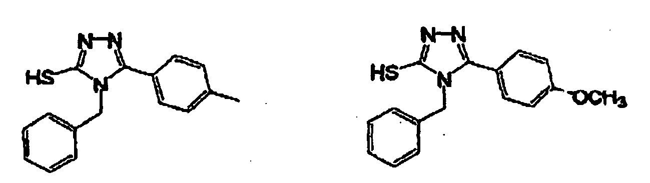

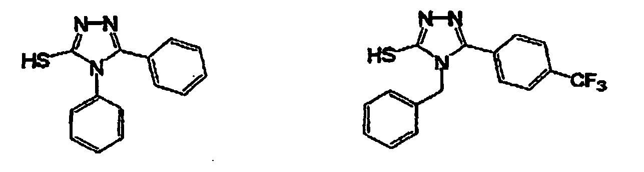

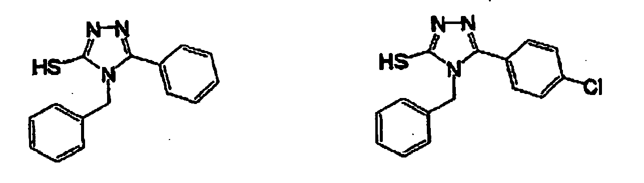

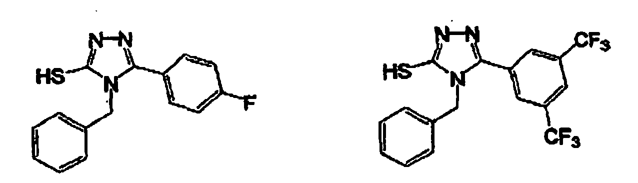

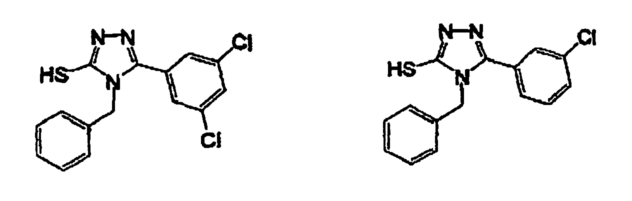

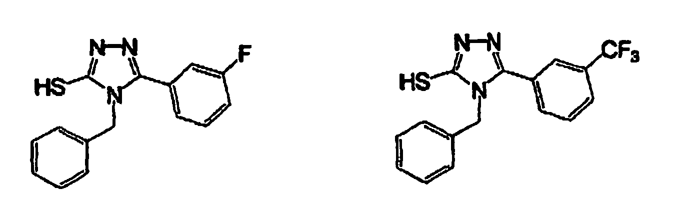

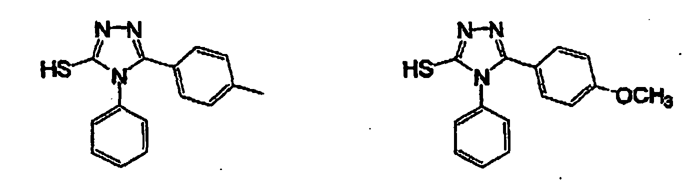

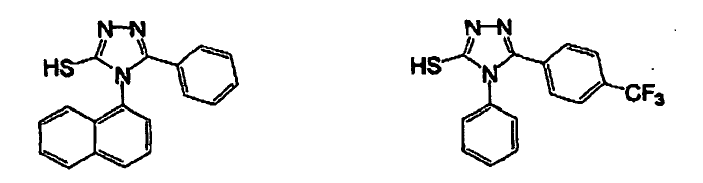

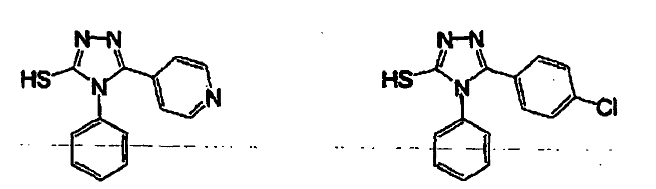

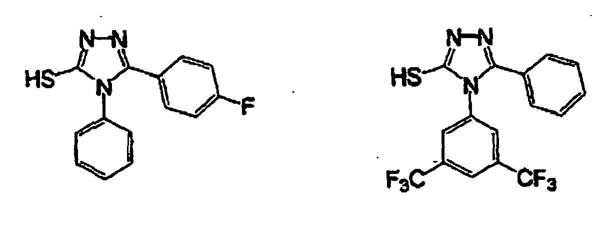

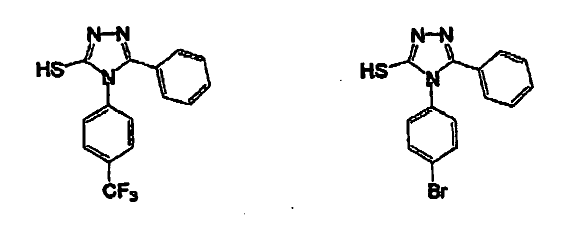

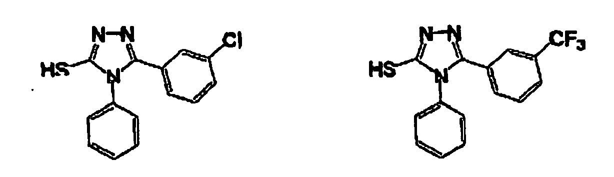

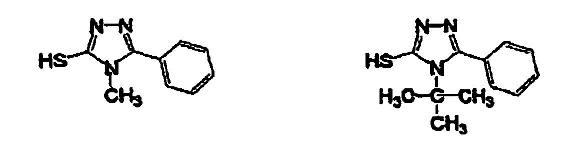

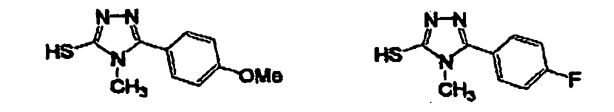

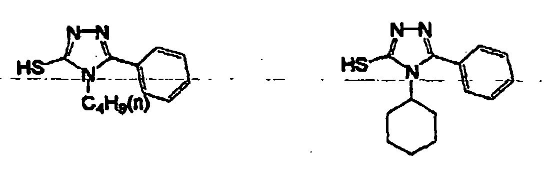

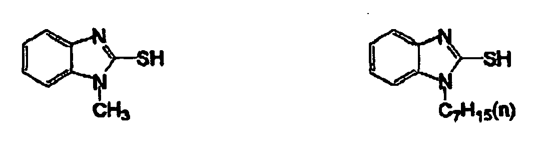

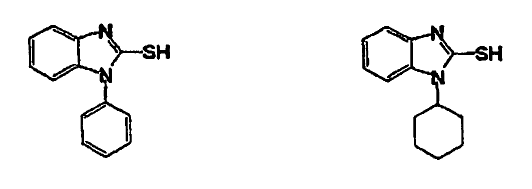

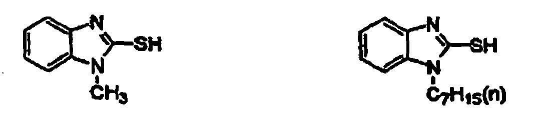

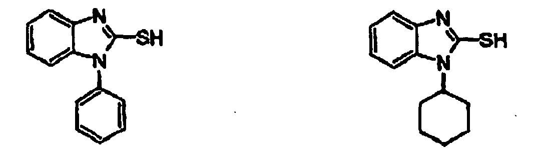

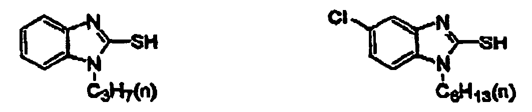

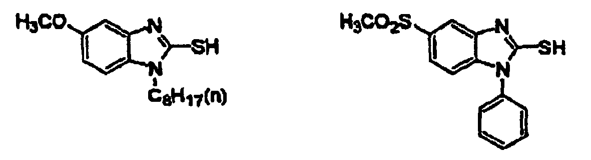

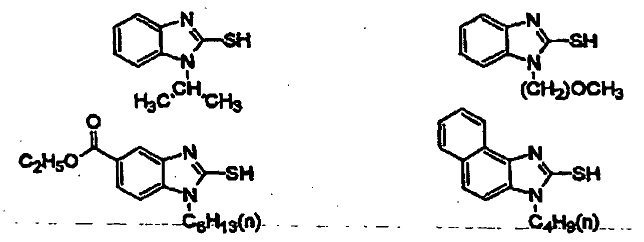

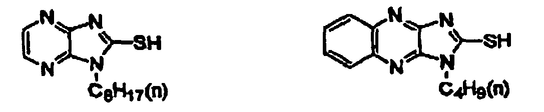

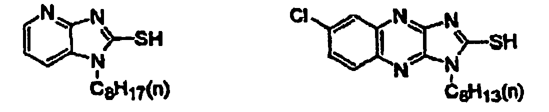

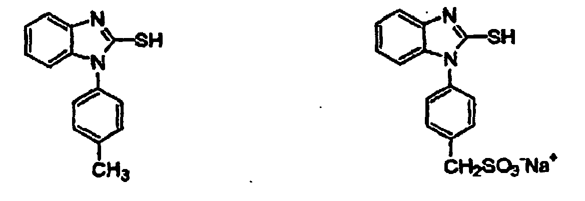

An amount of the chain transfer agent (for example, the thiol compound) used is preferably from 0.01 to 20% by weight, more preferably from 0.1 to 15% by weight, still more preferably from 1.0 to 10% by weight, based on the total solid content of the photosensitive layer.

### (F) Other Additives

It is preferred to add a small amount of a thermal polymerization inhibitor to the photosensitive layer, in order to prevent undesirable thermal polymerization in the photosensitive layer during the production or preservation of the lithographic printing plate precursor. Suitable examples of the thermal polymerization inhibitor include hydroquinone, p-methoxyphenol, di-tert-butyl-p-cresol, pyrogallol, tert-butylcatechol, benzoquinone, 4,4-thiobis(3-methyl-6-tert-butylphenol), 2,2'-methylenebis(4-methyl-6-tert-butylphenol), N-nitrosophenylhydroxyamine cerium(IIn salt and N-nitrosophenylhydroxylamine aluminum salt.

The amount of the thermal polymerization inhibitor added is preferably from about 0.01 to about 5% by weight, based on the total solid content of the photosensitive layer.

If desired, in order to avoid polymerization inhibition due to oxygen, a higher fatty acid derivative, for example, behenic acid or behenic amide may be added and allowed to localize on the photosensitive layer surface during the drying step after the coating thereof. The amount of the higher fatty acid derivative added is preferably from about 0.5 to about 10% by weight based on the total solid content of the photosensitive layer.

Further, for the purpose of coloring the photosensitive layer, a coloring agent may be added. Examples of the coloring agent include phthalocyanine pigments (for example, C.I. Pigment Blue 15:3, C.I. Pigment Blue 15:4 or C.I. Pigment Blue 15:6), azo pigments, pigments, for example, carbon black or titanium oxide, Ethyl Violet, Crystal Violet, azo dyes, anthraquinone dyes and cyanine dyes. The amount of the dye or pigment added is preferably from about 0.5 to about 20% by weight based on the total solid content of the photosensitive layer. In addition, for the purpose of improving physical properties of the cured film, an additive, for example, an inorganic filler or a plasticizer, for example, dioctyl phthalate, dimethyl phthalate or tricresyl phosphate may be added. The amount of the additive added is preferably 10% by weight or less based on the total solid content of the photosensitive layer.

### [Formation of Photosensitive Layer]

In the coating of the photosensitive layer, each of the components described above is dissolved in a solvent to prepare a coating solution. Examples of the solvent used include acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propyolene glycol monoethyl ether acetate, 3-methoxypropyl acetate, N,N-dimethylformamide, dimethylsulfoxide, γ-butyrolactone, methyl lactate and ethyl lactate. The solvents may be used individually or as a mixture thereof.

The concentration of the solid content in the coating solution is ordinarily from 1 to 50% by weight.

Further, in order to improve surface quality of the coating, a surfactant may be added to the coating solution.

The coverage of the photosensitive layer is ordinarily from about 0.1 to about 10 g/m², preferably from 0.3 to 5 g/m², and more preferably from 0.5 to 3 g/m², in terms of weight after drying.

### [Protective Layer]

In the lithographic printing plate precursor according to the invention, a protective layer (oxygen-block layer) is provided on the photosensitive layer in order to prevent diffusion and penetration of oxygen which hinders the polymerization reaction at the time of exposure. The protective layer for use in the invention preferably has oxygen permeability (A) at 25°C under 1 atmosphere of 1.0 ≤ A ≤ 20 (ml/m²·day). When the oxygen permeability (A) is extremely lower than 1.0 (ml/m²·day), problems may occur in that an undesirable polymerization reaction arises during the production or preservation before imagewise exposure and in that undesirable fog or spread of image line generates at the image exposure. On the contrary, when the oxygen permeability (A) greatly exceeds 20 (ml/m²·day), decrease in sensitivity may occur. The oxygen permeability (A) is more preferably in a range of 1.5 ≤ A ≤ 12 (ml/m²·day), and still more preferably in a range of 2.0 ≤ A ≤ 8.0 (ml/m²·day). Besides the above described oxygen permeability, as for the characteristics required of the protective layer, it is preferred that the protective layer does not substantially hinder the transmission of light for exposure, is excellent in adhesion to the photosensitive layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in fundamental characteristics, for example, oxygen-shielding property and removability of the protective layer by development.

Polyvinyl alcohol for use in the protective layer may be partially substituted with ester, ether or acetal as long as it contains unsubstituted vinyl alcohol units for achieving the necessary oxygen-blocking property and water solubility. Also, a part of polyvinyl alcohol may have other copolymer component. As specific examples of polyvinyl alcohol, those having a hydrolyzing rate of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (manufactured by Kuraray Co., Ltd.). They can be used individually or as a mixture. According to a preferred embodiment, the content of polyvinyl alcohol in the protective layer is from 20 to 95% by weight, more preferably from 30 to 90% by weight.

As a component used as a mixture with polyvinyl alcohol, polyvinyl pyrrolidone or a modified product thereof is preferred from the viewpoint of the oxygen-blocking property and removability by development. The content thereof is ordinarily from 3.5 to 80% by weight, preferably from 10 to 60% by weight, more preferably from 15 to 30% by weight.

The components of the protective layer (the selection of PVA and the use of additives) and the coating amount are selected taking into consideration fogging characteristic, adhesion and scratch resistance besides the oxygen-blocking property and removability by development. In general, the higher the hydrolyzing rate of the PVA used (the higher the unsubstituted vinyl alcohol unit content in the protective layer) and the larger the layer thickness, the higher is the oxygen-blocking property, thus advantageous in the point of sensitivity. The molecular weight of the (co)polymer, for example, polyvinyl alcohol (PVA) is ordinarily from 2,000 to 10,000,000, and preferably from 20,000 to 3,000,000.

As other components of the protective layer, glycerin, dipropylene glycol or the like can be added in an amount corresponding to several % by weight of the (co)polymer to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the (co)polymer. The thickness of the protective layer is suitably from 0.5 to 5 µm, and particularly preferably from 1 to 3 µm.

The adhesion of the protective layer to the photosensitive layer and scratch resistance are also extremely important in handling of the printing plate. Specifically, when a hydrophilic layer comprising a water-soluble polymer is laminated on a lipophilic photosensitive layer, layer peeling due to insufficient adhesion is liable to occur, and the peeled part causes such a defect as film hardening failure due to polymerization hindrance by oxygen. Various proposals have been made for improving the adhesion between the photosensitive layer and the protective layer. For example, it is described in U.S. Patent Application Nos. 292,501 and 44,563 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the photosensitive layer. Any of these known techniques can be applied to the protective layer of the invention. Coating methods of the protective layer are described in detail, for example, in U.S. Patent 3,458,311 and JP-B-55-49729.

A coating amount of the protective layer is ordinarily from 0.1 to 10 g/m², and preferably from 0.5 to 5 g/m², in terms of dry weight.

### [Support]

The support for use in the lithographic printing plate precursor of the invention is not particularly restricted as long as it is a dimensionally stable plate-like material. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinyl acetal film) and paper or a plastic film laminated or deposited with the metal described above. A preferred support includes a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials conventionally known and used can be appropriately utilized.

The thickness of the support is preferably from 0.1 to 0.6 mm, more preferably from 0.15 to 0.4 mm, and still more preferably from 0.2 to 0.3 mm.

Prior to the use of aluminum plate, a surface treatment, for example, surface roughening treatment or anodizing treatment is preferably performed. The surface treatment facilitates improvement in the hydrophilic property and assurance of adhesion between the photosensitive layer and the support. Prior to the surface roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, a mechanical roughening treatment, an electrochemical roughening treatment (roughening treatment of electrochemically dissolving the surface) and a chemical roughening treatment (roughening treatment of chemically dissolving the surface selectively).

As the method of the mechanical roughening treatment, a known method, for example, ball grinding, brush grinding, blast grinding or buff grinding can be used.

The electrochemical roughening treatment method includes, for example, a method of applying alternating current or direct current to the aluminum plate in an electrolyte containing an acid, for example, hydrochloric acid or nitric acid. Also, a method of using a mixed acid described in JP-A-54-63902 can be used.

The aluminum plate subjected to the roughening treatment is subjected, if desired, to an alkali etching treatment using an aqueous solution, for example, of potassium hydroxide or sodium hydroxide and further subjected to a neutralizing treatment, and then subjected to an anodizing treatment in order to improve the abrasion resistance of the aluminum plate, if desired.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte used.

Since the conditions for the anodizing treatment are varied depending on the electrolyte used, they cannot be defined commonly. However, it is ordinarily preferred that electrolyte concentration in the solution is from 1 to 80% by weight, liquid temperature is from 5 to 70°C, current density is from 5 to 60 A/dm², voltage is from 1 to 100 V, and electrolysis time is from 10 seconds to 5 minutes. The amount of the anodized film formed is preferably from 1.0 to 5.0 g/m² and more preferably from 1.5 to 4.0 g/m². In the above-described range, good printing durability and favorable scratch resistance in the non-image area of lithographic printing plate can be achieved.

After conducting the anodizing treatment, the surface of the aluminum plate is subjected to a hydrophilizing treatment, if desired. The hydrophilizing treatment includes an alkali metal silicate method described in U.S. Patents 2,714,066, 3,181,461, 3,280,734 and 3,902,734. In the method, the support is subjected to immersion treatment or electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

The support preferably has a center line average roughness of 0.10 to 1.2 µm. In the above-described range, good adhesion with the photosensitive layer, good printing durability and good resistance to stain can be achieved.

Further, color density of the support is preferably from 0.15 to 0.65 in terms of a reflection density value. In the above-described range, good image-forming property due to prevention of halation at the image exposure and good plate inspection property after development can be achieved.

### [Intermediate layer]

According to the invention, after performing the above described treatments, an intermediate layer (also referred to as an undercoat layer, sometimes) may be provided for the purpose of improving the adhesion between the photosensitive layer and the support and improving the stain resistance. For instance, the support undercoated with a water-soluble resin, for example, polyvinylphosphonic acid, a polymer or copolymer having a sulfo group in the side chain thereof or polyacryic acid, a water-soluble metal salt, for example, zinc borate, a yellow dye or an amine salt is preferably used. Moreover, a sol-gel treated substrate to which a functional group capable of causing an addition reaction with a radical is connected via a covalent bond as described in JP-A-7-159983 is preferably used.

Other preferred examples include a support obtained by providing a water-resistant hydrophilic layer as a surface layer on an appropriate support. Examples of the surface layer include a layer comprising an inorganic pigment and a binder described in U.S. Patent 3,055,295 and JP-A-56-13168, a hydrophilic swellable layer described in JP-A-9-80744, and a sol-gel film comprising titanium oxide, polyvinyl alcohol and a silicic acid described in JP-T-8-507727 (The term "JP-T" as used herein means a published Japanese translation of a PCT patent application). The hydrophilizing treatment is conducted for the purpose of rendering the surface of the support hydrophilic, and for the purpose of preventing harmful reactions of the photosensitive layer provided thereon and improving adhesion to the photosensitive layer.

Other examples of the intermediate layer include those described, for example, in JP-B-50-7481, JP-A-54-72104, JP-A-59-101651, JP-A-60-149491, JP-A-60-232998, JP-A-3-56177, JP-A-4-282637, JP-A-5-16558, JP-A-5-246171, JP-A-7-314937, JP-A-8-202025, JP-A-8-320551, JP-A-9-34104, JP-A-9-236911, JP-A-9-269593, JP-A-10-69092, JP-A-10-115931, JP-A-10-161317, JP-A-10-260536, JP-A-10-282682, JP-A-11-84674, JP-A-11-38635, JP-A-11-38629, JP-A-10-282645, JP-A-10-301262, JP-A-11-24277, JP-A-11-109641, JP-A-10-319600, JP-A-11-327152, JP-A-2000-10292, JP-A-2000-235254, JP-A-2000-352824 and JP-A-2001-209170.

### [Backcoat]

After performing the surface treatments on the support or forming the intermediate layer on the support, a backcoat may be provided on the rear surface of the support, if desired.

The backcoat preferably includes, for example, a coating layer comprising an organic polymer compound described in JP-A-5-45885 and a coating layer comprising a metal oxide obtained by hydrolysis and polycondensation of an organic metallic compound or inorganic metallic compound. Among them, an alkoxy compound of silicon, for example, Si(OCH₃)₄, Si(OC₂H₅)₄ Si(OC₃H₇)₄ or Si(OC₄H₉)₄ is preferably used, since the starting materials thereof are not expensive and easily available.

### EXAMPLES

The present invention will be described in more detail with reference to the following examples, but the invention should not be construed as being limited thereto. [Preparation of Developer]

The compositions shown below were dissolved in water, and pH of the resulting solution was adjusted with potassium hydroxide as shown in Table 1 below to prepare a developer.

| (Composition of Developer) | |
|---|---|
| Surfactant shown in Table 1 | Amount shown in Table 1 |
| Defoaming agent shown in Table 1 | Amount shown in Table 1 |
| Chelating agent shown in Table 1 | Amount shown in Table 1 |
| Potassium carbonate | 0.2% by weight |
| Additive shown in Table 1 | Amount shown in Table 1 |

The structures or names of Compounds A-C and E-K contained in the developers used in the examples according to the invention and comparative examples are shown below, respectively. 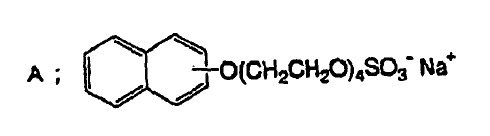 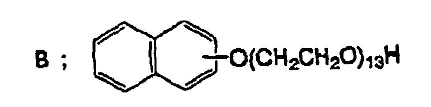 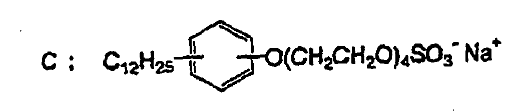
E: 2,4,7,9-Tetramethyl-5-decyne-4,7-diol (Defoaming agent (9) described hereinbefore)
F: Megafac F177 (Fluorine-based defoaming agent, produced by Dainippon Ink & Chemicals, Inc.)
G: FS Antifoam DB110N (Silicon-based defoaming agent, produced by Dow Coming Corp.)
H: Tetrasodium ethylenediaminetetraacetate
I: Na₂P₂O₇
J: Phenylphosphonic acid
K: JISA potassium silicate

### [Evaluation of Foaming Property of Developer]

Because of a concern with the foaming, when the anionic surfactant is incorporated into the developer, the evaluation of foaming property was performed in the following manner.

Specifically, the developer was put into a glass bottle having a diameter of 3cm and a height of 15cm up to 5cm in height. The bottle was shaken up and down ten times, allowed to stand for 10 seconds and then the height of the forming portion was measured. As the value is smaller, the foaming is restrained. The results obtained are shown in Table 1 below.

**TABLE 1**

| Developer | Surfactant | | Deforming Agent | | Chelating Agent | | Other Additive | | pH | Foaming Property |
|---|---|---|---|---|---|---|---|---|---|---|
| | Kind | Amount Added | Kind | Amount Added | Kind | Amount Added | Kind | Amount Added | | |
| Developer 1 | A | 4.0% | E | 0.001% | H | 0.2% | None | - | 11.0 | 2 cm |
| Developer 2 | A | 4.0% | E | 0.001% | H | 0.2% | None | - | 12.0 | 2 cm |
| Developer 3 | A | 4.0% | E | 0.001% | H | 0.2% | None | - | 12.5 | 2 cm |
| Developer 4 | A | 1.0% | E | 0.001% | H | 0.2% | None | - | 12.0 | 2 cm |
| Developer 3 | A | 10.0% | E | 0.001% | H | 0.2% | None | - | 12.0 | 2 cm |
| Developer 6 | A | 4.0% | None | - | H | 0.2% | None | - | 12.0 | 8 cm |
| Developer 7 | A | 4.0% | E | 0.0001% | H | 0.2% | None | - | 12.0 | 4 cm |
| Developer 8 | A | 4.0% | E | 0.5% | H | 0.2% | None | - | 12.0 | 2 cm |
| Developer 9 | A | 4.0% | E | 0.001% | None | - | None | - | 12.0 | 2 cm |
| Developer 10 | A | 4.0% | E | 0.001% | H | 0.01% | None | - | 12.0 | 2 cm |
| Developer 11 | A | 4.0% | E | 0.001% | H | 5.0% | None | - | 12.0 | 2 cm |
| Developer 12 | A | 4.0% | F | 0.001% | H | 0.2% | None | - | 12.0 | 4 cm |
| Developer 13 | A | 4.0% | G | 0.001% | H | 0.2% | None | - | 12.0 | 3 cm |
| Developer 14 | A | 4.0% | E | 0.001% | I | 0.2% | None | - | 12.0 | 2 cm |
| Developer 15 | A | 4.0% | E | 0.001% | J | 0.2% | None | - | 12.0 | 2 cm |
| Developer 16 | A | 4.0% | E | 0.001% | H | 0.2% | K | 3.0% | 12.0 | 2 cm |
| Developer 17 | A | 4.0% | E | 0.001% | H | 0.2% | K | 5.0% | 12.0 | 2 cm |
| Developer 18 | A/B | 3.0%/1.0% | E | 0.001% | H | 0.2% | None | - | 12.0 | 2 cm |
| Developer 19 | C | 4.0% | E | 0.001% | H | 0.2% | None | - | 12.0 | 2 cm |
| Comparative Developer 1 | A | 0.8% | E | 0.001% | H | 0.2% | None | - | 12.0 | 2 cm |
| Comparative Developer 2 | A | 11.0% | E | 0.001% | H | 0.2% | None | - | 12.0 | 2 cm |
| Comparative Developer 3 | B | 4.0% | E | 0.001% | H | 0.2% | None | - | 12.0 | 2 cm |
| Comparative Developer 4 | A | 4.0% | E | 0.001% | H | 0.2% | None | - | 12.0 | 2 cm |
| Comparative Developer 5 | A | 4.0% | E | 0.001% | H | 0.2% | None | - | 12.0 | 2 cm |

### [Preparation of Lithographic Printing Plate Precursor]

### (Preparation of Support)

A 0.3 mm-thick aluminum plate was etched by dipping in a 10% by weight aqueous sodium hydroxide solution at 60°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 coulomb/dm². Subsequently, the aluminum plate was dipped in a 1% by weight aqueous sodium hydroxide solution at 40°C for 5 seconds, dipped in a 30% by weight aqueous sulfuric acid solution at 60°C for 40 seconds to effect a desmut treatment, and then subjected to an anodizing treatment in a 20% by weight aqueous sulfuric acid solution for 2 minutes at a current density of 2 A/dm² to form an anodic oxide film having a thickness of 2.7 g/m². The surface roughness was measured and found to be 0.3 µm (Ra value according to JIS B0601).

On the aluminum plate thus-treated was coated a coating solution for intermediate layer shown below using a bar coater, followed by drying at 80°C for 20 seconds. A coating amount of the intermediate layer after drying was 10 mg/m².

**Coating Solution for Intermediate Layer**

| | | |
|---|---|---|
| | Sol solution shown below | 100 g |
| | Methanol | 900 g |

**Sol Solution**

| | | |
|---|---|---|
| | Phosmer PE (produced by Uni-Chemical Co., Ltd) | 5 g |
| | Methanol | 45 g |
| | Water | 10 g |
| | Phosphoric acid (85% by weight) | 5 g |
| | Tetraethoxysilane | 20 g |
| | 3-Methacryloxypropyltrimethoxysilane | 15 g |

### (Preparation of Lithographic Printing Plate Precursor 1)

Photopolymerizable composition P-1 having the composition shown below was coated on the intermediate layer so as to have a dry coating amount of 1.4 g/m² and dried at 100°C for one minute to form a photosensitive layer.

**Photopolymerizable Composition P-1**

| | | |
|---|---|---|
| | Polymerizable compound (1) shown below | 4.5 parts by weight |
| | Binder polymer (1) shown below | 5.3 parts by weight |
| | Sensitizing dye (1) shown below | 0.4 parts by weight |
| | Polymerization initiator (1) shown below | 0.9 parts by weight |
| | Chain transfer agent (1) shown below | 0.5 parts by weight |
| | Dispersion of ε-phthalocyanine pigment*¹ | 0.9 parts by weight |
| | Fluorine-based nonionic surfactant (Megafac F780, produced by Dainippon Ink & Chemicals, Inc.) | 0.02 parts by weight |
| | Thermal polymerization inhibitor (N-nitrosophenylhydroxylamine aluminum salt) | 0.03 parts by weight |
| | Methyl ethyl ketone | 58 parts by weight |
| | Propylene glycol monomethyl ether acetate | 53 parts by weight |

| | | |
|---|---|---|
| *¹:Dispersion of ε-phthalocyanine pigment | | |

Dispersion of 15 parts by weight of ε-phthalocyanine pigment, 10 parts by weight of dispersing agent (allyl methacrylate/methacrylic acid copolymer (copolymerization molar ratio: 83/17)) and 15 parts by weight of cyclohexanone

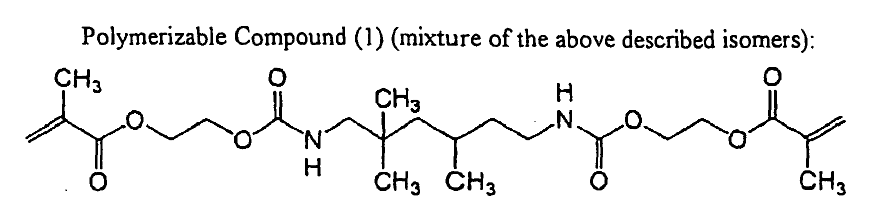

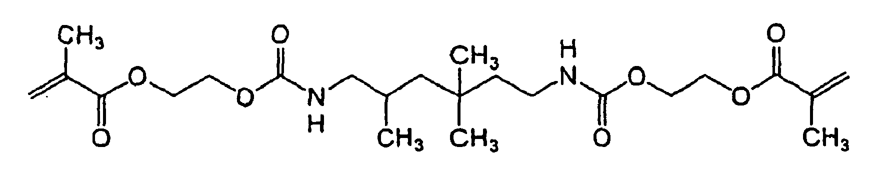

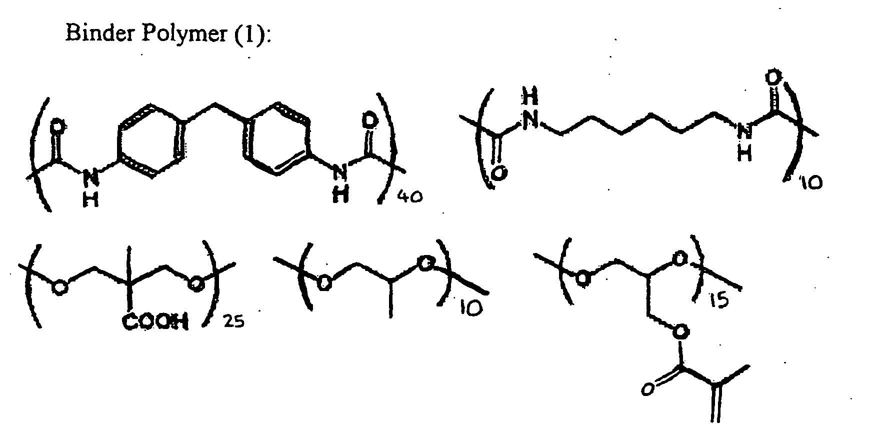

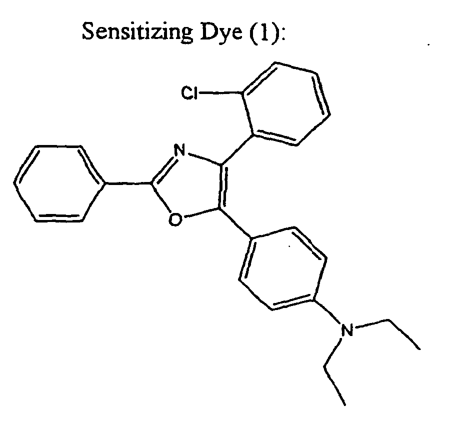

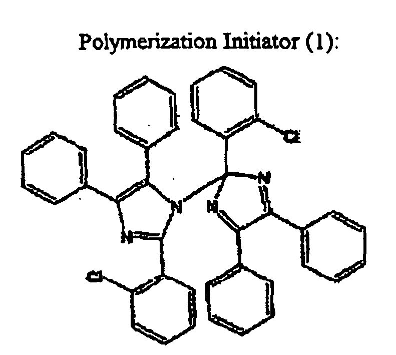

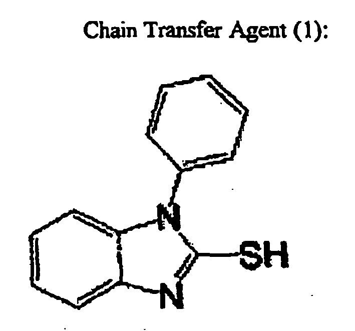

Coating solution for protective layer (1) having the composition shown below was coated on the photosensitive layer so as to have a dry coating amount of 2.3 g/m² and dried at 125°C for 75 seconds to form a protective layer, whereby Lithographic printing plate precursor 1 was prepared.

**Coating Solution for Protective Layer (1)**

| | | |
|---|---|---|
| | Polyvinyl alcohol (saponification degree: 95% by mole, polymerization degree: 500) | 36 parts by weight |
| | Polyvinyl pyrrolidone (molecular weight: 50,000) | 9 parts by weight |
| | Copolymer of vinyl pyrrolidone and vinyl acetate (1/1) (molecular weight: 70,000) | 0.5 parts by weight |
| | Surfactant (Emalex 710, produced by Nihon Emulsion Co., Ltd.) | 0.5 parts by weight |
| | Water | 950 parts by weight |

### (Preparation of Lithographic Printing Plate Precursor 2)

Lithographic printing plate precursor 2 was prepared in the same manner as in Preparation of Lithographic Printing Plate Precursor 1 except for changing Binder polymer (1) in Photopolymerizable composition P-1 of Preparation of Lithographic Printing Plate Precursor 1 to Binder polymer (2) shown below.

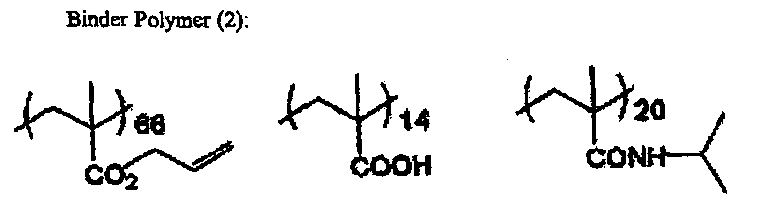

### (preparation of Lithographic Printing Plate Precursor 3)

Lithographic printing plate precursor 3 was prepared in the same manner as in Preparation of Lithographic Printing Plate Precursor 1 except for changing Binder polymer (1) in Photopolymerizable composition P-1 of Preparation of Lithographic Printing Plate Precursor 1 to Binder polymer (3) shown below.

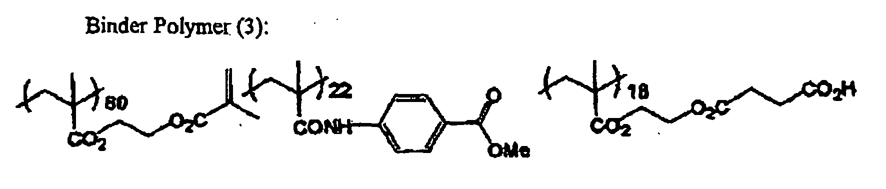

### (Preparation of Lithographic Printing Plate Precursor 4)

Lithographic printing plate precursor 4 was prepared in the same manner as in Preparation of Lithographic Printing Plate Precursor 1 except for changing Sensitizing dye (1) in Photopolymerizable composition P-1 of Preparation of Lithographic Printing Plate Precursor 1 to Sensitizing dye (2) shown below.

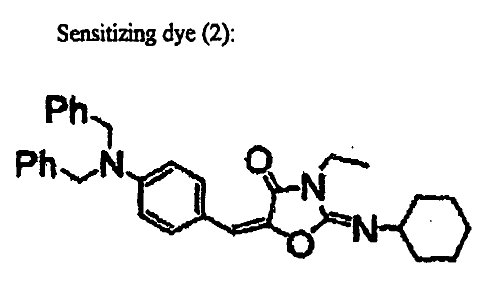

### (Preparation of Lithographic Printing Plate Precursor 5)

Lithographic printing plate precursor 5 was prepared in the same manner as in Preparation of Lithographic Printing Plate Precursor 1 except for changing Sensitizing dye (1) in Photopolymerizable composition P-1 of Preparation of Lithographic Printing Plate Precursor 1 to Sensitizing dye (3) shown below.

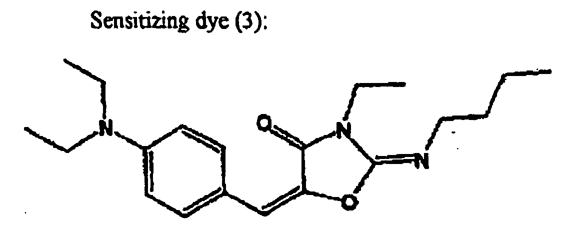

### (Preparation of Lithographic Printing Plate Precursor 6)

Lithographic printing plate precursor 6 was prepared in the same manner as in Preparation of Lithographic Printing Plate Precursor 1 except for changing Chain transfer agent (1) in Photopolymerizable composition P-1 of Preparation of Lithographic Printing Plate Precursor 1 to Chain transfer agent (2) shown below.

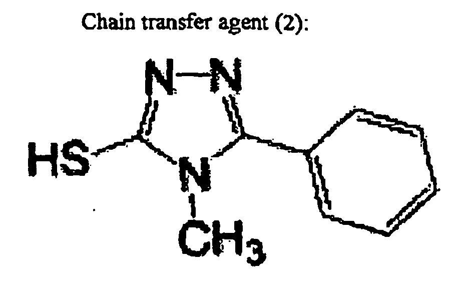

### EXAMPLES 1 TO 19, 21-25 AND COMPARATIVE EXAMPLES 1 TO 5

Each of Lithographic printing plate precursors 1 to 6 obtained was subjected to imagewise drawing using Vx9600CTP (wavelength of light source: 405 nm, produced by Fuji Photo Film Co., Ltd.) while controlling an exposure amount on the surface of the lithographic printing plate precursor to 0.05 mJ/cm², Then, the lithographic printing plate precursor was developed using a PS processor (IP850HD, produced by G & J) fed with each of Developers 1 to 19 and Comparative Developers 1 to 5 having the compositions described above in the combination shown in Table 2 below, as an alkali developer, at plate-heating temperature of 115°C/12 seconds and at the solution temperature of 25°C for development time of 28 seconds. As a finisher, an aqueous solution prepared by diluting FN-6 (produced by Fuji Photo Film Co., Ltd.) with 3 times of water was used.

### [Evaluation]

### (1) Printing Durability

The lithographic printing plate obtained by the above-described exposure and development processing was subjected to printing by a printing machine (Lithrone, produced by Komori Corp.) using ink (DIC-GEOS (N) Black, produced by Dainippon Ink & Chemicals, Inc.) and a mixture of etching solution (EU-3, produced by Fuji Photo Film Co., Ltd.)/water/isopropyl alcohol = 1/89/10 (in volume ratio), and a number of sheets when it was visually recognized that the density of solid image area began to become thin was determined to evaluate the printing durability. The results obtained are shown in Table 2 below.

### (2) Developing Property

The developing property was evaluated by observing the non-image area of the lithographic printing plate obtained by the above-described exposure and development processing. In the evaluation of developing property, O denotes no residual layer in the non-image area. The results obtained are shown in Table 2 below.

### (3) Development Scum

Each 20 m² of Lithographic printing plate precursors 1 to 6 obtained was developed with one liter of each of the developers shown in Table 2. The developer was allowed to stand for one month and then the presence or absence of the development scum precipitated was determined. In the evaluation of development scum, O denotes the absence of precipitate, Δ denotes the presence of a slight amount of the precipitate but a level of practically no problem, and × denotes the presence of a large amount of the precipitate. The results obtained are shown in Table 2 below.

**TABLE 2**

| | Lithographic Printing Plate Precursor | Developer | Printing Durability (x 10⁴ sheets) | Developing Property | Development Scum |
|---|---|---|---|---|---|
| Example 1 | 1 | 1 | 25 | O | Δ |
| Example 2 | 1 | 2 | 25 | O | O |
| Example 3 | 1 | 3 | 21 | O | O |
| Example 4 | 1 | 4 | 26 | O | Δ |
| Example 5 | 1 | 5 | 23 | O | O |
| Example 6 | 1 | 6 | 25 | O | O |
| Example 7 | 1 | 7 | 25 | O | O |
| Example 8 | 1 | 8 | 25 | O | O |
| Example 9 | 1 | 9 | 25 | O | Δ |
| Example 10 | 1 | 10 | 25 | O | O |
| Example 11 | 1 | 11 | 25 | O | O |
| Example 12 | 1 | 12 | 25 | O | O |
| Example 13 | 1 | 13 | 25 | O | O |
| Example 14 | 1 | 14 | 25 | O | O |
| Example 15 | 1 | 15 | 25 | O | O |
| Example 16 | 1 | 16 | 25 | O | O |
| Example 17 | 1 | 17 | 23 | O | Δ |
| Example 18 | 1 | 18 | 25 | O | O |
| Example 19 | 1 | 19 | 25 | O | O |
| Example 21 | 2 | 2 | 20 | O | O |
| Example 22 | 3 | 2 | 22 | O | O |
| Example 23 | 4 | 2 | 25 | O | O |
| Example 24 | 5 | 2 | 25 | O | O |
| Example 25 | 6 | 2 | 25 | O | O |
| Comparative Example 1 | 1 | Comparison 1 | 25 | Presence of Residual Layer | × |
| Comparative Example 2 | 1 | Comparison 2 | 20 | O | O |
| Comparative Example 3 | 1 | Comparison 3 | 25 | Presence of Residual Layer | × |
| Comparative Example 4 | 1 | Comparison 4 | 25 | Presence of Residual Layer | × |
| Comparative Example 5 | 1 | Comparison 5 | 19 | O | O |

From the results described above, it can be seen that according to the plate-making method of the invention, the good developing property is achieved, the high printing durability is obtained, and the occurrence of development scum is prevented.

## Claims

1. A method for making a lithographic printing plate comprising the steps of:
(a) exposing a lithographic printing plate precursor comprising a hydrophilic support, a photosensitive layer containing a sensitizing dye having absorption in a wavelength of 405 nm, a hexaarylbiimidazole compound, a polymerizable compound, a binder polymer and a chain transfer agent and a protective layer in this order with a laser beam having a wavelength of from 350 to 450 nm; and
(b) developing the exposed lithographic printing plate precursor with a developer having pH of 10.0 to 12.5 and containing an anionic surfactant in an amount of from 1.0 to 10.0% by weight represented by formula (II-A) and/or formula (II-B): 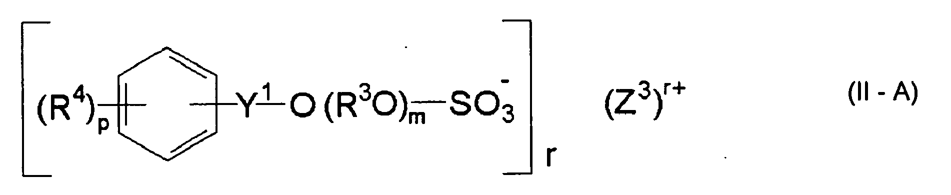 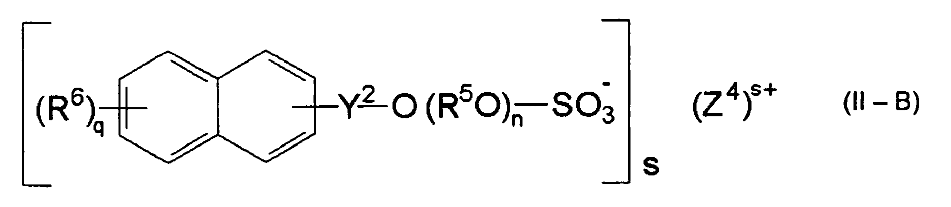
wherein R³ and R⁵ each represents a straight-chain or branched alkylene group having from 1 to 5 carbon atoms; m and n each represents an integer of from 1 to 100, when m is 2 or more, R³ may be selected from two or more groups, and when n is 2 or more, R⁵ may be selected from two or more groups; R⁴ and R⁶ each represents a straight-chain or branched alkyl group having from 1 to 20 carbon atoms; p and q each represents an integer of from 0 to 2; Y¹ and Y² each represents a simple bond or an alkylene group having from 1 to 10 carbon atoms; Z³ and Z⁴ each represents an alkali metal ion, an alkaline earth metal ion, an unsubstituted ammonium ion or an ammonium ion substituted with an alkyl group; and r and s each represents 1 or 2;
with the proviso that if q is 0, n is 1, Y² is a simple bond and R⁵ is an ethylene group, then Z⁴ is not Na.

2. A method for making a lithographic printing plate comprising the steps of:
(a) exposing a lithographic printing plate precursor comprising a hydrophilic support, a photosensitive layer containing a sensitizing dye having absorption in a wavelength of 405 nm, a hexaarylbiimidazole compound, a polymerizable compound, a binder polymer and a thiol compound of formula (XI) as a chain transfer agent and a protective layer in this order with a laser beam having a wavelength of from 350 to 450 nm; and
(b) developing the exposed lithographic printing plate precursor with a developer having pH of 10.0 to 12.5 and containing an anionic surfactant in an amount of from 1.0 to 10.0% by weight represented by formula (II-A) and/or formula (II-B): 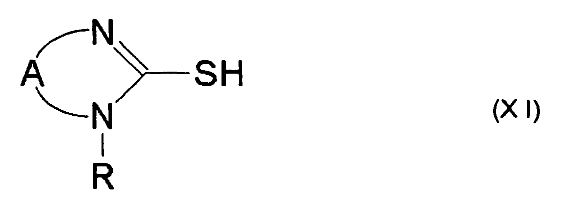
wherein R represents an alkyl group which may have a substituent or an aryl group which may have a substituent; and A represents a moiety which forms a 5-membered or 6-membered hetero ring containing a carbon atom together with the N=C-N linkage, and A may have a substituent; 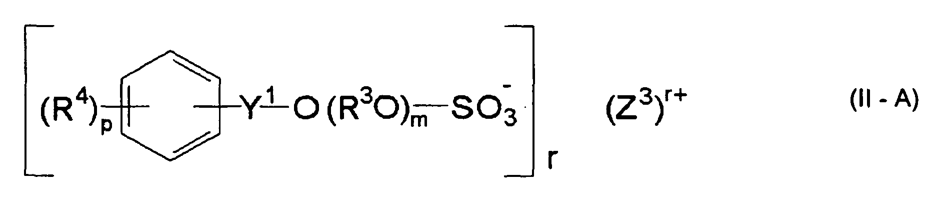 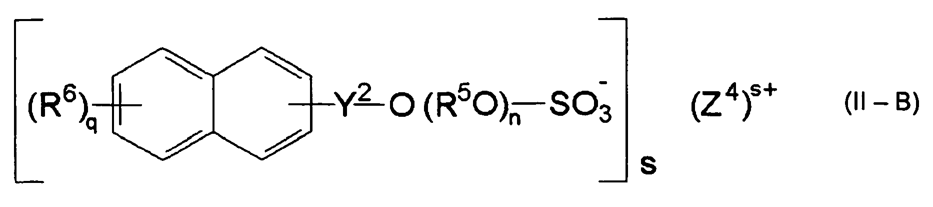 wherein R³ and R⁵ each represents a straight-chain or branched alkylene group having from 1 to 5 carbon atoms; m and n each represents an integer of from 1 to 100, when m is 2 or more, R³ may be selected from two or more groups, and when n is 2 or more, R⁵ may be selected from two or more groups; R⁴ and R⁶ each represents a straight-chain or branched alkyl group having from 1 to 20 carbon atoms; p and q each represents an integer of from 0 to 2; Y¹ and Y² each represents a simple bond or an alkylene group having from 1 to 10 carbon atoms; Z³ and Z⁴ each represents an alkali metal ion, an alkaline earth metal ion, an unsubstituted ammonium ion or an ammonium ion substituted with an alkyl group; and r and s each represents 1 or 2.

3. A method for making a lithographic printing plate according to Claim 1 or Claim 2, wherein the developer contains a defoaming agent.

4. A method for making a lithographic printing plate comprising the steps of:
(a) exposing a lithographic printing plate precursor comprising a hydrophilic support, a photosensitive layer containing a sensitizing dye having absorption in a wavelength of 405 nm, a hexaarylbiimidazole compound, a polymerizable compound, a binder polymer and a chain transfer agent and a protective layer in this order with a laser beam having a wavelength of from 350 to 450 nm; and
(b) developing the exposed lithographic printing plate precursor with a developer having pH of 10.0 to 12.5 and containing a defoaming agent and an anionic surfactant in an amount of from 1.0 to 10.0% by weight represented by formula (II-A) and/or formula (II-B): 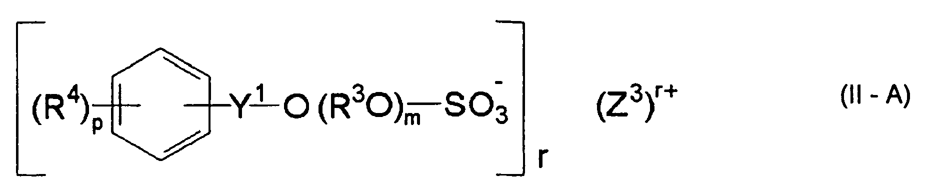 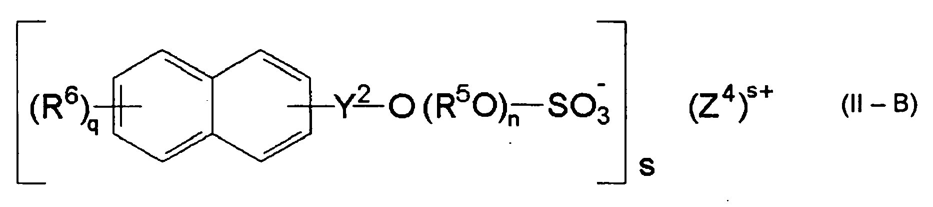
wherein R³ and R⁵ each represents a straight-chain or branched alkylene group having from 1 to 5 carbon atoms; m and n each represents an integer of from 1 to 100, when m is 2 or more, R³ may be selected from two or more groups, and when n is 2 or more, R⁵ may be selected from two or more groups; R⁴ and R⁶ each represents a straight-chain or branched alkyl group having from 1 to 20 carbon atoms; p and q each represents an integer of from 0 to 2; Y¹ and Y² each represents a simple bond or an alkylene group having from 1 to 10 carbon atoms; Z³ and Z⁴ each represents an alkali metal ion, an alkaline earth metal ion, an unsubstituted ammonium ion or an ammonium ion substituted with an alkyl group; and r and s each represents 1 or 2.

5. A method for making a lithographic printing plate according to Claim 1 or Claim 4, wherein the chain transfer agent is a thiol compound represented by the following formula (XI): 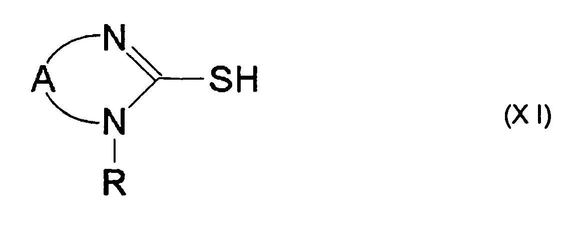 wherein R represents an alkyl group which may have a substituent or an aryl group which may have a substituent; and A represents a moiety which forms a 5-membered or 6-membered hetero ring containing a carbon atom together with the N=C-N linkage, and A may have a substituent.

6. A method for making a lithographic printing plate according to any preceding claim, wherein the developer contains an alkali metal salt of an organic acid and/or an alkali metal salt of an inorganic acid.

7. A method for making a lithographic printing plate according to any preceding claim, wherein the binder polymer is at least one of a (meth)acrylic copolymer having a crosslinkable group in a side chain or a polyurethane resin having a crosslinkable group in a side chain.

8. A method for making a lithographic printing plate according to any preceding Claim, wherein the developer contains a chelating agent.

## Patentansprüche

1. Verfahren zum Herstellen einer Lithographie-Druckplatte umfassend die Schritte:
(a) Belichten einer Lithographie-Druckplattenvorläufers, der in dieser Reihenfolge einen hydrophilen Träger, eine fotoempfindliche Schicht, die einen sensibilisierenden Farbstoff mit Absorption bei einer Wellenlänge von 405 nm, eine Hexaarylbiimidazol-Verbindung, eine polymerisierbare Verbindung, ein Bindemittelpolymer und ein Kettenübertragungsmittel enthält, und eine Schutzschicht umfaßt, mit einem Laserstrahl, der eine Wellenlänge von 350 bis 450 nm aufweist, und
(b) Entwickeln des belichteten Lithographie-Druckplattenvorläufers mit einem Entwickler, der einen pH von 10,0 bis 12,5 aufweist und ein anionisches Tensid in einer Menge von 1,0 bis 10,0 Gew.% enthält, das durch die Formel (II-A) und/oder die Formel (II-B) dargestellt wird: 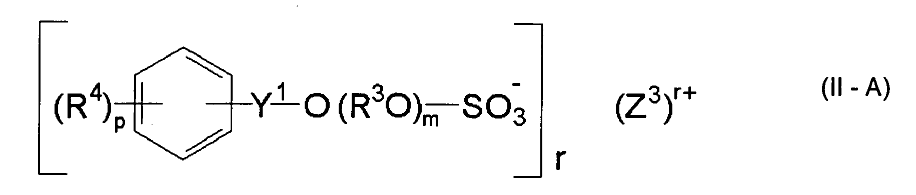 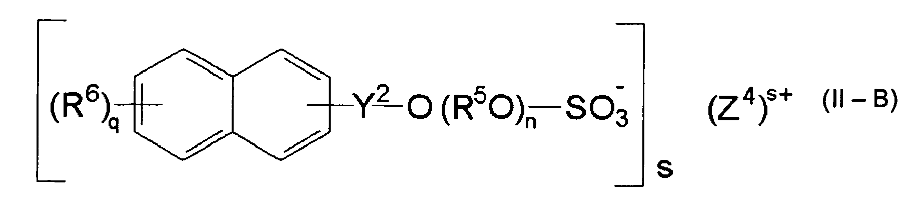
wobei R³ und R⁵ jeweils eine geradkettige oder verzweigte Alkylengruppe mit 1 bis 5 Kohlenstoffatomen darstellen, m und n jeweils eine ganze Zahl von 1 bis 100 darstellen, wenn m 2 oder mehr ist, kann R³ aus zwei oder mehr Gruppen ausgewählt werden, und wenn n 2 oder mehr ist, kann R⁵ aus zwei oder mehr Gruppen ausgewählt werden; R⁴ und R⁶ jeweils eine geradkettige oder verzweigte Alkylgruppe mit 1 bis 20 Kohlenstoffatomen darstellen, p und q jeweils eine ganze Zahl von 0 bis 2 darstellen, Y¹ und Y² jeweils eine Einfachbindung oder eine Alkylengruppe mit 1 bis 10 Kohlenstoffatomen darstellen, Z³ und Z⁴ jeweils ein Alkalimetallion, ein Erdalkalimetallion, ein unsubstituiertes Ammoniumion oder ein Ammoniumion, das mit einer Alkylgruppe substituiert ist, darstellen, und r und s jeweils 1 oder 2 darstellen,
mit der Maßgabe, daß Z⁴ nicht Na ist, wenn q 0 ist, n 1 ist, Y² eine Einfachbindung ist und R⁵ eine Ethylengruppe ist.

2. Verfahren zum Herstellen einer Lithographie-Druckplatte umfassend die Schritte:
(a) Belichten eines Lithographie-Druckplattenvorläufers, der in dieser Reihenfolge einen hydrophilen Träger, eine fotoempfindliche Schicht, die einen sensibilisierenden Farbstoff mit Absorption bei einer Wellenlänge von 405 nm, eine Hexaarylbiimidazol-Verbindung, eine polymerisierbare Verbindung, ein Bindemittelpolymer und eine Thiolverbindung der Formel (XI) als ein Kettenübertragungsmittel enthält, und eine Schutzschicht umfaßt, mit einem Laserstrahl, der eine Wellenlänge von 350 bis 450 nm aufweist, und
(b) Entwickeln des belichteten Lithographie-Druckplattenvorläufers mit einem Entwickler, der einen pH von 10,0 bis 12,5 aufweist und ein anionisches Tensid in einer Menge von 1,0 bis 10,0 Gew.% enthält, das durch die Formel (II-A) und/oder die Formel (II-B) dargestellt wird: 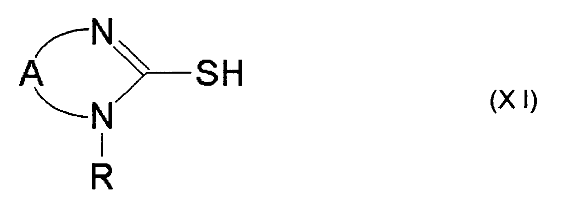
wobei R eine Alkylgruppe, die einen Substituenten aufweisen kann, oder eine Arylgruppe, die einen Substituenten aufweisen kann, darstellt und A einen Rest darstellt, der einen 5-gliedrigen oder 6-gliedrigen Heteroring bildet, der ein Kohlenstoffatom zusammen mit der N=C-N-Verbindungsgruppe enthält, und A einen Substituenten aufweisen kann; 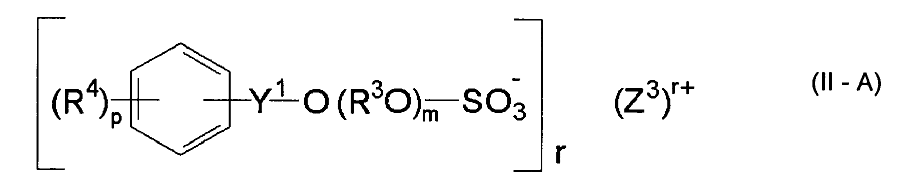 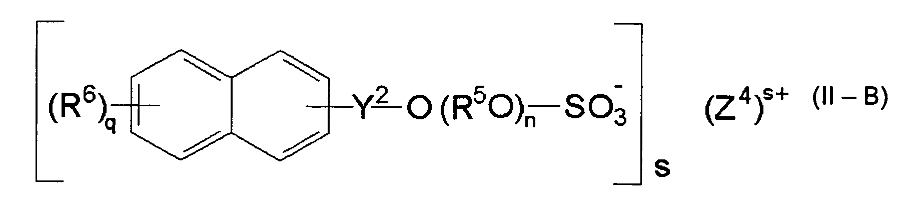 wobei R³ und R⁵ jeweils eine geradkettige oder verzweigte Alkylengruppe mit 1 bis 5 Kohlenstoffatomen darstellen, m und n jeweils eine ganze Zahl von 1 bis 100 darstellen, wenn m 2 oder mehr ist, kann R³ aus zwei oder mehr Gruppen ausgewählt werden, und wenn n 2 oder mehr ist, kann R⁵ aus zwei oder mehr Gruppen ausgewählt werden; R⁴ und R⁶ jeweils eine geradkettige oder verzweigte Alkylgruppe mit 1 bis 20 Kohlenstoffatomen darstellen, p und q jeweils eine ganze Zahl von 0 bis 2 darstellen, Y¹ und Y² jeweils eine Einfachbindung oder eine Alkylengruppe mit 1 bis 10 Kohlenstoffatomen darstellen, Z³ und Z⁴ jeweils ein Alkalimetallion, ein Erdalkalimetallion, ein unsubstituiertes Ammoniumion oder ein Ammoniumion, das mit einer Alkylgruppe substituiert ist, darstellen, und r und s jeweils 1 oder 2 darstellen.

3. Verfahren zum Herstellen einer Lithographie-Druckplatte gemäß Anspruch 1 oder Anspruch 2, wobei der Entwickler ein Entschäumungsmittel enthält.

4. Verfahren zum Herstellen einer Lithographie-Druckplatte umfassend die Schritte:
(a) Belichten eines Lithographie-Druckplattenvorläufers, der in dieser Reihenfolge einen hydrophilen Träger, eine fotoempfindliche Schicht, die einen sensibilisierenden Farbstoff mit Absorption bei einer Wellenlänge von 405 nm, eine Hexaarylbiimidazol-Verbindung, eine polymerisierbare Verbindung, ein Bindemittelpolymer und ein Kettenübertragungsmittel enthält, und eine Schutzschicht umfaßt, mit einem Laserstrahl, der eine Wellenlänge von 350 bis 450 nm aufweist, und
(b) Entwickeln des belichteten Lithographie-Druckplattenvorläufers mit einem Entwickler, der einen pH von 10,0 bis 12,5 aufweist und ein Entschäumungsmittel und ein anionisches Tensid in einer Menge von 1,0 bis 10,0 Gew.% enthält, das durch die Formel (II-A) und/oder die Formel (II-B) dargestellt wird: 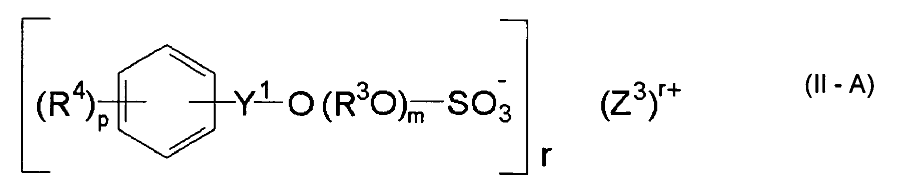 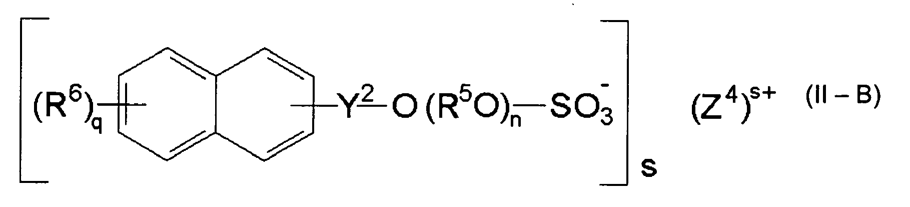
wobei R³ und R⁵ jeweils eine geradkettige oder verzweigte Alkylengruppe mit 1 bis 5 Kohlenstoffatomen darstellen, m und n jeweils eine ganze Zahl von 1 bis 100 darstellen, wenn m 2 oder mehr ist, kann R³ aus zwei oder mehr Gruppen ausgewählt werden, und wenn n 2 oder mehr ist, kann R⁵ aus zwei oder mehr Gruppen ausgewählt werden; R⁴ und R⁶ jeweils eine geradkettige oder verzweigte Alkylgruppe mit 1 bis 20 Kohlenstoffatomen darstellen, p und q jeweils eine ganze Zahl von 0 bis 2 darstellen, Y¹ und Y² jeweils eine Einfachbindung oder eine Alkylengruppe mit 1 bis 10 Kohlenstoffatomen darstellen, Z³ und Z⁴ jeweils ein Alkalimetallion, ein Erdalkalimetallion, ein unsubstituiertes Ammoniumion oder ein Ammoniumion, das mit einer Alkylgruppe substituiert ist, darstellen, und r und s jeweils 1 oder 2 darstellen.

5. Verfahren zum Herstellen einer Lithographie-Druckplatte gemäß Anspruch 1 oder Anspruch 4, wobei das Kettenübertragungsmittel eine Thiolverbindung ist, die durch die folgende Formel (XI) dargestellt wird: 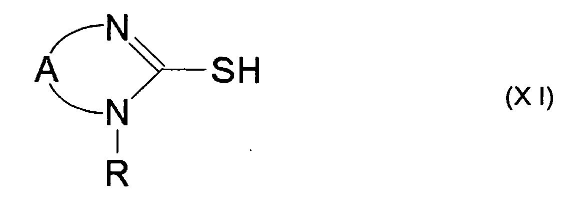 wobei R eine Alkylgruppe, die einen Substituenten aufweisen kann, oder eine Arylgruppe, die einen Substituenten aufweisen kann, darstellt und A einen Rest darstellt, der einen 5-gliedrigen oder 6-gliedrigen Heteroring bildet, der ein Kohlenstoffatom zusammen mit der N=C-N-Verbindungsgruppe enthält, und A einen Substituenten aufweisen kann.

6. Verfahren zum Herstellen einer Lithographie-Druckplatte gemäß einem der vorstehenden Ansprüche, wobei der Entwickler ein Alkalimetallsalz einer organischen Säure und/oder ein Alkalimetallsalz einer anorganischen Säure enthält.

7. Verfahren zum Herstellen einer Lithographie-Druckplatte gemäß einem der vorstehenden Ansprüche, wobei das Bindemittelpolymer wenigstens eines von einem (Meth)acrylsäure-Copolymer mit einer vernetzbaren Gruppe in einer Seitenkette oder ein Polyurethanharz mit einer vernetzbaren Gruppe in einer Seitenkette ist.

8. Verfahren zum Herstellen einer Lithographie-Druckplatte gemäß einem der vorstehenden Ansprüche, wobei der Entwickler ein chelatbildendes Mittel enthält.

## Revendications

1. Procédé de fabrication d'une plaque d'impression lithographique comprenant les étapes consistant à :
(a) exposer un précurseur de plaque d'impression lithographique comprenant un support hydrophile, une couche photosensible contenant une teinture sensibilisatrice présentant une absorption à une longueur d'onde de 405 nm, un composé d'hexa-aryl-biimidazole, un composé polymérisable, un polymère liant et un agent de transfert de chaîne et une couche protectrice, dans cet ordre, avec un faisceau laser ayant une longueur d'onde de 350 à 450 nm ; et
(b) développer le précurseur de plaque d'impression lithographique exposé avec un développeur ayant une valeur de pH de 10,0 à 12,5 et contenant un agent de surface anionique en une quantité de 1,0 à 10,0 % en poids représenté par la formule (II-A) et/ou la formule (II-B) : 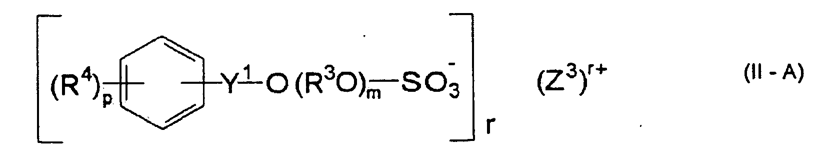 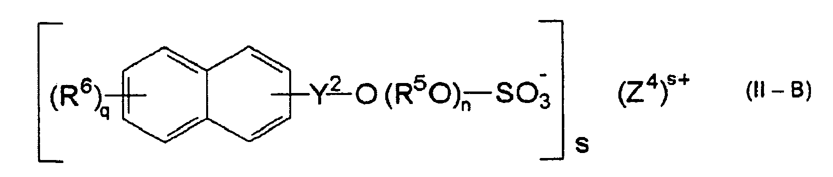
dans lesquelles R³ et R⁵ représentent chacun un groupe alkylène à chaîne droite ou ramifiée ayant de 1 à 5 atomes de carbone ; m et n représentent chacun un entier allant de 1 à 100, quand m vaut 2 ou plus, R³ peut être sélectionné à partir de deux ou plusieurs groupes, et lorsque n vaut 2 ou plus, R⁵ peut être sélectionné à partir de deux ou plusieurs groupes ; R⁴ et R⁶ représentent chacun un groupe alkyle à chaîne droite ou ramifiée ayant de 1 à 20 atomes de carbone ; p et q représentent chacun un entier allant de 0 à 2 ; Y¹ et Y² représentent chacun une liaison simple ou un groupe alkylène ayant de 1 à 10 atomes de carbone ; Z³ et Z⁴ représentent chacun un ion de métal alcalin, un ion de métal alcalino-terreux, un ion d'ammonium non substitué ou un ion d'ammonium substitué par un groupe alkyle ; et r et s représentent chacun 1 ou 2 ;
avec la clause restrictive que si q vaut 0, n vaut 1, Y² est une liaison simple et R⁵ est un groupe éthylène, alors Z⁴ n'est pas du Na.

2. Procédé de fabrication d'une plaque d'impression lithographique comprenant les étapes consistant à :
(a) exposer un précurseur de plaque d'impression lithographique comprenant un support hydrophile, une couche photosensible contenant une teinture sensibilisatrice ayant une absorption à une longueur d'onde de 405 nm, un composé d'hexa-aryl-biimidazole, un composé polymérisable, un polymère liant et un composé thiol de formule (XI) en tant qu'agent de transfert de chaîne et une couche protectrice, dans cet ordre, avec un faisceau laser ayant une longueur d'onde de 350 à 450 nm ; et
(b) développer le précurseur de plaque d'impression lithographique exposé avec un développeur ayant une valeur de pH de 10,0 à 12,5 et contenant un agent de surface anionique en une quantité de 1,0 à 10,0 % en poids représenté par la formule (II-A) et/ou la formule (II-B) : 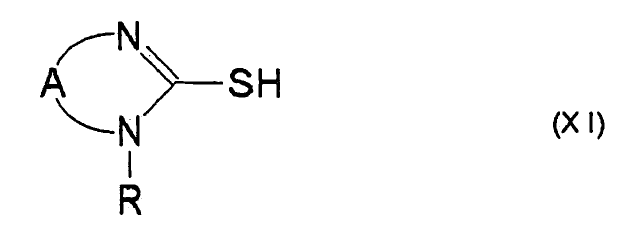
dans laquelle R représente un groupe alkyle qui peut avoir un substituant ou un groupe aryle qui peut avoir un substituant ; et A représente une moitié qui forme un hétéro-cycle à 5 éléments ou à 6 éléments contenant un atome de carbone en même temps que la liaison N=C-N, et A peut avoir un substituant ; 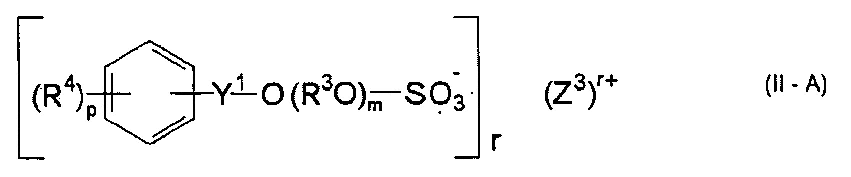 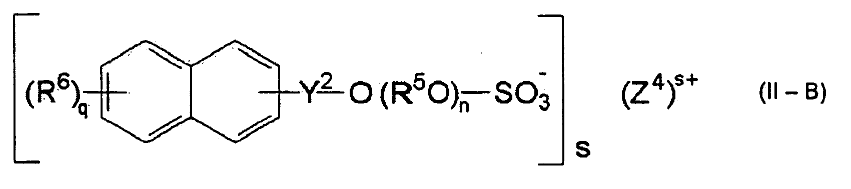 dans lesquelles R³ et R⁵ représentent chacun un groupe alkylène à chaîne droite ou ramifiée ayant de 1 à 5 atomes de carbone ; m et n représentent chacun un entier allant de 1 à 100, quand m vaut 2 ou plus, R³ peut être sélectionné à partir de deux ou plusieurs groupes, et quand n vaut 2 ou plus, R⁵ peut être sélectionné à partir de deux ou plusieurs groupes ; R⁴ et R⁶ représentent chacun un groupe alkyle à chaîne droite ou ramifiée ayant de 1 à 20 atomes de carbone ; p et q représentent chacun un entier de 0 à 2 ; Y¹ et Y² représentent chacun une liaison simple ou un groupe alkylène ayant de 1 à 10 atomes de carbone ; Z³ et Z⁴ représentent chacun un ion de métal alcalin, un ion de métal alcalino-terreux, un ion d'ammonium non substitué ou un ion d'ammonium substitué par un groupe alkyle ; et r et s représentent chacun 1 ou 2.

3. Procédé de fabrication d'une plaque d'impression lithographique selon la revendication 1 ou la revendication 2, dans lequel le développeur contient un agent antimousse.

4. Procédé de fabrication d'une plaque d'impression lithographique comprenant les étapes consistant à :
(a) exposer un précurseur de plaque d'impression lithographique comprenant un support hydrophile, une couche photosensible contenant une teinture sensibilisatrice ayant une absorption à une longueur d'onde de 405 nm, un composé d'hexa-aryl-biimidazole, un composé polymérisable, un polymère liant et un agent de transfert de chaîne et une couche protectrice, dans cet ordre, avec un faisceau laser ayant une longueur d'onde de 350 à 450 nm ; et
(b) développer le précurseur de plaque d'impression lithographique exposé avec un développeur ayant une valeur de pH de 10,0 à 12,5 et contenant un agent antimousse et un agent de surface anionique en une quantité de 1,0 à 10,0 % en poids représenté par la formule (II-A) et/ou la formule (II-B) : 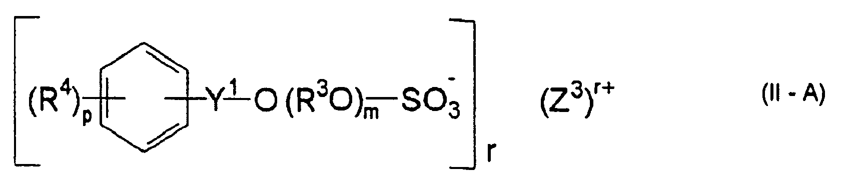 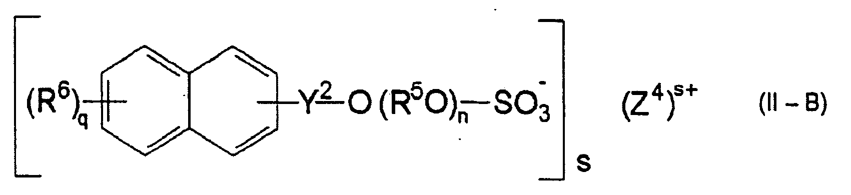
dans laquelle R³ et R⁵ représentent chacun un groupe alkylène à chaîne droite ou ramifiée ayant de 1 à 5 atomes de carbone ; m et n représentent chacun un entier allant de 1 à 100, quand m vaut 2 ou plus, R³ peut être sélectionné à partir de deux ou plusieurs groupes, et quand n vaut 2 ou plus, R⁵ peut être sélectionné à partir de deux ou plusieurs groupes ; R⁴ et R⁶ représentent chacun un groupe alkyle à chaîne droite ou ramifiée ayant de 1 à 20 atomes de carbone ; p et q représentent chacun un entier de 0 à 2 ; Y¹ et Y² représentent chacun une liaison simple ou un groupe alkylène ayant de 1 à 10 atomes de carbone ; Z³ et Z⁴ représentent chacun un ion de métal alcalin, un ion de métal alcalino-terreux, un ion d'ammonium non substitué ou un ion d'ammonium substitué par un groupe alkyle ; et r et s représentent chacun 1 ou 2.

5. Procédé de fabrication d'une plaque d'impression lithographique selon la revendication 1 ou la revendication 4, dans lequel l'agent de transfert de chaîne est un composé thiol représenté par la formule suivante (XI) : 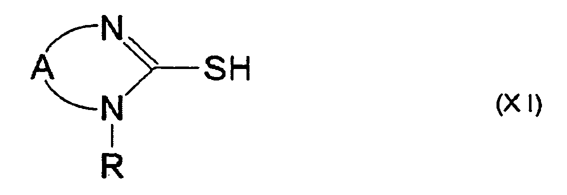 dans laquelle R représente un groupe alkyle qui peut avoir un substituant ou un groupe aryle qui peut avoir un substituant ; et A représente une moitié qui forme un hétéro-cycle à 5 éléments ou à 6 éléments contenant un atome de carbone en même temps que la liaison N=C-N, et A peut avoir un substituant.

6. Procédé de fabrication d'une plaque d'impression lithographique selon l'une quelconque des revendications précédentes, dans lequel le développeur contient un sel de métal alcalin d'un acide organique et/ou un sel de métal alcalin d'un acide inorganique.

7. Procédé de fabrication d'une plaque d'impression lithographique selon l'une quelconque des revendications précédentes, dans lequel le polymère liant est au moins l'un d'un copolymère (méth)acrylique ayant un groupe pouvant être réticulé dans une chaîne latérale ou une résine de polyuréthane ayant un groupe pouvant être réticulé dans une chaîne latérale.

8. Procédé de fabrication d'une plaque d'impression lithographique selon l'une quelconque des revendications précédentes, dans lequel le développeur contient un agent chélatant.
